# EUROPÄISCHE PATENTSCHRIFT

(11) **EP 2 590 757 B1**
(45) Veröffentlichungstag und Bekanntmachung des Hinweises auf die Patenterteilung: **07.09.2016**
(21) Anmeldenummer: 11738658.1
(22) Anmeldetag: 06.07.2011
(51) Int. Cl.: B05D 1/28, B05D 5/10, G03F 7/00, B05D 1/32, B82Y 10/00, B05D 3/12, B82Y 40/00

(54) **VERFAHREN ZUR HERSTELLUNG VON FEINSTRUKTURIERTEN OBERFLÄCHEN**
METHOD FOR PRODUCING FINELY STRUCTURED SURFACES
PROCÉDÉ DE FABRICATION DE SURFACES FINEMENT STRUCTURÉES

(30) Priorität: 07.07.2010 DE 102010026490
(43) Veröffentlichungstag der Anmeldung: 15.05.2013
(73) Patentinhaber: Leibniz-Institut für Neue Materialien gemeinnützige GmbH, 66123 Saarbrücken (DE)
(72) Erfinder: ARZT, Eduard, 66123 Saarbrücken (DE); KRONER, Elmar, 66111 Saarbrücken (DE); DE OLIVEIRA, Peter William, 66123 Saarbrücken (DE); DEVRIM SAM PARMAK, Ebru, 34734 Sahrayicedit-Istanbul (TR); BÜSCH, Florian, 67433 Neustadt (DE); URBAN, Dieter, 67346 Speyer (DE); SCHWALM, Reinhold, 67157 Wachenheim (DE); BLÄSI, Benedikt, 79102 Freiburg (DE); NITSCHE, Michael, 79115 Freiburg (DE); SPIECKER, Hannes, 10115 Berlin (DE); MÜLLER, Claas, 79104 Freiburg (DE)
(74) Vertreter: Patentanwälte Gierlich & Pischitzis Partnerschaft mbB
(86) Internationale Anmeldenummer: PCT/EP2011/061440
(87) Internationale Veröffentlichungsnummer: WO 2012/004319

(56) Entgegenhaltungen:
- WO-A1-2008/124180
- WO-A1-2009/128946
- WO-A1-2009/158631
- WO-A2-2008/076390
- WO-A2-2009/002644
- US-A1- 2005 271 869
- US-A1- 2006 078 725
- US-A1- 2009 114 618

## Beschreibung

Die vorliegende Erfindung betrifft ein Verfahren zur Herstellung von feinstrukturierten Oberflächen, insbesondere zur Beeinflussung der Adhäsion, die so hergestellten Beschichtungen und deren Verwendung.

Es ist bekannt, dass feinstrukturierte Oberflächen eine erhöhte Adhäsionsfähigkeit besitzen. Derartige Strukturen und Verfahren zu deren Herstellung sind beispielsweise beschrieben in EP 1 513 904 B1, WO 01/49776 A2 oder WO 2009/053714 A1.

Eine besondere Fähigkeit solcher Oberflächen ist ihre Trockenadhäsivität. Unter Trockenadhäsivität wird im Rahmen dieser Schrift die Ausbildung von adhäsiven Kräften zwischen Oberflächen ohne haftvermittelnde Stoffe, wie Klebstoffe, verstanden. Solche Haftverbindungen zeichnen sich auch dadurch aus, dass sie sich ohne Rückstände wieder entfernen lassen.

Solche Haftsysteme basieren häufig auf einer Strukturierung der Oberfläche. Dabei muss allerdings zwischen Systemen unterschieden werden, welche eine spezielle Gegenstruktur erfordern, wie z.B. Haken und Ösen, und Systemen, welche mit beliebigen Oberflächen Adhäsionskräfte ausbilden können.

Solche Haftsysteme sind beispielsweise auch aus der Natur, z.B. bei Gecko-Beinen oder an Insekten, bekannt (siehe auch WO 01/49776 A2). Man nimmt an, dass bei solchen Systemen die Haftkräfte auf van-der-Waals-Kräften basieren. Die Strukturierung der Oberfläche führt bei Kontaktierung zu einer sehr starken Vergrößerung der Kontaktfläche, und damit auch der Stärke der bei der Kontaktierung ausgebildeten Adhäsionskräfte.

Solche Oberflächen sind meistens feinstrukturiert. Dies bedeutet, dass sie Vertiefungen oder Vorsprünge mit einer Strukturierung von unter einem Millimeter aufweisen. Mit Vorteil sind es mikrostrukturierte Oberflächen. Dies bedeutet, dass die Struktur der Oberfläche, d.h. die Vorsprünge und/oder Vertiefungen, mindestens eine Dimension im Bereich von mindestens 100 nm, bevorzugt mindestens 150 nm, besonders bevorzugt mindestens 200 nm, ganz besonders bevorzugt mindestens 250 nm und unter 1 mm, bevorzugt unter 750 µm, besonders bevorzugt unter 500 µm, ganz besonders bevorzugt unter 250 µm, insbesondere unter 100 µm, speziell unter 50 µm, sogar unter 30 µm und durchaus unter 20 µm aufweisen. Mit Vorteil weisen sie mindestens zwei Dimensionen jeweils unabhängig voneinander in diesem Bereich auf.

Um solche feinstrukturierten Oberflächen einfach und kostengünstig herzustellen, bietet sich das Abformen einer Matrize durch Polymere oder Polymermischungen an.

Die folgenden Eigenschaften/Anforderungen sind von der Polymermischung zu erfüllen:
1. Niedrige Viskosität der Polymermischung, um ein schnelles, vollständiges und gleichmäßiges Einfließen in die Matrize zu ermöglichen;
2. Bevorzugt ein strahlungshärtbares Polymer, um die Aushärtung unmittelbar und besonders schnell zu ermöglichen. Eine thermische oder chemische Härtung ist bei den geplanten Kontaktzeiten zwischen Substrat und Strukturmaster (Matrize) weniger bevorzugt, wenn auch denkbar;
3. Hohe Abformtreue und ein geringer Schrumpf des Materials vom Zustand vor zum Zustand nach der Strahlungshärtung, da die exakte Strukturabformung (d.h. die Abformung der Struktur der Matrize) besonders wichtig ist für die endgültigen Eigenschaften der Substratoberflächenstruktur.
4. Härte und Elastizität des gehärteten Polymermaterials, um eine optimale trockenadhäsive Oberflächenstruktur zu erhalten.

Es kommt somit auf eine Balance zwischen der Viskosität der Polymermischung beim Auftragen der Polymermischung und der Elastizität der gehärteten Polymermischung an.

Dabei ist jedoch zu bedenken, daß eine niedrige Viskosität zumeist erreicht wird mit niedermolekularen polymerisationsfähigen Verbindungen. Diese weisen jedoch eine hohe Dichte an polymerisationsfähigen Gruppen auf, führen also im Polymer zu einer hohen Vernetzung, was eine hohe Härte ergibt, was in der Regel einer hohen Sprödigkeit entspricht, so daß sich derart gehärtete Strukturen nicht mehr von der Matrize trennen lassen können bzw. beim Trennen aus den feinen Strukturen der Matrize abbrechen.

Eine Absenkung der Dichte an polymerisationsfähigen Gruppen, also eine Erhöhung des Molgewichts führt jedoch zu einer erhöhung der Viskosität mit folgenden Nachteilen:

Aus DE 100 01 135 A1 ist ein Verfahren zur Herstellung feinstrukturierter Oberflächen bekannt, in dem in eine strahlungshärtbare thixotrope Beschichtungsmasse mit einer Viskosität über 30 Pas eine Feinstruktur geprägt, die geprägte Oberfläche von der Prägevorrichtung gelöst und per Strahlung gehärtet wird.

Nachteilig ist, daß mit derartig hochviskosen Beschichtungsmassen feine Strukturen nicht vollständig gefüllt werden können, so daß von einer Matrize nur flache Strukturen abgebildet werden.

Die zeigt sich anhand der in Figur 1 der DE 100 01 135 A1 abgebildeten Struktur, die bei einem Durchmesser an der Basis von etwa 1,4 µm lediglich eine Höhe von etwa 150 nm aufweist, also ein Aspektverhältnis (Verhältnis der Höhe der Struktur und dem Durchmesser (AR; aspect ratio)) von lediglich 0,11.

Aus DE 10 2007 021249 A1 ist ein Verfahren zur Herstellung strukturierter Oberflächen bekannt, in dem eine Beschichtungsmasse durch Strahlung gehärtet wird, wobei an der Oberfläche wegen der Sauerstoffinhibierung eine etwa 1 µm dünne Schicht ungehärtet bleibt, die anschließend durch Eindrücken einer Matrize strukturiert und in einem zweiten Schritt endgültig gehärtet werden kann.

Nachteilig an diesem Verfahren ist, daß die oberste Schicht trotz der Sauerstoffinhibierung nicht ungehärtet, sondern zumindest teilweise gehärtet ist. Dies bewirkt in dieser obersten Schicht einen Anstieg der Viskosität der Beschichtungsmasse mit allen Nachteilen, wie sie bereits oben für die DE 100 01 135 A1 beschrieben worden sind.

WO 2008/124180 A1 beschreibt die Herstellung von mikrostrukturierten Oberflächen mit strahlungshärtbaren Beschichtungsmassen. WO 2009/158631 A1 beschreibt ein Verfahren zur Abformung von nanostrukturierten Oberflächen, welche strahlungshärtbar sein können. WO 2009/128946 A1 beschreibt die Herstellung von Stempeln zur Strukturierung von Oberflächen, insbesondere Fotolacken.

### Aufgabe

Aufgabe der Erfindung ist es, ein Verfahren anzugeben, welche es erlaubt feinstrukturierte Oberflächen mit hohen Aspektverhältnissen kostengünstig und einfach herzustellen.

### Lösung

Die Aufgabe wird durch die Erfindung mit den Merkmalen der unabhängigen Ansprüche gelöst. Vorteilhafte Weiterbildungen der Erfindung sind in den Unteransprüchen gekennzeichnet. Der Wortlaut sämtlicher Ansprüche wird hiermit durch Bezugnahme zum Inhalt dieser Beschreibung gemacht. Die Erfindung umfasst auch alle sinnvollen und insbesondere alle erwähnten Kombinationen von unabhängigen und/oder abhängigen Ansprüchen.

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Die Aufgabe wird gelöst durch ein Verfahren zur Herstellung von feinstrukturierten beschichteten Oberflächen, bevorzugt mit einem Aspektverhältnis von mindestens 0,5, zur Beeinflussung der Adhäsion umfassend die Schritte:
a) Auftragen mindestens einer Beschichtungsmasse auf mindestens ein Substrat;
b) Formen einer Feinstruktur durch eine Matrize, die das Negativ einer Feinstruktur aufweist, wobei
   b1) die Matrize gegen die Beschichtungsmasse auf dem Substrat gedrückt wird oder
   b2) das Substrat aus Schritt a) die Matrize enthält;
c) Härten der so erhaltenen feinstrukturierten Beschichtungsmasse unter Erhalt einer gehärteten Beschichtung;
d) Abtrennen der feinstrukturierten Beschichtung von der Matrize, wobei die Schritte d) und c) auch in umgekehrter Reihenfolge durchgeführt werden können, und
   wobei
   - die Beschichtungsmasse in lösungsmittelfreiem Zustand vor dem Auftragen auf das Substrat eine Viskosität [Rotationsviskosimetrie nach DIN 53018-1 mit Platte/Kegel-Geometrie bei 25°C; Temperierung: Peltier; Messeinrichtung: HC 60/1 bei einer Scherrate (Schergefälle) D zwischen 10 und 1.000, bevorzugt 400 1*s⁻¹] unter 10 Pas, bevorzugt unter 1 Pas, besonders bevorzugt zwischen 20 mPas und 1 Pas, und
   - die gehärtete Beschichtung ein E-Modul [Indentation mit Berkovich Spitze, Last zwischen 0,1 und 1 mN je nach Modul der zu bestimmenden Probe; Eindrückzeit: 10 s; Haltezeit 30 s und Rückzugzeit 10 s, Kalibrierung auf Polycarbonat] von mindestens 1 und bis zu 2000, bevorzugt 1 bis 1000, besonders bevorzugt 2 bis 100 MPa aufweist.

In einer weiteren Ausführungsform der Erfindung liegen die Viskositäten der Beschichtungsmassen in lösungsmittelfreiem Zustand im Bereich zwischen 10 mPas und 600 mPas, bevorzugt bis zu 500 mPas, besonders bevorzugt bis zu 400 mPas, ganz besonders bevorzugt bis zu 300 mPas und insbesondere bis zu 250 mPas und der E-Modul der gehärteten Beschichtungsmassen zwischen 2 und 20 MPa.

Solche Beschichtungsmassen ermöglichen es, dass die Matrize vollständig befüllt wird und die Struktur beim Abtrennen der Matrize erhalten bleibt. Ansonsten besteht die Gefahr, dass die Struktur kollabiert oder zerfließt.

Mit den oben angegebenen Viskositäten der lösungsmittelfreien Beschichtungsmassen und E-Moduli der gehärteten Beschichtungsmassen ist es erstmals möglich Mikrostrukturen mit den erfindungsgemäß bevorzugt geforderten Aspektverhältnissen von mindestens 0,5, bevorzugt mindestens 0,7, besonders bevorzugt mindestens 0,9, ganz besonders bevorzugt mindestens 1, insbesondere mindestens 1,3 und speziell mindestens 1,5 zu erhalten.

Die obere Grenze für das Aspektverhältnis liegt davon unabhängig bevorzugt bei 100, 50, 20, 15, 10 oder 5. Bei hierarchischen Strukturen gibt das Aspektverhältnis das Aspektverhältnis der größten Hierarchiestufe an.

Unter einer Beschichtungsmasse wird im Rahmen dieser Schrift eine im wesentlichen unpolymerisierte, flüssige Verbindung oder Mischung von Verbindungen mit einer näher angegeben Viskosität verstanden, die durch einen beliebigen Mechanismus polymerisiert werden kann, beispielsweise durch einen in der Beschichtungsmasse enthaltenen Starter oder durch einen äußeren Einfluss. Bei der Polymerisation kann es sich beispielsweise um eine Polykondensation oder ionische oder radikalische, bevorzugt kationische oder radikalische, besonders bevorzugt radikalische Polymerisation handeln. Unter einer Polymerisation wird dabei eine Vervielfachung des mittleren Molekulargewichts der Verbindung verstanden.

Unter einer Beschichtung wird im Rahmen dieser Schrift das aus einer Beschichtungsmasse durch Polymerisieren erhältliche Polymer verstanden, das in der Regel ein mittleres Molekulargewicht des mindestens zehnfachen, bevorzugt des mindestens zwanzigfachen, besonders bevorzugt des mindestens fünfzigfachen der eingesetzten Verbindung aufweist.

Unter der Viskosität wird im Rahmen dieser Schrift, wenn nicht anders angegeben, das Messergebnis gemäß DIN 53018-1 [Rotationsviskosimetrie mit Platte/Kegel-Geometrie bei 25°C; Temperierung: Peltier; Messeinrichtung: HC 60/1 bei einem Schergefälle D von 10 - 1.000 1*sek⁻¹] verstanden. Dabei ist darauf zu achten, dass bei der Bestimmung der Viskosität eventuell in der Beschichtungsmasse enthaltenes Lösungsmittel im wesentlichen entfernt ist, d.h. etwaiges in der Beschichtungsmasse enthaltenes Lösungsmittel zu mindestens 90%, Gew.-%, bevorzugt zu mindestens 95%, besonders bevorzugt zu mindestens 98% und ganz besonders bevorzugt zu mindestens 99% entfernt ist. Lösungsmittel sind dabei solche leichtflüchtigen Bestandteile einer Beschichtungsmasse, die nach dem Polymerisationsmechanismus nicht in das Polymer eingebaut werden und durch Trocknen der Beschichtungsmasse bei Temperaturen von bis zu 100 °C über einen Zeitraum bis zu 1 Stunde im Wesentlichen entfernt werden können.

Unter dem E-Modul wird im Rahmen dieser Schrift eine Indentation mit Berkovich Spitze, Last zwischen 0,1 und 1 mN je nach Modul der zu bestimmenden Probe, verstanden. Das E-Modul wird dabei bestimmt an einer unstrukturierten Probe aus dem Material, das für die Strukturierung verwendet werden soll.

Es stellt eine bevorzugte Ausführungsform der vorliegenden Erfindung dar, wenn die gehärtete Beschichtung eine Glasübergangstemperatur (bestimmt gemäß ASTM Norm D3418-03 mit einer Aufheizrate von 20 °C/min) mindestens Raumtemperatur aufweist, bevorzugt mindestens 25 °C, besonders bevorzugt mindestens 30 °C, ganz besonders bevorzugt mindestens 35 °C und insbesondere mindestens 40 °C.

Die im erfindungsgemäßen Schritt a) aufgetragene Beschichtungsmasse ist strahlungshärtbar. Weitere nicht erfindungsgemäße Härtungsmechanismen sind beispielsweise physikalisch härtend, thermisch härtend, chemisch härtend oder strahlungshärtbar. Unter einer physikalischen Härtung wird dabei das einfache Abdunsten von Lösungsmittel unter Ausbildung der Beschichtung verstanden.

Eine thermische Härtung bedeutet dabei ein Härtungsmechanismus, der auf eine Temperatur oberhalb von Raumtemperatur zurückzuführen ist. Dies kann beispielsweise die Bildung von Radikalen oder Ionen, bevorzugt Radikalen aus einem Initiator sein, der bei den erhöhten Temperaturen zerfällt und so eine radikalische bzw. ionische Polymerisation startet. Beispiele für solche thermisch aktivierbare Initiatoren sind solche, die eine Halbwertszeit bei 80 °C von weniger als 100 Stunden aufweisen, wie in "Polymer Handbook", 2. Aufl., Wiley & Sons, New York beschrieben.

Unter einer chemischen Härtung wird dabei die Reaktion verschiedener Komponenten mit komplementären reaktiven Gruppen verstanden, beispielsweise im Sinne einer Polykondensation.

Ausgewählte nach diesem Mechanismus härtende Beschichtungsmassen sind ein- oder zweikomponentige Beschichtungsmassen aus Poly-isocyanaten, die optional blockiert sein können, und Polyollen sowie Siloxanstrukturen.

Beispiele für letztere sind Silikon, Polydimethylsiloxan (PDMS), z.B. Sylgard^{®} 184 der Firma Dow Corning, und Polyvinylsiloxan.

Beispiele für Polyisocyanate in den erstere sind in der Regel wie folgt charakterisiert:

Die mittlere NCO Funktionalität solcher Verbindungen beträgt in der Regel mindestens 1,8 und kann bis zu 8 betragen, bevorzugt 2 bis 5 und besonders bevorzugt 2,4 bis 4.

Der Gehalt an Isocyanatgruppen nach der Oligomerisierung, berechnet als NCO = 42 g/mol, beträgt, wenn nicht anders angegeben, in der Regel von 5 bis 25 Gew.-%.

Beispielsweise handelt es sich bei den Polyisocyanaten um folgende Verbindungen:
1) Isocyanuratgruppen aufweisende Polyisocyanate von aromatischen, aliphatischen und/oder cycloaliphatischen Diisocyanaten. Besonders bevorzugt sind hierbei die entsprechenden aliphatischen und/oder cycloaliphatischen Isocyanato-Isocyanurate und insbesondere die auf Basis von Hexamethylendiisocyanat und Isophorondiisocyanat. Bei den dabei vorliegenden Isocyanuraten handelt es sich insbesondere um Tris-isocyanatoalkyl- bzw. Tris-isocyanatocycloalkyl-Isocyanurate, welche cyclische Trimere der Diisocyanate darstellen, oder um Gemische mit ihren höheren, mehr als einen Isocyanuratring aufweisenden Homologen. Die Isocyanato-Isocyanurate haben im Allgemeinen einen NCO-Gehalt von 10 bis 30 Gew.-%, insbesondere 15 bis 25 Gew.-% und eine mittlere NCO-Funktionalität von 2,6 bis 8.
2) Uretdiongruppen aufweisende Polyisocyanate mit aromatisch, aliphatisch und/oder cycloaliphatisch gebundenen Isocyanat-gruppen, vorzugsweise aliphatisch und/oder cycloaliphatisch gebundenen und insbesondere die von Hexamethylendiisocyanat oder Isophorondiisocyanat abgeleiteten. Bei Uretdiondiiso-cyanaten handelt es sich um cyclische Dimerisierungsprodukte von Diisocyanaten.
   Die Uretdiongruppen aufweisenden Polyisocyanate werden im Gemisch mit anderen Polyisocyanaten, insbesondere den unter 1) genannten, erhalten. Dazu können die Diisocyanate unter Reaktionsbedingungen umgesetzt werden, unter denen sowohl Uretdiongruppen als auch die anderen Polyisocyanate gebildet werden, oder zunächst die Uretdiongruppen gebildet und diese anschließend zu den anderen Polyisocyanaten umgesetzt werden oder die Diisocyanate zunächst zu den anderen Polyisocyanaten und diese anschließend zu Uretdiongruppen-haltigen Produkten umgesetzt werden.
3) Biuretgruppen aufweisende Polyisocyanate mit aromatisch, cycloaliphatisch oder aliphatisch gebundenen, bevorzugt cycloaliphatisch oder aliphatisch gebundenen Isocyanatgruppen, insbesondere Tris-(6-isocyanatohexyl)-biuret oder dessen Gemische mit seinen höheren Homologen. Diese Biuretgruppen aufweisenden Polyisocyanate weisen im Allgemeinen einen NCO-Gehalt von 18 bis 22 Gew.-% und eine mittlere NCO-Funktionalität von 2,8 bis 6 auf.
4) Urethan- und/oder Allophanatgruppen aufweisende Polyisocyanate mit aromatisch, aliphatisch oder cycloaliphatisch gebundenen, bevorzugt aliphatisch oder cycloaliphatisch gebundenen Isocyanatgruppen, wie sie beispielsweise durch Umsetzung von überschüssigen Mengen an Diisocyanat, beispielsweise Hexamethylendiisocyanat oder Isophorondiisocyanat, mit ein- oder mehrwertigen Alkoholen. Diese Urethan- und/oder Allophanatgruppen aufweisenden Polyisocyanate haben im Allgemeinen einen NCO-Gehalt von 12 bis 24 Gew.-% und eine mittlere NCO-Funktionalität von 2,5 bis 4,5. Solche Urethan- und/oder Allophanatgruppen aufweisenden Polyisocyanate können unkatalysiert oder bevorzugt in Gegenwart von Katalysatoren, wie beispielsweise Ammoniumcarboxylaten oder -hydroxiden, oder Allophanatisierungskatalysatoren, z.B. Zn-(II)-Verbindungen, jeweils in Anwesenheit von ein-, zwei- oder mehrwertigen, bevorzugt einwertigen Alkoholen, hergestellt werden.
5) Oxadiazintriongruppen enthaltende Polyisocyanate, vorzugsweise von Hexamethylendiisocyanat oder Isophorondiisocyanat abgeleitet. Solche Oxadiazintriongruppen enthaltenden Polyisocyanate sind aus Diisocyanat und Kohlendioxid zugänglich.
6) Iminooxadiazindiongruppen enthaltende Polyisocyanate, vorzugsweise von Hexamethylendiisocyanat oder Isophorondiisocyanat abgeleitet. Solche Iminooxadiazindiongruppen enthaltenden Polyisocyanate sind aus Diisocyanaten mittels spezieller Katalysatoren herstellbar.
7) Uretonimin-modifizierte Polyisocyanate.
8) Carbodiimid-modifizierte Polyisocyanate.
9) Hyperverzweigte Polyisocyanate, wie sie beispielsweise bekannt sind aus der DE 100 13 186 A1 oder DE 100 13 187 A1.
10) Polyurethan-Polyisocyanat-Präpolymere, aus Di- und/oder Polyisocyanaten mit Alkoholen.
11) Polyharnstoff-Polyisocyanat-Präpolymere.
12) Die Polyisocyanate 1)-11), bevorzugt 1), 3), 4) und 6) können nach deren Herstellung in Biuretgruppen- oder Urethan-/Allophanat-Gruppen aufweisende Polyisocyanate mit aromatisch, cycloaliphatisch oder aliphatisch gebundenen, bevorzugt (cyclo)aliphatisch gebundenen Isocyanatgruppen, überführt werden. Die Bildung von Biuretgruppen erfolgt beispielsweise durch Zugabe von Wasser oder Umsetzung mit Aminen. Die Bildung von Urethan- und/oder Allophanatgruppen erfolgt durch Umsetzung mit ein-, zwei- oder mehrwertigen, bevorzugt einwertigen Alkoholen, gegebenenfalls in Gegenwart von geeigneten Katalysatoren. Diese Biuret- oder Urethan-/Allophanatgruppen aufweisenden Polyisocyanate weisen im Allgemeinen einen NCO-Gehalt von 18 bis 22 Gew.-% und eine mittlere NCO-Funktionalität von 2,8 bis 6 auf.
13) Hydrophil modifizierte Polyisocyanate, d.h. Polyisocyanate, die neben den unter 1-12 beschriebenen Gruppen solche enthalten, die formal durch Addition von Molekülen mit NCOreaktiven Gruppen und hydrophilierenden Gruppen an die Isocyanatgruppen obiger Moleküle entstehen. Bei letzteren handelt es sich um nichtionische Gruppen wie Alkyl-Polyethylenoxid und/oder ionische, welche von Phosphorsäure, Phosphonsäure, Schwefelsäure oder Sulfonsäure, bzw. ihren Salzen abgeleitet sind.
14) Modifizierte Polyisocyanate für Dual Cure Anwendungen, d.h. Polyisocyanate, die neben den unter 1-12 beschriebenen Gruppen solche enthalten, die formal durch Addition von Molekülen mit NCO-reaktiven Gruppen und durch UV- oder aktinische Strahlung vernetzbare Gruppen an die Isocyanatgruppen obiger Moleküle entstehen. Bei diesen Molekülen handelt es sich beispielsweise um Hydroxyallkyl(meth)acrylate und andere Hydroxy-Vinylverbindungen.

Die oben aufgeführten Diisocyanate oder Polyisocyanate können auch zumindest teilweise in blockierter Form vorliegen.
Zur Blockierung eingesetzte Verbindungsklassen sind beschrieben in D. A. Wicks, Z. W. Wicks, Progress in Organic Coatings, 36, 148-172 (1999), 41, 1-83 (2001) sowie 43, 131-140 (2001).

Beispiele für zur Blockierung eingesetzte Verbindungsklassen sind Phenole, Imidazole, Triazole, Pyrazole, Oxime, N-Hydroxyimide, Hydroxybenzoesäureester, sekundäre Amine, Lactame, CH-acide cyclische Ketone, Malonsäureester oder Alkylacetoacetate.

Das Polyisocyanat kann ausgewählt sein aus der Gruppe bestehend aus Isocyanuraten, Biureten, Urethanen und Allophanaten, bevorzugt aus der Gruppe bestehend aus Isocyanuraten, Urethanen und Allophanaten, besonders bevorzugt aus der Gruppe bestehend aus Isocyanuraten und Allophanaten, insbesondere handelt es sich um ein isocyanuratgruppenhaltiges Polyisocyanat.

Bei den Polyolen kann es sich beispielsweise um Polyacrylatpolyole, Polyesterpolyole, Polyetherpolyole, Polyurethanpolyole; Polyharnstoffpolyole; Polyesterpolyacrylatpolyole; Polyesterpolyurethanpolyole; Polyurethanpolyacrylatpolyole, polyurethanmodifizierte Alkydharze; Fettsäuremodifizierte Polyesterpolyurethanpolyole, Kopolymerisate mit Allylethern, Pfropfpolymerisate aus den genannten Stoffgruppen mit z.B. unterschiedlichen Glasübergangstemperaturen, sowie Mischungen der genannten Polyole handeln. Bevorzugt sind Polyacrylatpolyole, Polyesterpolyole und Polyetherpolyole.

Bevorzugte OH-Zahlen, gemessen gemäß DIN 53240-2, sind 40-350 mg KOH/g Festharz für Polyester, bevorzugt 80-180 mg KOH/g Festharz, und 15-250 mg KOH/g Festharz für Polyacrylatole, bevorzugt 80-160 mg KOH/g.

Zusätzlich können die Polyole eine Säurezahl gemäß DIN EN ISO 3682 bis 200 mg KOH/g, bevorzugt bis 150 und besonders bevorzugt bis 100 mg KOH/g aufweisen.

Polyacrylatpolyole weisen bevorzugt ein Molekulargewicht Mₙ von mindestens 1000, besonders bevorzugt mindestens 2000 und ganz besonders bevorzugt mindestens 5000 g/mol auf. Das Molekulargewicht Mₙ kann prinzipiell nach oben unbegrenzt sein, bevorzugt bis 200.000, besonders bevorzugt bis zu 100.000, ganz besonders bevorzugt bis zu 80.000 und insbesondere bis zu 50.000 g/mol betragen.

Die Hydroxyzahl wird im Wesentlichen durch Einpolymerisierung von hydroxygruppentragenden Monomeren bewirkt.

Dies können beispielsweise Monoester von α,β-ungesättigten Carbonsäuren, wie Acrylsäure, Methacrylsäure (in dieser Schrift kurz als "(Meth)acrylsäure" bezeichnet) sein, mit Di- oder Polyolen, die vorzugsweise 2 bis 20 C-Atome und wenigstens zwei Hydroxygruppen aufweisen, wie Ethylenglykol, Diethylenglykol, Triethylenglykol, 1,2-Propylenglykol, 1,3-Propylenglykol, 1,1-Dimethyl-1,2-Ethandiol, Dipropylenglykol, Triethylenglykol, Tetraethylenglykol, Pentaethylenglykol, Tripropylenglykol, 1,4-Butandiol, 1,5-Pentandiol, Neopentylglykol, Hydroxypivalinsäureneopentylglykolester, 2-Ethyl-1,3-Propandiol, 2-Methyl-1,3-Propandiol, 2-Butyl-2-ethyl-1,3-Propandiol, 1,6-Hexandiol, 2-Methyl-1,5-pentandiol, 2-Ethyl-1,4-butandiol, 2-Ethyl-1,3-Hexandiol, 2,4-Diethyl-oktan-1,3-diol, 2,2-Bis(4-hydroxycyclohexyl)propan, 1,1-, 1,2-, 1,3- und 1,4-Bis(hydroxymethyl)-cyclohexan, 1,2-, 1,3- oder 1,4-Cyclohexandiol, Glycerin, Trimethylolethan, Trimethylolpropan, Trimethylolbutan, Pentaerythrit, Ditrimethylolpropan, Dipentaerythrit, Sorbit, Mannit, Diglycerol, Threit, Erythrit, Adonit (Ribit), Arabit (Lyxit), Xylit, Dulcit (Galactit), Maltit, Isomalt, Poly-THF mit einem Molgewicht zwischen 162 und 4500, bevorzugt 250 bis 2000, Poly-1,3-propandiol oder Polypropylenglykol mit einem Molgewicht zwischen 134 und 2000 oder Polyethylenglykol mit einem Molgewicht zwischen 238 und 2000.

Bevorzugt sind 2-Hydroxyethylacrylat, 2-Hydroxyethylmethacrylat, 2- oder 3-Hydroxypropylacrylat, 1,4-Butandiolmonoacrylat oder 3-(Acryloyloxy)-2-hydroxypropylacrylat und besonders bevorzugt 2-Hydroxyethylacrylat und/oder 2-Hydroxyethylmethacrylat.

Die hydroxygruppentragenden Monomere werden in die Copolymerisation im Gemisch mit anderen polymerisierbaren, bevorzugt radikalisch polymerisierbaren Monomeren, eingesetzt, bevorzugt solche, welche zu mehr als 50 Gew.-% aus C₁-C₂₀-, bevorzugt C₁- bis C₄-Alkyl(meth)acrylat, (Meth)acrylsäure, Vinylaromaten mit bis zu 20 C-Atomen, Vinylestern von bis zu 20 C-Atomen enthaltenden Carbonsäuren, Vinylhalogeniden, nicht aromatischen Kohlenwasserstoffen mit 4 bis 8 C-Atomen und 1 oder 2 Doppelbindungen, ungesättigten Nitrilen und deren Mischungen bestehen. Besonders bevorzugt sind die Polymeren, die zu mehr als 60 Gew.-% aus C₁-C₁₀-Alkyl(meth)acrylaten, Styrol und dessen Derivate, Vinylimidazol oder deren Mischungen bestehen.

Darüberhinaus können die Polymere gegebenenfalls weitere Monomere enthalten, z.B. (Meth)acrylsäureglycidylepoxyester, ethylenisch ungesättigte Säuren, insbesondere Carbonsäuren, Säureanhydride oder Säureamide.

Weitere Polyole sind z.B. Polyesterole, wie sie durch Kondensation von Polycarbonsäuren, insbesondere Dicarbonsäuren mit Polyolen, insbesondere Diolen erhältlich sind. Um eine für die Polymerisation angemessene Funktionalität des Polyesterpolyols zu gewährleisten werden partiell auch Triole, Tetrole etc. wie auch Trisäuren, etc. eingesetzt.

Polyesterpolyole, sind z.B. aus Ullmanns Encyklopädie der technischen Chemie, 4. Auflage, Band 19, S. 62 bis 65 bekannt. Bevorzugt werden Polyesterpolyole eingesetzt, die durch Umsetzung von zweiwertigen Alkoholen mit zweiwertigen Carbonsäuren erhalten werden. Anstelle der freien Polycarbonsäuren können auch die entsprechenden Polycarbonsäureanhydride oder entsprechende Polycarbonsäureester von niederen Alkoholen oder deren Gemische zur Herstellung der Polyesterpolyole verwendet werden. Die Polycarbonsäuren können aliphatisch, cycloaliphatisch, aromatisch oder heterocyclisch sein und gegebenenfalls, z.B. durch Halogenatome, substituiert und/oder ungesättigt sein. Als Beispiele hierfür seien genannt:

Oxalsäure, Maleinsäure, Fumarsäure, Bernsteinsäure, Glutarsäure, Adipinsäure, Sebacinsäure, Dodekandisäure, o-Phthalsäure, Isophthalsäure, Terephthalsäure, Trimellithsäure, Azelainsäure, 1,4-Cyclohexandicarbonsäure oder Tetrahydrophthalsäure, Korksäure, Azelainsäure, Phthalsäureanhydrid, Tetrahydrophthalsäureanhydrid, Hexahydrophthalsäureanhydrid, Tetrachlorphthalsäureanhydrid, Endomethylentetrahydrophthalsäureanhydrid, Glutarsäureanhydrid, Maleinsäureanhydrid, dimere Fettsäuren, deren Isomere und Hydrierungsprodukte sowie veresterbare Derivate, wie Anhydride oder Dialkylester, beispielsweise C₁-C₄-Alkylester, bevorzugt Methyl-, Ethyl- oder n-Butylester, der genannten Säuren eingesetzt werden. Bevorzugt sind Dicarbonsäuren der allgemeinen Formel HOOC-(CH₂)_{y}-COOH, wobei y eine Zahl von 1 bis 20, bevorzugt eine gerade Zahl von 2 bis 20 ist, besonders bevorzugt Bernsteinsäure, Adipinsäure, Sebacinsäure und Dodecandicarbonsäure.

Als mehrwertige Alkohole kommen zur Herstellung der Polyesterole in Betracht 1,2-Propandiol, Ethylenglykol, 2,2-Dimethyl-1,2-Ethandiol, 1,3-Propandiol, 1,2-Butandiol, 1,3-Butandiol, 1,4-Butandiol, 3-Methylpentan-1,5-diol, 2-Ethylhexan-1,3-diol, 2,4-Diethyloctan-1,3-diol, 1,6-Hexandiol, Poly-THF mit einer Molmasse zwischen 162 und 4500, bevorzugt 250 bis 2000, Poly-1,3-propandiol mit einer Molmasse zwischen 134 und 1178, Poly-1,2-propandiol mit einer Molmasse zwischen 134 und 898, Polyethylenglykol mit einer Molmasse zwischen 106 und 458, Neopentylglykol, Hydroxypivalinsäureneopentylglykolester, 2-Ethyl-1,3-Propandiol, 2-Methyl-1,3-Propandiol, 2,2-Bis(4-hydroxycyclohexyl)propan, 1,1-, 1,2-, 1,3- und 1,4-Cyclohexandimethanol, 1,2-, 1,3- oder 1,4-Cyclohexandiol, Trimethylolbutan, Trimethylolpropan, Trimethylolethan, Neopentylglykol, Pentaerythrit, Glycerin, Ditrimethylolpropan, Dipentaerythrit, Sorbit, Mannit, Diglycerol, Threit, Erythrit, Adonit (Ribit), Arabit (Lyxit), Xylit, Dulcit (Galactit), Maltit oder Isomalt, die gegebenenfalls wie oben beschrieben alkoxyliert sein können.

Bevorzugt sind Alkohole der allgemeinen Formel HO-(CH₂)ₓ-OH, wobei x eine Zahl von 1 bis 20, bevorzugt eine gerade Zahl von 2 bis 20 ist. Bevorzugt sind Ethylenglycol, Butan-1,4-diol, Hexan-1,6-diol, Octan-1,8-diol und Dodecan-1,12-diol. Weiterhin bevorzugt ist Neopentylglykol.

Ferner kommen auch Polycarbonatdiole in Betracht, wie sie z.B. durch Umsetzung von Phosgen mit einem Überschuss von den als Aufbaukomponenten für die Polyesterpolyole genannten niedermolekularen Alkohole erhalten werden können.

Geeignet sind auch Polyesterdiole auf Lacton-Basis, wobei es sich um Homo- oder Mischpolymerisate von Lactonen, bevorzugt um endständige Hydroxylgruppen aufweisende Anlagerungsprodukte von Lactonen an geeignete difunktionelle Startermoleküle handelt. Als Lactone kommen bevorzugt solche in Betracht, die sich von Verbindungen der allgemeinen Formel HO-(CH₂)_{z}-COOH ableiten, wobei z eine Zahl von 1 bis 20 ist und ein H-Atom einer Methyleneinheit auch durch einen C₁- bis C₄-Alkylrest substituiert sein kann. Beispiele sind ε-Caprolacton, β-Propiolacton, γ-Butyrolacton und/oder Methyl-ε-caprolacton, 4-Hydroxybenzoesäure, 6-Hydroxy-2-naphthalinsäure oder Pivalolacton sowie deren Gemische. Geeignete Starterkomponenten sind z.B. die vorstehend als Aufbaukomponente für die Polyesterpolyole genannten niedermolekularen zweiwertigen Alkohole. Die entsprechenden Polymerisate des ε-Caprolactons sind besonders bevorzugt. Auch niedere Polyesterdiole oder Polyetherdiole können als Starter zur Herstellung der Lacton-Polymerisate eingesetzt sein. Anstelle der Polymerisate von Lactonen können auch die entsprechenden, chemisch äquivalenten Polykondensate der den Lactonen entsprechenden Hydroxycarbonsäuren, eingesetzt werden.

Weiterhin sind als Polymere auch Polyetherole geeignet, die durch Addition von Ethylenoxid, Propylenoxid oder Butylenoxid an H-aktive Komponenten hergestellt werden. Ebenso sind Polykondensate aus Butandiol geeignet.

Weiterhin können hydroxyfunktionelle Carbonsäuren eingesetzt werden, wie beispielsweise Dimethylolpropionsäure oder Dimethylolbutansäure.

Bei den Polymeren kann es sich natürlich auch um Verbindungen mit primären der sekundären Aminogruppen handeln.

Dabei kann es sich beispielsweise um zumindest teilweise hydrolysierte Poly-N-vinylformamid oder Polyalkylenimine, besonders Polyethylenimine handeln.

Die Herstellung der Polymerisate von N-Vinylformamid ist seit langem bekannt (siehe zum Beispiel EP 71 050 B1, entspricht US 4, 421, 602) .

Neben den nichtionischen (Co)Polymerisaten erhält man kationische Copolymerisate von N-Vinylformamid besonders einfach dadurch, dass man Homopolymerisate von N-Vinylformamid mit definierten Mengen von Säure oder Base hydrolytisch zu dem gewünschten Hydrolysegrad spaltet, wie in der EP 71 050 A1 beschrieben. Die dabei an der Polymerkette entstehenden Aminogruppen sind je nach pH-Wert der Lösung mehr oder weniger protoniert und verleihen damit dem Polymeren einen kationischen Charakter.

Unter nichtionischen (Co)Polymerisaten werden dabei erfindungsgemäß solche N-Vinylformamid in einpolymerisierter Form enthaltende (Co)Polymerisate verstanden, die unabhängig vom pH-Wert keine Ladungen enthalten. Dies können beispielsweise ungespaltenes Poly-N-Vinylformamid oder Copolymere aus N-Vinylformamid und neutralen Monomeren sein.

Auch kationische Copolymerisate, die N-Vinylformamid einpolymerisiert enthalten, können erfindungsgemäß verwendet werden.

Die Herstellung kationischer Copolymerisate aus N-Vinylformamid und einem wasserlöslichen basischen Monomer, wie beispielsweise N-Trialkylammoniumalkylacrylamide, zumindest teilweise protonierte N-Dialkylammoniumalkylacrylamide, N-Trialkylammoniumalkylmethacrylamide, zumindest teilweise protonierte N-Dialkylammoniumalkylmethacrylamide, N-Trialkylammoniumalkylacrylester, zumindest teilweise protonierte N-Dialkylammoniumalkylacrylester, N-Trialkylammoniumalkylmethacrylester, zumindest teilweise protonierte N-Dialkylammoniumalkylmethacrylester und/oder Diallyldialkylammoniumsalze, sowie deren Verwendung als Flockungs- und Entwässerungshilfsmittel für die Behandlung von Abwässern und Schlämmen ist in der EP0 464 043 B1 (entspricht US 5,225,088) beschrieben.

Beispielsweise kann man als wasserlösliche kationische Monomere Diallyldimethylammoniumchlorid, Diallyldiethylammoniumchlorid, Diallyldimethylammoniummethosulfat, Diallyldiethylammoniumethosulfat, N-(2-Trimethylammonium)ethylacrylamid methosulfat oder N-2-(Ethyl-dimethyl)ammoniumethylmethacrylamid ethosulfat oder Gemische davon mit N-Vinylformamid copolymerisieren, wie in EP 0 464 043 B1 beschrieben, und erhält damit kationische Copolymerisate, die sich für die Verwendung in den erfindungsgemäßen Streichfarben eignen.

Das (Co)Polymerisat enthält im Allgemeinen folgende Monomere in einpolymerisierter Form:

### N-Vinylformamid:

50-100 Gew.-%, bevorzugt 80-99,5 Gew.-%, besonders bevorzugt 90-99 Gew.-% und ganz besonders bevorzugt 95-99 Gew.-%.

### Wasserlösliche(s) kationische(s) Monomer(e):

0-20 Gew.-%, bevorzugt 0,5-10 Gew.-%, besonders bevorzugt 1-5 Gew.-% und ganz besonders bevorzugt 1-5 Gew.-%.

### Andere(s) Monomer(e):

0-30 Gew.-%, bevorzugt 0-10 Gew.-%, besonders bevorzugt 0-5 Gew.-% und ganz besonders bevorzugt 0 Gew.-%.

Als andere Monomere können dem Fachmann an sich bekannte, ethylenisch ungesättigte Monomere copolymerisiert werden. Beispielsweise sind geeignet Ester der (Meth)acrylsäure mit Alkoholen, die 1 bis 20 C-Atome aufweisen, z.B. (Meth)acrylsäuremethylester, (Meth)acrylsäureethylester, (Meth)acrylsäure-n-butylester, (Meth)acrylsäure-2-ethylhexylester, vinylaromatische Verbindungen, z.B. Styrol, Divinylbenzol, α,β-ungesättigte Nitrile, z.B. Acrylnitril, Methacrylnitril, Vinylester, z.B. Vinylacetat, Vinylpropionat, halogenierte ethylenisch ungesättigte Verbindungen, z.B. Vinylchlorid, Vinylidenchlorid, konjugierte ungesättigte Verbindungen, z.B. Butadien, Isopren, Chloropren, einfach ungesättigte Verbindungen, z.B. Ethylen, Propylen, 1-Buten, 2-Buten, isoButen, cyclische einfach ungesättigte Verbindungen, z.B. Cyclopenten, Cyclohexen, Cyclododecen, Allylessigsäure, Vinylessigsäure, monoethylenisch ungesättigten Carbonsäuren mit 3 bis 8 C-Atomen sowie deren wasserlöslichen Alkalimetall-, Erdalkalimetall- oder Ammoniumsalze wie beispielsweise: Acrylsäure, Methacrylsäure, Dimethylacrylsäure, Ethacrylsäure, Maleinsäure, Citraconsäure, Methylenmalonsäure, Crotonsäure, Fumarsäure, Mesaconsäure und Itaconsäure, Maleinsäure, N-Vinylpyrrolidon, N-Vinyllactame, wie z.B. N-Vinylcaprolactam, N-Vinyl-N-Alkyl-carbonsäureamide oder N-Vinyl-carbonsäureamide, wie z. B. N-Vinylacetamid, N-Vinyl-N-methylformamid und N-Vinyl-N-methylacetamid, Vinylether, z.B. Methylvinylether, Ethylvinylether, n-Propylvinylether, iso-Propylvinylether, n-Butylvinylether, sek-Butylvinylether, iso-Butylvinylether, tert-Butylvinylether, 4-Hydroxybutylvinylether, sowie Gemische davon.

Das Einpolymerisieren der anderen Monomeren ist jedoch zum Erreichen des erfinderischen Erfolgs nicht zwingend erforderlich, so dass darauf auch verzichtet werden kann.

Eine häufige, aber nicht die einzige Methode zur Herstellung der bisher angeführten (Co)Polymerisate ist die radikalische (Co)Polymerisation in einem Lösungs- oder Verdünnungsmittel.

Die radikalische (Co)Polymerisation solcher Monomere erfolgt beispielsweise in wässriger Lösung in Gegenwart von Polymerisationsinitiatoren, die unter Polymerisationsbedingungen in Radikale zerfallen. Die (Co)Polymerisation kann in einem weiten Temperaturbereich, gegebenenfalls unter vermindertem oder auch unter erhöhtem Druck in der Regel bei Temperaturen bis zu 100 °C vorgenommen werden. Der pH-Wert des Reaktionsgemisches wird gewöhnlich in dem Bereich von 4 bis 10 eingestellt.

Die (Co)Polymerisation kann aber auch in anderer, dem Fachmann an sich bekannter Weise durchgeführt werden, z.B. als Lösungs-, Fällungs-, Wasser-in-Öl-Emulsions- oder umgekehrte Suspensionspolymerisation. Bevorzugt ist die Lösungspolymerisation.

Dabei wird das N-Vinylformamid unter Verwendung radikalischer Polymerisationsinitiatoren, z.B. in Radikale zerfallende Azoverbindungen, wie 2,2'-Azo-bis(isobutyronitril), 2,2'-Azobis-(2-amidinopropan)-hydrochlorid oder 4,4'-Azo-bis-(4'-cyan-pentansäure) (co)polymerisiert.

Die genannten Verbindungen werden meist in Form wässriger Lösungen eingesetzt, wobei die untere Konzentration durch die in der (Co)Polymerisation vertretbare Wassermenge und die obere Konzentration durch die Löslichkeit der betreffenden Verbindung in Wasser bestimmt ist. Im allgemeinen beträgt die Konzentration 0,1 bis 30 Gew.-%, bevorzugt 0,5 bis 20 Gew.-%, besonders bevorzugt 1,0 bis 10 Gew.-%, bezogen auf die Lösung.

Die Menge der Initiatoren beträgt im allgemeinen 0,1 bis 10 Gew.-%, bevorzugt 0,5 bis 5 Gew.-%, bezogen auf die zu (co)polymerisierenden Monomeren. Es können auch mehrere, verschiedene Initiatoren bei der (Co)Polymerisation Verwendung finden.

Als Lösungs- oder Verdünnungsmittel können z.B. Wasser, Alkohole, wie Methanol, Ethanol, n- oder iso-Propanol, n- oder isoButanol, oder Ketone, wie Aceton, Ethylmethylketon, Diethylketon oder iso-Butylmethylketon dienen.

Gegebenenfalls kann die (Co)Polymerisation in Gegenwart von Polymerisationsreglern, wie beispielsweise Hydroxylammoniumsalze, chlorierte Kohlenwasserstoffe und Thioverbindungen, wie z.B. tert.-Butylmercaptan, Thioglycolsäureethylacrylester, Mercaptoethynol, Mercaptopropyltrimethoxysilan, Dodecylmercaptan, tert.-Dodecylmercaptan oder Alkalimetallhypophosphite, durchgeführt werden. Bei der (Co)Polymerisation können diese Regler, z. B. in Mengen von 0 bis 0,8 Gew.-Teile, bezogen auf 100 Gew.-Teile der zu (co)polymerisierenden Monomeren, eingesetzt werden, durch die die Molmasse des entstehenden (Co)Polymers verringert wird.

Bei der Emulsionspolymerisation können ionische und/oder nichtionische Emulgatoren und/oder Schutzkolloide bzw. Stabilisatoren als grenzflächenaktive Verbindungen verwendet werden.

Je nach Polymerisationsbedingungen erhält man bei der (Co)Polymerisation (Co)Polymerisate eines unterschiedlichen Molekulargewichtes, das in der EP 71 050 B1 und im Folgenden mit Hilfe der K-Werte nach Fikentscher (gemessen in 0,5 Gew.-%iger wässriger Kochsalzlösung bei 25 °C) charakterisiert wird.

(Co)Polymerisate mit einem hohen K-Wert, z.B. oberhalb von 80, werden vorzugsweise durch (Co)Polymerisieren des N-Vinylformamids in Wasser hergestellt. (Co)Polymerisate mit einem hohen K-Wert mit hohen Molekulargewichten erhält man darüber hinaus beispielsweise durch (Co)Polymerisieren der Monomeren in Form der umgekehrten Suspensionspolymerisation oder durch (Co)Polymerisieren der Monomeren nach dem Verfahren der Wasser-in-Öl-Polymerisation.

Bei dem Verfahren der umgekehrten Suspensionspolymerisation sowie der Wasser-in-Öl-Polymerisation verwendet man als Ölphase gesättigte Kohlenwasserstoffe, beispielsweise Hexan, Heptan, Cyclohexan, Dekalin oder aromatische Kohlenwasserstoffe, wie Benzol, Toluol, Xylol und Cumol. Das Verhältnis von Ölphase zu wässriger Phase beträgt bei der umgekehrten Suspensionspolymerisation beispielsweise 10:1 bis 1:10.

(Co)Polymerisat mit einem niedrigen K-Wert, z.B. unterhalb von 80, erhält man, wenn man die (Co)Polymerisation in Gegenwart von Polymerisationsreglern oder in einem Lösungsmittel durchführt, das die (Co)Polymerisation regelt, z.B. Alkohole, wie Methanol, Ethanol, n- oder iso-Propanol, oder Ketone, wie Aceton, Ethylmethylketon, Diethylketon oder iso-Butylmethylketon. K-Werte mit niedrigen Molekulargewichten und entsprechend niedrigen K-Werten erhält man weiterhin mit Hilfe der üblichen Methoden, d.h. Einsatz größerer Mengen an Polymerisationsinitiator oder Verwendung von Polymerisationsreglern oder Kombinationen der genannten Maßnahmen.

Das Molekulargewicht der erfindungsgemäß einsetzbaren (Co)Polymerisate ist nicht beschränkt, doch sollte es nicht zu hoch sein, damit die Streichmasse keine zu hohe Viskosität bekommt. Bevorzugt werden (Co)Polymerisate mit K-Werten von 10 bis 100, wobei K-Werte von 30 bis 80 besonders bevorzugt sind. Die K-Werte werden nach Fikentscher gemessen in 0,5 gew.-%iger wässriger Kochsalzlösung bei 25 °C.

Vinylformamid enthaltende (Co)Polymerisate können erfindungsgemäß in ungespaltener und in zumindest teilweise gespaltener Form eingesetzt werden. Bevorzugt ist ein Spaltgrad von 10 bis 100%, besonders bevorzugt von 20 bis 98% und ganz besonders bevorzugt von 30 bis 95%. Die Art der Abspaltung der Formylgruppe ist dabei nicht beschränkt, sie kann beispielsweise in Gegenwart von Säure oder Base erfolgen, bevorzugt ist die Spaltung in Gegenwart von Basen, wie beispielsweise Natriumhydroxid, Kaliumhydroxid, Erdalkalimetallhydroxide, Ammoniak oder Amine.

Pro Formylgruppenäquivalent im (Co)Polymer von N-Vinylformamid benötigt man für die saure Hydrolyse etwa 0,05 bis 1,5 Äquivalente einer Säure, wie Salzsäure, Bromwasserstoffsäure, Phosphorsäure, Schwefelsäure. Der pH-Wert bei der sauren Hydrolyse liegt in dem Bereich von 2 bis 0, vorzugsweise bei 1 bis 0. Die Hydrolyse verläuft wesentlich schneller als die von (Co)Polymerisaten anderer N-Vinylcarbonsäureamide, wie z. B. des N-Methyl-N-Vinylformamids, und kann daher unter schonenderen Bedingungen, d.h. bei niedrigeren Temperaturen und ohne einen hohen Überschuss von Säuren, durchgeführt werden.

Darüber hinaus lässt sich die Hydrolyse der Formylgruppen des Poly-N-vinylformamids auch in alkalischem Medium durchführen, z.B. in dem pH-Bereich von 11 bis 14. Dieser pH-Wert wird vorzugsweise durch Zugabe von Natronlauge oder Kalilauge eingestellt. Es ist jedoch auch möglich Ammoniak, Amine und/oder Erdalkalimetallbasen zu verwenden. Für die alkalische Hydrolyse verwendet man 0,05 bis 1,5, vorzugsweise 0,4 bis 1,0 Äquivalente einer Base.

Die Abspaltung der Formylgruppe kann beispielsweise in Wasser durchgeführt werden.

Die Abspaltung der Formylgruppe erfolgt bei Temperaturen in dem Bereich von 20 bis 200 °C, vorzugsweise 40 bis 180 °C und besonders bevorzugt in dem Temperaturbereich von 70 bis 90 °C.

Die Spaltung kann auch ohne Säure oder Base bei hohen Temperaturen, beispielsweise über 100 °C, bevorzugt 120 bis 180 °C, besonders bevorzugt 140 bis 160 °C in Gegenwart eines Lösungsmittels, z.B. Wasser, durchgeführt werden. Bevorzugt wird dies bei Bedingungen oberhalb des kritischen Punktes durchgeführt, beispielsweise mit überkritischem Wasser.

Bei der Hydrolyse, d.h. die Formylgruppe wird in Wasser in Gegenwart von Säuren oder Basen, aus dem Poly-N-vinylformamid abgespalten, erhält man als Nebenprodukt Ameisensäure beziehungsweise Salze der Ameisensäure.

Polyalkylenimine, besonders Polyethylenimine, sind vielfältig kommerziell verfügbar und sind erhältlich durch Polymerisation der korrespondierenden monomeren Alkylenimine in Gegenwart von Säuren, Lewis-Säuren oder Halogenalkanen. Bei den Polyethyleniminen kann es sich um Homopolymere, Copolymere oder Pfropfpolymere handeln, wie sie beispielsweise beschrieben sind in US 2,182,306 oder US 3,203,910.

Optional können diese Polymere nachträglich vernetzt werden. Nützliche Vernetzer sind beispielsweise solche multifunktionellen Verbindungen, die reaktive Gruppen gegenüber primären Aminogruppen aufweisen, beispielsweise multifunktionelle Epoxide, wie Diglycidylether von Oligo- oder Polyethylenoxiden oder anderen multifunktionellen Alkoholen, wie beispielsweise Glycerin oder Zucker, multifunktionell Carbonsäureester, Polyisocyanate, multifunktionelle Acrylsäure- oder Methacrylsäureester, multifunktionelle Acrylamide oder Methacrylamide, Epichlorhydrin, multifunktionelle Säurehalogenide, multifunktionelle Alkohole, wie beispielsweise Glycerin oder Zucker, Divinylsulfone, Maleinsäureanhydrid, ω-Hylogencarbonylchloride oder multifunktionelle Halogenalkane, besonders α,ω-Dichloralkane.

Polymere mit Ethylenimineinheiten sind ebenfalls bekannt aus EP 0 411 400 A1, DE 24 34 816 A1 und US 4,066,494.

Beispiele von Polymeren mit Ethylenimineinheiten sind beispielsweise
- Homopolymere von Ethylenimin,
- Polyethyleneimine, die mit mindestens difunktionellen Vernetzern vernetzt sind,
- Polyamidoamine, die mit Ethyleniminen gepfropft sind und mit mindestens difunktionellen Vernetzern vernetzt sind,
- Reaktionsprodukte von Polyethyleniminen mit Monocarbonsäuren, die amidierte Polyethylenimine ergeben,
- Michael Additionsprodukte von Polyethyleniminen auf ethylenisch ungesättigte Säuren, Salze, Ester, Amide oder Nitrile von monoethylenisch ungesättigte Säuren,
- Phosphonomethylierte Polyethyleneimine,
- Carboxylierte Polyethylenimine und
- Alkoxylierte Polyethylenimine.

Polymere die erhältlich sind durch Kondensation mindestens einer Polycarbonsäure mit mindestens einem Polyamin und anschließend durch Pfropfung mit Ethylenimin und anschließender Vernetzung mit einer der oben bezeichneten Komponenten können ebenfalls eingesetzt werden. Ein Verfahren zur Herstellung solcher Verbindungen ist beispielsweise beschrieben in DE 24 34 816 A1, worin α,ω-Chlorohydrinether von Oligo- oder Polyethyleneoxiden als Vernetzer eingesetzt werden.

Reaktionsprodukte von Polyethyleniminen mit Monocarbonsäuren unter Erhalt von amidierten Polyethyleniminen sind bekannt aus WO 94/12560 A1. Michael Additionsprodukte von Polyethyleneiminen mit ethylenisch ungesättigten Säuren, Salzen, Estern, Amiden oder Nitrilen von monoethylenisch ungesättigten Säuren sind bekannt aus WO 94/14873 A1. Phosphonomethyliert Polyethyleneimines sind im Detail beschrieben in WO 97/25367 A1. Carboxylierte Polyethylenimine sind erhältlich, beispielsweise, in einer Strecker Synthese durch Reaktion von Polyethyleneiminen mit Formaldehyd und Ammoniak/Blausäure und Hydrolyse des Reaktionsproduktes. Alkoxylierte Polyethylenimine sind herstellbar durch Reaktion von Polyethyleniminen mit Alkylenoxiden wie Ethylenoxid und/oder Propylenoxid.

Des weiteren sind aminogruppenhaltige Polymere denkbar, wie sie beschrieben in WO 97/25367 A1 sind, dort besonders von Seite 6, Zeile 9 bis Seite 18, Zeile 44, auf die hiermit ausdrücklich Bezug genommen wird, sowie in WO 94/12560 A1, dort besonders Seite 3, Zeile 23 bis Seite 6, Zeile 27, auf die hiermit ausdrücklich Bezug genommen wird.

Zur Herstellung solcher Zweikomponenten Beschichtungsmassen zur Ausbildung feinstrukturierter Oberflächen werden Polyisocyanat und Polyol bzw. Polyamin in einem Molverhältnis von Isocyanatgruppen zu gegenüber Isocyanat reaktiven Gruppen von 0,1:1 bis 10:1, bevorzugt 0,2:1 bis 5:1, besonders bevorzugt 0,3:1 bis 3:1, ganz besonders bevorzugt 0,5:1 bis 2:1, insbesondere 0,8:1 bis 1,2:1 und speziell 0,9:1 bis 1,1:1 miteinander vermischt, wobei gegebenenfalls noch weitere Additive eingemischt werden können, und auf das Substrat aufgetragen.

Anschließend wird Umgebungstemperatur bis 140 °C, bevorzugt 20 bis 80 °C, besonders bevorzugt bis 60 °C die Beschichtungsmasse ausgehärtet.

Dies erfordert je nach Temperatur in der Regel nicht mehr 12 Stunden, bevorzugt bis zu 8 Stunden, besonders bevorzugt bis zu 6, ganz besonders bevorzugt bis zu 4 und insbesondere bis zu 3 Stunden.

Insbesondere handelt es sich bei dem Polyisocyanat um Isocyanuratgruppen enthaltende Polyisocyanate von 1,6-Hexamethylendiisocyanat.

Insbesondere handelt es sich bei dem Polyisocyanat um ein Gemisch von Isocyanuratgruppen enthaltenden Polyisocyanaten von 1,6-Hexamethylendiisocyanat und von Isophorondiisocyanat.

Insbesondere handelt es sich bei dem Polyisocyanat um ein Gemisch enthaltend niedrigviskose Polysiocyanate, bevorzugt Isocyanuratgruppen enthaltende Polyisocyanate, mit einer Viskosität von 600-1500 mPa*s, insbesondere unter 1200 mPa*s, niederviskose Urethane und/oder Allophanate mit einer Viskosität von 200-1600 mPa*s, insbesondere 600-1500 mPa*s, und/oder Iminooxadiazindiongruppen enthaltende Polyisocyanate.

Erfindungsgemäß handelt es sich bei den Beschichtungsmassen um strahlungshärtbare Beschichtungsmassen, die durch Strahlung gehärtet werden.

Strahlungshärtung heißt hier, dass die radikalische Polymerisation von polymerisierbaren Verbindungen infolge einer elektromagnetischen und/oder korpuskularen Strahlung initiiert wird, beispielsweise (N)IR-Licht im Wellenlängenbereich von λ=700 - 1200 nm, bevorzugt 700 - 900 nm und/oder UV-Licht im Wellenlängenbereich von λ=200 bis 700 nm, bevorzugt von λ=200 bis 500 nm und besonders bevorzugt λ=250 bis 400 nm und/oder Elektronenstrahlung im Bereich von 150 bis 300 keV und besonders bevorzugt mit einer Strahlungsdosis von mindestens 80, bevorzugt 80 bis 3000 mJ/cm².

Bei Härtung mit Hilfe von (N)IR- und/oder UV-Licht ist dabei darauf zu achten, dass in diesem Fall in den Beschichtungsmassen Photoinitiatoren anwesend sind, die durch Licht der eingestrahlten Wellenlänge zu Radikalen zersetzt werden können, die ihrerseits eine radikalische Polymerisation starten können.

Bei Härtung mit Elektronenstrahlung ist die Anwesenheit solcher Photoinitiatoren dagegen nicht erforderlich.

Bei der strahlungshärtbaren Beschichtungsmasse handelt es sich bevorzugt Acrylsäureester, Methacrylsäureester und/oder ungesättigte Polyesterharze.

Ungesättigte Polyesterharze sind dem Fachmann an sich bekannt.

Bevorzugt handelt es sich um ein ungesättigtes Polyesterharz, das zumindest aufgebaut ist aus den Komponenten:
(a1) Maleinsäure oder deren Derivate,
(a2) mindestens eine cyclische Dicarbonsäure oder deren Derivate,
(a3) mindestens ein aliphatisches oder cycloaliphatisches Diol.

Unter Derivaten werden im Rahmen dieser Schrift bevorzugt verstanden
- die betreffenden Anhydride in monomerer oder auch polymerer Form,
- Mono- oder Dialkylester, bevorzugt Mono- oder Di-C₁-C₄-alkylester, besonders bevorzugt Mono- oder Dimethylester oder die entsprechenden Mono- oder Diethylester,
- ferner Mono- und Divinylester sowie
- gemischte Ester, bevorzugt gemischte Ester mit unterschiedlichen C₁-C₄-Alkylkomponenten, besonders bevorzugt gemischte Methylethylester.

C₁-C₄-Alkyl bedeutet im Rahmen dieser Schrift Methyl, Ethyl, *iso*-Propyl, n-Propyl, n-Butyl, *iso*-Butyl, *sek*-Butyl und *tert-*Butyl, bevorzugt Methyl, Ethyl und n-Butyl, besonders bevorzugt Methyl und Ethyl und ganz besonders bevorzugt Methyl.

Im Rahmen der vorliegenden Erfindung ist es auch möglich, ein Gemisch aus einer Dicarbonsäure und einem oder mehreren ihrer Derivate einzusetzen. Gleichfalls ist es im Rahmen der vorliegenden Erfindung möglich, ein Gemisch mehrerer verschiedener Derivate von einer oder mehreren Dicarbonsäuren einzusetzen.

Bei der Komponente (a1) handelt es sich um Maleinsäure oder deren Derivate, bevorzugt um Maleinsäure oder Maleinsäureanhydrid.

Bei der Komponente (a2) handelt es sich um mindestens eine, bevorzugt ein bis vier, besonders bevorzugt ein bis drei und ganz besonders bevorzugt genau eine cyclische Dicarbonsäure oder deren Derivate.

Unter einer cyclischen Verbindung wird dabei im Rahmen der vorliegenden Schrift eine Verbindung verstanden, die mindestens einen, bevorzugt ein bis zwei und besonders bevorzugt genau einen Carbo- oder Heterocyclus, bevorzugt Carbocyclus enthält. Dabei kann es sich um aromatische oder alicyclische Verbindungen handeln, wobei letztere sowohl im Ring partiell ungesättigte als auch gesättigte Verbindungen umfassen.

Bevorzugt handelt es sich bei den Cyclen um fünf- bis sechsgliedrige Cyclen, besonders bevorzugt um sechsgliedrige Cyclen.

Beispiele für aromatische Komponenten (a2) sind Phthalsäure, Isophthalsäure oder Terephthalsäure, bevorzugt ist (a2) ausgewählt aus der Gruppe bestehend aus Phthalsäure und Terephthalsäure.

Beispiele für alicyclische Komponenten (a2) sind cis- und trans-Cyclohexan-1,2-dicarbonsäure, cis- und trans-Cyclohexan-1,3-dicarbonsäure, cis- und trans-Cyclohexan-1,4-dicarbonsäure, cis- und trans-Cyclopentan-1,2-dicarbonsäure, cis- und trans-Cyclopentan-1,3-dicarbonsäure sowie Cyclohex-1-en-1,2-dicarbonsäure. Bevorzugt handelt es sich um technische Isomerengemische von Hexahydro- und Tetrahydrophthalsäure.

Bei der Komponente (a3) handelt es sich um mindestens ein, bevorzugt ein bis vier, besonders bevorzugt ein bis drei, ganz besonders bevorzugt ein bis zwei und insbesondere genau ein aliphatisches oder cycloaliphatisches Diol.

Als Diole gemäß der vorliegenden Erfindung verwendet man beispielsweise Ethylenglykol, Propan-1,2-diol, Propan-1,3-diol, Butan-1,2-diol, Butan-1,3-diol, Butan-1,4-diol, Butan-2,3-diol, Pentan-1,2-diol, Pentan-1,3-diol, Pentan-1,4-diol, Pentan-1,5-diol, Pentan-2,3-diol, Pentan-2,4-diol, Hexan-1,2-diol, Hexan-1,3-diol, Hexan-1,4-diol, Hexan-1,5-diol, Hexan-1,6-diol, Hexan-2,5-diol, Heptan-1,2-diol 1,7-Heptandiol, 1,8-Octandiol, 1,2-Octandiol, 1,9-Nonandiol, 1,2-Decandiol, 1,10-Decandiol, 1,2-Dodecandiol, 1,12-Dodecandiol, 1,5-Hexadien-3,4-diol, 1,2-und 1,3-Cyclopentandiole, 1,2-, 1,3- und 1,4-Cyclohexandiole, 1,1-, 1,2-, 1,3- und 1,4-Bis-(Hydroxymethyl)cyclohexane, 1,1-, 1,2-, 1,3- und 1,4-Bis(Hydroxyethyl)cyclohexane, Neopentylglykol, (2)-Methyl-2,4-pentandiol, 2,4-Dimethyl-2,4-Pentandiol, 2-Ethyl-1,3-hexandiol, 2,5-Dimethyl-2,5-hexandiol, 2,2,4-Trimethyl-1,3-pentandiol, Pinacol, Diethylenglykol, Triethylenglykol, Dipropylenglykol, Tripropylenglykol, Polyethylenglykole HO(CH₂CH₂O)ₙ-H oder Polypropylenglykole HO(CH[CH₃]CH₂O)ₙ-H, wobei n eine ganze Zahl und n ≥ 4 ist, Polyethylen-polypropylenglykole, wobei die Abfolge der Ethylenoxid- der Propylenoxid-Einheiten blockweise oder statistisch sein kann, Polytetramethylenglykole, vorzugsweise bis zu einem Molgewicht bis zu 5000 g/mol, Poly-1,3-Propandiole, vorzugsweise mit einem Molgewicht bis zu 5000 g/mol, Polycaprolactone oder Gemische von zwei oder mehr Vertretern der voranstehenden Verbindungen.

Bevorzugt eingesetzte Diole sind Ethylenglykol, 1,2-Propandiol, 1,3-Propandiol, 1,4-Butandiol, 1,5-Pentandiol, 1,6-Hexandiol, 1,8-Octandiol, 1,2-, 1,3- und 1,4-Cyclohexandiol, 1,3- und 1,4-Bis(hydroxymethyl)cyclohexan, sowie Diethylenglykol, Triethylenglykol, Dipropylenglykol und Tripropylenglykol.

Die Diole können optional noch weitere Funktionalitäten wie beispielsweise Carbonyl, Carboxy, Alkoxycarbonyl oder Sulfonyl enthalten, wie beispielsweise Dimethylolpropionsäure oder Dimethylolbuttersäure, sowie deren C₁-C₄-Alkylester, bevorzugt weisen die Diole jedoch keine weiteren Funktionalitäten auf.

Besonders bevorzugte aliphatische Diole sind solche, die 2 bis 6 Kohlenstoffatome aufweisen. Ganz besonders bevorzugt bevorzugt sind die aliphatischen Diole ausgewählt aus der Gruppe bestehend aus Diethylenglykol und Neopentylglykol.

Gleichermaßen bevorzugt kann es sich bei dem Diol (a2) um cycloaliphatische Diole handeln, besonders bevorzugt um 1,1-, 1,2-, 1,3- und 1,4-Bis-(Hydroxymethyl)cyclohexane oder 2,2-Bis(4-hydroxycyclohexyl)propan.

Neben den Aufbaukomponenten (a1), (a2) und (a3) kann das ungesättigte Polyesterharz (a) optional noch weitere Komponenten enthalten:

Optional kann als Aufbaukomponente (a4) mindestens eine andere Dicarbonsäure oder deren Derivate als (a1) und (a2) anwesend sein. Bei der Komponente (a4) kann es sich beispielsweise um andere acyclische Dicarbonsäuren handeln, bevorzugt sind Oxalsäure, Malonsäure, Bernsteinsäure, Glutarsäure, Adipinsäure, Pimelinsäure, Korksäure, Azelainsäure, Sebacinsäure, Undecan-α,ω-dicarbonsäure, Dodecan-α,ω-dicarbonsäure, 2-Methylmalonsäure, 2-Ethylmalonsäure, 2-Phenylmalonsäure, 2-Methylbernsteinsäure, 2-Ethylbernsteinsäure, 2-Phenylbernsteinsäure, Itaconsäure, 3,3-Dimethylglutarsäure oder Fumarsäure, besonders bevorzugt sind Malonsäure, Bernsteinsäure, Glutarsäure und Adipinsäure.
(a5) Des Weiteren kann optional mindestens eine Polycarbonsäure mit einer Funktionalität von 3 oder mehr oder deren Derivate anwesend sein.

Beispiele dafür sind Aconitsäure, 1,3,5-Cyclohexantricarbonsäure, 1,2,4-Benzoltricarbonsäure, 1,3,5-Benzoltricarbonsäure, 1,2,4,5-Benzoltetracarbonsäure (Pyromellitsäure) sowie Mellitsäure und niedermolekulare Polyacrylsäuren.

Des Weiteren kann als weitere optionale Aufbaukomponente (a6) ein anderes Diol als die unter (a3) beschriebenen anwesend sein.

Des Weiteren kann als weitere optionale Aufbaukomponente (a7) ein Polyol mit einer Funktionalität von 3 oder mehr anwesend sein.

Beispiele dafür sind Glycerin, Trimethylolmethan, Trimethylolethan, Trimethylolpropan, 1,2,4-Butantriol, Tris(hydroxymethyl)amin, Tris(hydroxyethyl)amin, Tris(hydroxypropyl)amin, Pentaerythrit, Diglycerin, Triglycerin oder höhere Kondensationsprodukte des Glycerins, Di(trimethylolpropan), Di(pentaerythrit), Trishydroxymethylisocyanurat, Tris(hydroxyethyl)isocyanurat (THEIC), Tris(hydroxypropyl)isocyanurat, Inositole oder Zucker, wie zum Beispiel Glucose, Fructose oder Sucrose, Zuckeralkohole wie z.B. Sorbit, Mannit, Threit, Erythrit, Adonit (Ribit), Arabit (Lyxit), Xylit, Dulcit (Galactit), Maltit, Isomalt, tri- oder höherfunktionelle Polyetherole auf Basis tri- oder höherfunktioneller Alkohole und Ethylenoxid, Propylenoxid und/oder Butylenoxid.

Die Zusammensetzung der ungesättigten Polyesterharze (a) ist in der Regel wie folgt:
(a1) 30 - 70 mol% bezüglich aller in (a) vorhandenen Carboxylgruppen und deren Derivate, bevorzugt 40 - 60 mol%,
(a2) 30 - 70 mol% bezüglich aller in (a) vorhandenen Carboxylgruppen und deren Derivate, bevorzugt 40 - 60 mol%,
(a3) 80 - 100 mol% bezüglich aller in (a) vorhandenen Hydroxygruppen, bevorzugt 100 mol%,
(a4) 0 - 20 mol% bezüglich aller in (a) vorhandenen Carboxylgruppen und deren Derivate, bevorzugt 0 mol%,
(a5) 0 - 5 mol% bezüglich aller in (a) vorhandenen Carboxylgruppen und deren Derivate, bevorzugt 0 mol%,
(a6) 0 - 20 mol% bezüglich aller in (a) vorhandenen Hydroxygruppen, bevorzugt 0 mol% und
(a7) 0 - 5 mol% bezüglich aller in (a) vorhandenen Hydroxygruppen, bevorzugt 0 mol%,

mit der Maßgabe, dass die Summe aller Hydroxygruppen 100 mol% und die Summe aller Carboxylgruppen 100 mol% beträgt, und die Stöchiometrie von Hydroxygruppen zu Carboxylgruppen von 1:0,85 bis 1:1,25, bevorzugt 1:0,9 bis 1:1,2 und besonders bevorzugt 1:0,95 bis 1:1,15 beträgt.

Bevorzugte ungesättigte Polyesterharze (a) weisen eine Glasübergangstemperatur Tg, gemessen nach der DSC-Methode (Differential Scanning Calorimetry) gemäß ASTM 3418/82 bei einer Aufheizrate von 20 °C/min, von 0 °C oder mehr, bevorzugt 10 °C oder mehr und besonders bevorzugt 25 °C oder mehr auf.

Bevorzugte ungesättigte Polyesterharze (a) weisen ein zahlenmittleres Molekulargewicht Mₙ von 1000 bis 10000 g/mol (bestimmt durch Gelpermeationschromatographie mit Polystyrol als Standard, Lösemittel Tetrahydrofuran) auf, bevorzugt von 1500 bis 8000 und besonders bevorzugt von 2000 bis 5000 g/mol.

Bevorzugt handelt es sich bei den strahlungshärtbaren Beschichtungsmassen um Polyester-, Polyether-, Carbonat-, Epoxy- oder Urethan(meth)acrylate sowie (meth)acrylierte Polyacrylate, die optional teilweise aminmodifiziert sein können.

Bei diesen handelt es sich um mindestens eine, beispielsweise ein bis vier, bevorzugt ein bis drei, besonders bevorzugt ein bis zwei und ganz besonders bevorzugt genau eine, strahlungshärtbare Verbindung mit mehr als 2, bevorzugt 3 - 10, besonders bevorzugt 3 - 6, ganz besonders bevorzugt 3 - 4 und insbesondere 3 radikalisch polymerisierbaren Gruppen.

Polyester(meth)acrylate sind die entsprechenden Ester von α,β-ethylenisch ungesättigten Carbonsäuren, bevorzugt von (Meth)acrylsäure, besonders bevorzugt von Acrylsäure mit Polyesterpolyolen.

Als Polyesterpolyole können beispielsweise solche eingesetzt werden, wie sie oben für Zweikomponenten Beschichtungsmassen beschrieben worden sind.

Polyether(meth)acrylate sind die entsprechenden Ester von α,β-ethylenisch ungesättigten Carbonsäuren, bevorzugt von (Meth)acrylsäure, besonders bevorzugt von Acrylsäure mit Polyetherolen.

Bevorzugt handelt es sich bei den Polyetherolen um Polyethylenglykol mit einer Molmasse zwischen 106 und 2000, bevorzugt 106 bis 1500, besonders bevorzugt 106 bis 1000, Poly-1,2-Propandiol mit einer Molmasse zwischen 134 und 1178, Poly-1,3-Propandiol mit einer Molmasse zwischen 134 und 1178 und Polytetrahydrofurandiol mit einem zahlenmittleren Molekulargewicht Mₙ im Bereich von etwa 500 bis 4000, bevorzugt 600 bis 3000, insbesondere 750 bis 2000.

Urethan(meth)acrylate sind z.B. erhältlich durch Umsetzung von Polyisocyanaten mit Hydroxyalkyl(meth)acrylaten und gegebenenfalls Kettenverlängerungsmitteln wie Diolen, Polyolen, Diaminen, Polyaminen oder Dithiolen oder Polythiolen. In Wasser ohne Zusatz von Emulgatoren dispergierbare Urethan-(meth)acrylate enthalten zusätzlich noch ionische und/oder nichtionische hydrophile Gruppen, welche z.B. durch Aufbaukomponenten wie Hydroxycarbonsäuren ins Urethan eingebracht werden.

Derartige Urethan(meth)acrylate enthalten als Aufbaukomponenten im Wesentlichen:
(a) mindestens ein organisches aliphatisches, aromatisches oder cycloaliphatisches Di- oder Polyisocyanat, beispielsweise mindestens eines der oben bei der Zweikomponenten Beschichtungsmassen beschriebenen Polyisocyanaten,
(b) mindestens eine Verbindung mit mindestens einer gegenüber Isocyanat reaktiven Gruppe, bevorzugt einem der oben bei den Polyacrylatpolyolen beschriebenen hydroxygruppentragenden Monomere, und mindestens einer radikalisch polymerisierbaren ungesättigten Gruppe und
(c) gegebenenfalls mindestens eine Verbindung mit mindestens zwei gegenüber Isocyanat reaktiven Gruppen, beispielsweise einem der oben bei den Polyesterolen beschriebenen mehrwertrigen Alkoholen.

Die Urethan(meth)acrylate haben vorzugsweise ein zahlenmittleres Molgewicht Mₙ von 500 bis 20 000, insbesondere von 500 bis 10 000 besonders bevorzugt 600 bis 3000 g/mol (bestimmt durch Gelpermeationschromatographie mit Tetrahydrofuran und Polystyrol als Standard).

Die Urethan(meth)acrylate haben vorzugsweise einen Gehalt von 1 bis 5, besonders bevorzugt von 2 bis 4 Mol (Meth)acrylgruppen pro 1000 g Urethan(meth)acrylat.

Epoxid(meth)acrylate sind erhältlich durch Umsetzung von Epoxiden mit (Meth)acrylsäure. Als Epoxide in Betracht kommen z.B. epoxidierte Olefine, aromatische Glycidylether oder aliphatische Glycidylether, bevorzugt solche von aromatischen oder aliphatischen Glycidylethern.

Epoxidierte Olefine können beispielsweise sein Ethylenoxid, Propylenoxid, *iso*-Butylenoxid, 1-Butenoxid, 2-Butenoxid, Vinyloxiran, Styroloxid oder Epichlorhydrin, bevorzugt sind Ethylenoxid, Propylenoxid, *iso*-Butylenoxid, Vinyloxiran, Styroloxid oder Epichlorhydrin, besonders bevorzugt Ethylenoxid, Propylenoxid oder Epichlorhydrin und ganz besonders bevorzugt Ethylenoxid und Epichlorhydrin.

Aromatische Glycidylether sind z.B. Bisphenol-A-diglycidylether, Bisphenol-F-diglycidylether, Bisphenol-B-diglycidylether, Bisphenol-S-diglycidylether, Hydrochinondiglycidylether, Alkylierungsprodukte von Phenol/Dicyclopentadien, z.B. 2,5-bis[(2,3-Epoxypropoxy)phenyl]octahydro-4,7-methano-5H-inden) (CAS-Nr. [13446-85-0]), Tris[4-(2,3-epoxypro-poxy)phenyl]methan Isomere )CAS-Nr. [66072-39-7]), Phenol basierte Epoxy Novolake (CAS-Nr. [9003-35-4]) und Kresol basierte Epoxy Novolake (CAS-Nr. [37382-79-9]).

Aliphatische Glycidylether sind beispielsweise 1,4-Butandioldiglycidether, 1,6-Hexandioldiglycidylether, Trimethylolpropantriglycidylether, Pentaerythrittetraglycidylether, 1,1,2,2-tetrakis[4-(2,3-epoxypropoxy)phenyl]ethan (CAS-Nr. [27043-37-4]), Diglycidylether von Polypropylenglykol (α,ω-bis(2,3-epoxypropoxy)poly(oxypropylen) (CAS-Nr. [16096-30-3]) und von hydriertem Bisphenol A (2,2-bis[4-(2,3-epoxypropoxy)cyclo-hexyl]propan, CAS-Nr. [13410-58-7]).

Die Epoxid(meth)acrylate haben vorzugsweise ein zahlenmittleres Molgewicht Mₙ von 200 bis 20000, besonders bevorzugt von 200 bis 10000 g/mol und ganz besonders bevorzugt von 250 bis 3000 g/mol; der Gehalt an (Meth)acrylgruppen beträgt vorzugsweise 1 bis 5, besonders bevorzugt 2 bis 4 pro 1000 g Epoxid(meth)-acrylat (bestimmt durch Gelpermeationschromatographie mit Polystyrol als Standard und Tetrahydrofuran als Elutionsmittel).

(Meth)acrylierte Poylacrylate sind die entsprechenden Ester von α,β-ethylenisch ungesättigten Carbonsäuren, bevorzugt von (Meth)acrylsäure, besonders bevorzugt von Acrylsäure mit Polyacrylatpolyolen, erhältlich durch Veresterung von Polyacrylatpolyolen mit (Meth)acrylsäure.

Bei den Polyacrylatpolyolen kann es sich beispielsweise um solche handeln, wie sie oben bei den Zweikomponenten Beschichtungsmassen beschrieben worden sind.

Carbonat(meth)acrylate sind ebenfalls mit verschiedenen Funktionalitäten erhältlich.

Das zahlenmittlere Molekulargewicht Mₙ der Carbonat(meth)-acrylate ist vorzugsweise kleiner 3000 g/mol, besonders bevorzugt kleiner 1500 g/mol, besonders bevorzugt kleiner 800 g/mol (bestimmt durch Gelpermeationschromatographie mit Polystyrol als Standard, Lösemittel Tetrahydrofuran).

Die Carbonat(meth)acrylate sind in einfacher Weise erhältlich durch Umesterung von Kohlensäureestern mit mehrwertigen, vorzugsweise zweiwertigen Alkoholen (Diolen, z.B. Hexandiol) und anschließende Veresterung der freien OH-Gruppen mit (Meth)-acrylsäure oder auch Umesterung mit (Meth)acrylsäureestern, wie es z.B. in EP 0 092 269 A1 beschrieben ist. Erhältlich sind sie auch durch Umsetzung von Phosgen, Harnstoffderivaten mit mehrwertigen, z.B. zweiwertigen Alkoholen.

Denkbar sind auch (Meth)acrylate von Polycarbonatpolyolen, wie das Reaktionsprodukt aus einem der genannten Di- oder Polyole und einem Kohlensäureester sowie einem hydroxylgruppenhaltigen (Meth)acrylat.

Geeignete Kohlensäureester sind z.B. Ethylen-, 1,2- oder 1,3-Propylencarbonat, Kohlensäuredimethyl-, -diethyl- oder -dibutylester.

Geeignete hydroxygruppenhaltige (Meth)acrylate sind beispielsweise 2-Hydroxyethyl(meth)acrylat, 2- oder 3-Hydroxypropyl(meth)acrylat, 1,4-Butandiolmono(meth)acrylat, Neopentylglykolmono(meth)acrylat, Glycerinmono- und di(meth)acrylat, Trimethylolpropanmono- und di(meth)acrylat sowie Pentaerythritmono-, -di- und -tri(meth)acrylat.

Besonders bevorzugte Carbonat(meth)acrylate sind solche der Formel: 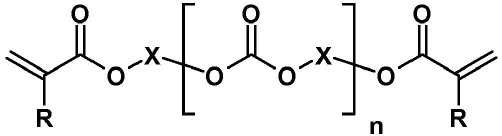 worin R für H oder CH₃, X für eine C₂-C₁₈ Alkylengruppe und n für eine ganze Zahl von 1 bis 5, vorzugsweise 1 bis 3 steht.

R steht vorzugsweise für H und X steht vorzugsweise für C₂- bis C₁₀-Alkylen, beispielsweise 1,2-Ethylen, 1,2-Propylen, 1,3-Propylen, 1,4-Butylen oder 1,6-Hexylen, besonders bevorzugt für C₄- bis C₈-Alkylen. Ganz besonders bevorzugt steht X für C₆-Alkylen.

Vorzugsweise handelt es sich bei den Carbonat(meth)acrylaten um aliphatische Carbonat(meth)acrylate.

In einer bevorzugten Ausführungsform ist die strahlungshärtbare Beschichtungsmasse wie folgt aufgebaut:
- mindestens ein Polyester-, Polyether-, Carbonat-, Epoxy- und/oder Urethan(meth)acrylat oder ungesättigtes Polyesterharz,
- optional mindestens einen Reaktivverdünner,
- optional mindestens ein Photoinitiator,
- optional mindestens ein Lösungsmittel,
- optional mindestens einen Stabilisator,
- optional mindestens Additiv, ausgewählt aus der Gruppe bestehend aus Aktivatoren, Füllmittel, Pigmente, Farbstoffe, Verdicker, thixotrope Agentien, oberflächenaktive Agentien, Viskositätsmodifikatoren, Plastifizierer und Chelatbildner.

Beispielsweise kann eine strahlungshärtbare Beschichtungsmasse zusammengesetzt sein wie folgt:
- 40 bis 100 Gew.-% mindestens eines Polyester-, Polyether-, Carbonat-, Epoxy- oder Urethan(meth)acrylats oder eines ungesättigten Polyesterharzes,
- 0 bis 60 Gew.-% mindestens eines Reaktivverdünners,
- 0 bis 5 Gew.-% mindestens eines Photoinitiators,
- 0 bis 20 Gew.-% mindestens eines Lösungsmittels,
- 0 bis 5 Gew.-% mindestens eines Stabilisators,
- 0 bis 5 Gew.-% mindestens eines Additivs, ausgewählt aus der Gruppe bestehend aus Aktivatoren, Füllmittel, Pigmente, Farbstoffe, Verdicker, thixotrope Agentien, oberflächenaktive Agentien, Viskositätsmodifikatoren, Plastifizierer und Chelatbildner,
mit der Maßgabe, dass die Summe immer 100 Gew.-% ergibt.

Im Einzelfall kann es sinnvoll sein, geringere Mengen mindestens eines Polyester-, Polyether-, Carbonat-, Epoxy- oder Urethan(meth)acrylats oder eines ungesättigten Polyesterharzes als die angegeben 40 Gew.-% in der strahlungshärtbaren Beschichtungsmasse einzusetzen, besonders dann, wenn der mindestens eine Reaktivverdünner die Anforderungen an Viskosität und E-Modul erfüllt, ohne dass es die Anwesenheit eines Polyester-, Polyether-, Carbonat-, Epoxy- oder Urethan(meth)acrylats oder eines ungesättigten Polyesterharzes bedarf. In diesem Fall kann der Reaktivverdünner bis zu 80, teilweise bis zu 90 wenn nicht sogar bis zu 100 Gew.-% der strahlungshärtbaren Beschichtungsmasse oder der strahlungshärtbaren Komponenten innerhalb der Beschichtungsmasse ausmachen. Im Gegenzug kann der Anteil des Polyester-, Polyether-, Carbonat-, Epoxy- oder Urethan(meth)acrylats oder des ungesättigten Polyesterharzes entsprechend nicht mehr als 20, nicht mehr als 10 oder sogar 0 Gew.-% ausmachen.

Erfindungsgemäße strahlungshärtbare Beschichtungsmassen sind solche, die eine Doppelbindungsdichte von nicht mehr als 7 mol/kg aufweisen.

In der Regel ist jedoch zumindest eine Doppelbindungsdichte von 0,1 mol/kg erforderlich, bevorzugt mindestens 0,5 mol/kg, besonders bevorzugt mindestens 1 mol/kg, ganz besonders bevorzugt mindestens 2 und insbesondere mindestens 2,5 mol/kg.

Unter Doppelbindungsdichte wird die Stoffmenge an polymerisierbaren Gruppen, also beispielsweise Vinylether-, Acrylsäure- und Methacrylsäuregruppen, bevorzugt Acrylsäure- und Methacrylsäuregruppen pro kg Bindemittel vestanden, wobei als Bindemittel die Komponenten Polyester-, Polyether-, Carbonat-, Epoxy- oder Urethan(meth)acrylat, ungesättigtes Polyesterharz sowie Reaktivverdünner gerechnet werden.

Wie oben ausgeführt ist ein Photoinitiator dann erforderlich, wenn in dem erfindungsgemäßen Verfahren die Beschichtungsmasse mit (N)IR- und/oder UV-Strahlung gehärtet wird, nicht jedoch, wenn eine Härtung per Elektronenstrahlung erfolgt.

Unter einem Reaktivverdünner werden dabei solche Verbindungen verstanden, die eine Viskosität bei 25 °C zwischen 1 und 500 mPas, bevorzugt zwischen 1 und 200 mPas und besonders bevorzugt zwischen 1 und 100 mPas aufweisen. In der Regel weisen diese Reaktivverdünner nicht mehr als sechs, bevorzugt bis zu vier, besonders bevorzugt bis zu drei, ganz besonders bevorzugt ein bis drei und insbesondere zwei bis drei strahlungshärtbare Gruppen auf.

Dies können beispielsweise multifunktionelle (Meth)acrylsäureester sein:

Beispiele für multifunktionelle, polymerisationsfähige Verbindungen sind Ethylen-glykoldiacrylat, 1,2-Propandioldiacrylat, 1,3-Propandioldiacrylat, 1,4-Butandioldiacrylat, 1,3-Butandioldiacrylat, 1,5-Pentandioldiacrylat, 1,6-Hexandioldiacrylat, 1,8-Octandioldiacrylat, Neopentylglykoldiacrylat, 1,1-, 1,2-, 1,3- und 1,4-Cyclohexandimethanoldiacry-lat, 1,2-, 1,3- oder 1,4-Cyclohexandioldiacrylat.

Beispiele für multifunktionelle, polymerisationsfähige Verbindungen sind Trimethylolpropantriacrylat, Ditrimethylolpropanpenta- oder -hexaacrylat, Pentaerythrittri- oder -tetraacrylat, Glycerindi- oder -triacrylat, sowie Di- und Polyacrylate von Zuckeralkoholen, wie beispielsweise Sorbit, Mannit, Diglycerol, Threit, Erythrit, Adonit (Ribit), Arabit (Lyxit), Xylit, Dulcit (Galactit), Maltit oder Isomalt.

Weitere Beispiele für sind (Meth)Acrylate von Verbindungen der Formel (IIa) bis (IId), 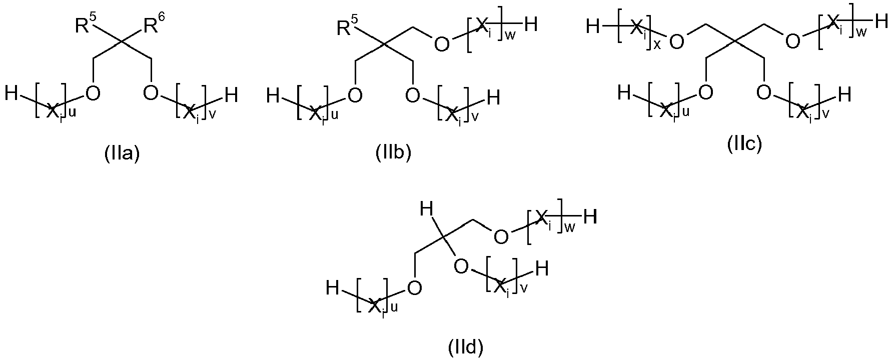 worin
R⁵ und R⁶ unabhängig voneinander Wasserstoff oder gegebenenfalls durch Aryl, Alkyl, Aryloxy, Alkyloxy, Heteroatome und/oder Heterocyclen substituiertes C₁ - C₁₈-Alkyl,
u, v, w, x unabhängig voneinander je für eine ganze Zahl von 1 bis 10, bevorzugt 1 bis 5 und besonders bevorzugt 1 bis 3 steht und
jedes Xᵢ für i = 1 bis u, 1 bis v, 1 bis w und 1 bis x unabhängig voneinander ausgewählt sein kann aus der Gruppe -CH₂-CH₂-O-, -CH₂-CH(CH₃)-O-, -CH(CH₃)-CH₂-O-, -CH₂-C(CH₃)₂-O-, -C(CH₃)₂-CH₂-O-, -CH₂-CHVin-O-, -CHVin-CH₂-O-, -CH₂-CHPh-O- und -CHPh-CH₂-O-, bevorzugt aus der Gruppe -CH₂-CH₂-O-, -CH₂-CH(CH₃)-O- und -CH(CH₃)-CH₂-O-, und besonders bevorzugt -CH₂-CH₂-O-,
worin Ph für Phenyl und Vin für Vinyl steht.

Darin bedeuten gegebenenfalls durch Aryl, Alkyl, Aryloxy, Alkyloxy, Heteroatome und/oder Heterocyclen substituiertes C₁ - C₁₈-Alkyl beispielsweise Methyl, Ethyl, Propyl, Isopropyl, n-Butyl, sec-Butyl, tert.-Butyl, Pentyl, Hexyl, Heptyl, Octyl, 2-Etylhexyl, 2,4,4-Trimethylpentyl, Decyl, Dodecyl, Tetradecyl, Hetadecyl, Octadecyl, 1,1-Dimethylpropyl, 1,1-Dimethylbutyl, 1,1,3,3-Tetramethylbutyl, bevorzugt Methyl, Ethyl oder n-Propyl, ganz besonders bevorzugt Methyl oder Ethyl.

Bevorzugt handelt es sich dabei um (Meth)Acrylate von ein- bis zwanzigfach und besonders bevorzugt drei- bis zehnfach ethoxyliertem, propoxyliertem oder gemischt ethoxyliertem und propoxyliertem und insbesondere ausschließlich ethoxyliertem Neopentylglykol, Trimethylolpropan, Trimethylolethan oder Pentaerythrit.

Bevorzugte multifunktionelle, polymerisationsfähige Verbindungen sind Ethylenglykoldiacrylat, 1,2-Propandioldiacrylat, 1,3-Propandioldiacrylat, 1,4-Butandioldiacrylat, 1,6-Hexandioldiacrylat, Dipropylenglykoldiacrylat, Trimethylolpropantriacrylat, Pentaerythrittetraacrylat und Triacrylat von ein- bis zwanzigfach alkoxyliertem, besonders bevorzugt Glycerin oder ethoxyliertem Trimethylolpropan.

Ganz besonders bevorzugte multifunktionelle, polymerisationsfähige Verbindungen sind 1,4-Butandioldiacrylat, 1,6-Hexandioldiacrylat, Trimethylolpropantriacrylat, Pentaerythrittetraacrylat und Triacrylat von ein- bis zwanzigfach ethoxyliertem Trimethylolpropan.

Denkbar sind auch einwertige (Meth)acrylate, beispielsweise (2-Phenoxyethylacrylat) oder höherethoxylierte Phenoxyacrylate, Ethyldiglykolacrylat, 4-tert.-Butylcyclohexylacrylat, Trimethylolpropanformalmonoacrylat, Isobornylacrylat, Tetrahydrofurfuryacrylatl, 2-(2-Ethoxyethoxy)ethylacrylat, sowie Lauryl-, Stearyl-, Isodecyl-, Octyl- und Decylacrylat.

Denkbar sind auch Ester von α,β-ethylenisch ungesättigten Carbonsäuren, bevorzugt von (Meth)acrylsäure mit Alkoholen, die 1 bis 20 C-Atome aufweisen, bevorzugt gegebenenfalls hydroxysubstituierte 1 bis 20 C-Atome aufweisende Alkanole, z.B. (Meth)acrylsäure-methylester, (Meth)acrylsäureethylester, (Meth)acrylsäure-n-butylester, (Meth)acrylsäure-2-ethylhexylester, 2-Hydroxyethyl(meth)acrylat, 2-Hydroxypropyl(meth)acrylat oder 4-Hydroxybutyl(meth)acrylat.

Weiterhin denkbar sind Ester der (Meth)acrylsäure mit Cycloalkanolen oder Bicycloalkanolen, wobei das Cycloalkanol oder Bicycloalkanol von 3 bis 20 Kohlenstoffatomen, bevorzugt 5 bis 10 Kohlenstoffatome aufweist und gegebenenfalls mit einem oder mehreren C₁- bis C₄-Alkylresten substituiert sein kann.

Beispiele für Cycloalkanol und Bicycloalkanol sind Cyclopentanol, Cyclohexanol, Cyclooctanol, Cyclododecanol, 4-Methyl cyclohexanol, 4-iso Propyl cyclohexanol, 4-tert. Butyl cyclohexanol (bevorzugt cis konfiguriert), Dihydrodicyclopentadienylalkohol und Norbornylalkohol. Bevorzugt ist Cyclohexanol und 4-tert. Butyl cyclohexanol.

UV-Photoinitiatoren können beispielsweise dem Fachmann bekannte Photoinitiatoren sein, z.B. solche in "Advances in Polymer Science", Volume 14, Springer Berlin 1974 oder in K. K. Dietliker, Chemistry and Technology of UV- and EB-Formulation for Coatings, Inks and Paints, Volume 3; Photoinitiators for Free Radical and Cationic Polymerization, P. K. T. Oldring (Eds), SITA Technology Ltd, London, genannten.

In Betracht kommen beispielsweise Phosphinoxide, Benzophenone, α-Hydroxy-alkyl-aryl-ketone, Thioxanthone, Anthrachinone, Acetophenone, Benzoine und Benzoinether, Ketale, Imidazole oder Phenylglyoxylsäuren und Gemische davon.

Phosphinoxide sind beispielsweise Mono- oder Bisacylphosphinoxide, wie sie z.B. in EP 7 508 A2, EP 57 474 A2,
DE 196 18 720 A1, EP 0 495 751 A1 oder EP 0 615 980 A2 beschrieben sind, beispielsweise 2,4,6-Trimethylbenzoyldiphenylphosphinoxid, Ethyl-2,4,6-trimethylbenzoylphenylphosphinat oder Bis(2,6-dimethoxybenzoyl)-2,4,4-trimethylpentylphosphinoxid.

Benzophenone sind beispielsweise Benzophenon, 4-Aminobenzophenon, 4,4'-Bis(dimethylamino)benzophenon, 4-Phenylbenzophenon, 4-Chlorbenzophenon, Michlers Keton, o-Methoxybenzophenon, 2,4,6-Trimethylbenzophenon, 4-Methylbenzophenon, 2,4-Dimethylbenzophenon, 4-Isopropylbenzophenon, 2-Chlorbenzophenon, 2,2'-Dichlorbenzophenon, 4-Methoxybenzophenon, 4-Propoxybenzophenon oder 4-Butoxybenzophenon, α-Hydroxy-alkyl-aryl-ketone sind beispielsweise 1-Benzoylcyclohexan-1-ol (1-Hydroxy-cyclohexyl-phenylketon), 2-Hydroxy-2,2-dimethylacetophenon, (2-Hydroxy-2-methyl-1-phenyl-propan-1-on), 1-Hydroxyacetophenon, 1-[4-(2-Hydroxyethoxy)-phenyl]-2-hydroxy-2-methyl-1-propan-1-on oder Polymeres, das 2-Hydroxy-2-methyl-1-(4-isopropen-2-yl-phenyl)-propan-1-on einpolymerisiert enthält.

Xanthone und Thioxanthone sind beispielsweise 10-Thioxanthenon, Thioxanthen-9-on, Xanthen-9-on, 2,4-Dimethylthioxanthon, 2,4-Diethylthioxanthon, 2,4-Di-isopropylthioxanthon, 2,4-Dichlorthioxanthon oder Chloroxanthenon,

Anthrachinone sind beispielsweise β-Methylanthrachinon, tert-Butylanthrachinon, Anthrachinoncarbonsäureester, Benz[de]-anthracen-7-on, Benz[a]anthracen-7,12-dion, 2-Methylanthraxchinon, 2-Ethylanthrachinon, 2-tert-Butylanthrachinon, 1-Chloranthrachinon oder 2-Amylanthrachinon.

Acetophenone sind beispielsweise Acetophenon, Acetonaphthochinon, Valerophenon, Hexanophenon, α-Phenylbutyrophenon, p-Morpholinopropiophenon, Dibenzosuberon, 4-Morpholinobenzophenon, p-Diacetylbenzol, 4'-Methoxyacetophenon, α-Tetralon, 9-Acetylphenanthren, 2-Acetylphenanthren, 3-Acetylphenanthren, 3-Acetylindol, 9-Fluorenon, 1-Indanon, 1,3,4-Triacetylbenzol, 1-Acetonaphthon, 2-Acetonaphthon, 2,2-Dimethoxy-2-phenylaceto-phenon, 2,2-Diethoxy-2-phenylacetophenon, 1,1-Dichloraceto-phenon, 1-Hydroxyacetophenon, 2,2-Diethoxyacetophenon, 2-Methyl-1-[4-(methylthio)phenyl]-2-morpholinopropan-1-on, 2,2-Dimethoxy-1,2-diphenylethan-2-on oder 2-Benzyl-2-dimethylamino-1-(4-morpholinophenyl)-butan-1-on.

Benzoine und Benzoinether sind beispielsweise 4-Morpholinodeoxybenzoin, Benzoin, Benzoin-isobutylether, Benzoin-tetrahydropyranylether, Benzoin-methylether, Benzoin-ethylether, Benzoin-butylether, Benzoin-isopropylether oder 7-H-Benzoin-methylether.

Ketale sind beispielsweise Acetophenondimethylketal, 2,2-Diethoxyacetophenon, oder Benzilketale, wie Benzildimethylketal.

Phenylglyoxylsäuren sind beispielsweise in DE 198 26 712 A1, DE 199 13 353 A1 oder WO 98/33761 A1 beschrieben.

Weiterhin verwendbare Photoinitiatoren sind beispielsweise Benzaldehyd, Methylethylketon, 1-Naphthaldehyd, Triphenylphosphin, Tri-o-Tolylphosphin oder 2,3-Butandion.

Typische Gemische umfassen beispielsweise 2-Hydroxy-2-methyl-1-phenyl-propan-2-on und 1-Hydroxy-cyclohexyl-phenylketon, Bis(2,6-dimethoxybenzoyl)-2,4,4-trimethylpentylphosphinoxid und 2-Hydroxy-2-methyl-1-phenyl-propan-1-on, Benzophenon und 1-Hydroxy-cyclohexyl-phenylketon, Bis(2,6-dimethoxybenzoyl)-2,4,4-trimethylpentylphosphinoxid und 1-Hydroxy-cyclohexyl-phenylketon, 2,4,6-Trimethylbenzoyldiphenylphosphinoxid und 2-Hydroxy-2-methyl-1-phenyl-propan-1-on, 2,4,6-Trimethylbenzophenon und 4-Methylbenzophenon oder 2,4,6-Trimethylbenzophenon und 4-Methylbenzophenon und 2,4,6-Trimethylbenzoyldiphenylphosphinoxid.

Bevorzugt unter diesen Photoinitiatoren sind 2,4,6-Trimethylbenzoyldiphenylphosphinoxid, Ethyl-2,4,6-trimethylbenzoyl-phenylphosphinat, Bis-(2,4,6-trimethylbenzoyl)-phenylphosphin-oxid, Benzophenon, 1-Benzoylcyclohexan-1-ol, 2-Hydroxy-2,2-dimethylacetophenon und 2,2-Dimethoxy-2-phenylacetophenon.

Weiterhin kann mindestens ein Stabilisator enthalten sein.

Geeignete Stabilisatoren umfassen typische UV-Absorber wie Oxanilide, Triazine und Benzotriazol (letztere erhältlich als Tinuvin® -Marken der Ciba-Spezialitätenchemie) und Benzophenone. Diese können allein oder zusammen mit geeigneten Radikalfängern, beispielsweise sterisch gehinderten Aminen wie 2,2,6,6-Tetramethylpiperidin, 2,6-Di-tert.-butylpiperidin oder deren Derivaten, z. B. Bis-(2,2,6,6-tetra-methyl-4-piperidyl)-sebacinat, eingesetzt werden. Stabilisatoren werden üblicherweise in Mengen von 0,1 bis 5,0 Gew.-%, bezogen auf die in der Zubereitung enthaltenen festen Komponenten, eingesetzt.

Ferner können die im erfindungsgemäßen Verfahren einsetzbaren Beschichtungsmassen zusätzlich 0 bis 10 Gew.-% weitere Additive enthalten.

Als weitere lacktypische Additive können Aktivatoren, Füllmittel, Pigmente, Farbstoffe, Verdicker, thixotrope Agentien, oberflächenaktive Agentien, Viskositätsmodifikatoren, Plastifizierer oder Chelatbildner verwendet werden.

Weiterhin können ein oder mehrere thermisch aktivierbare Initiatoren zugesetzt werden, z.B. Kaliumperoxodisulfat, Dibenzoylperoxid, Cyclohexanonperoxid, Di-tert.-Butylperoxid, Azobis-*iso*-butyronitril, Cyclohexylsulfonylacetylperoxid, Diiso-propylpercarbonat, *tert*-Butylperoktoat oder Benzpinakol, sowie beispielsweise solche thermisch aktivierbare Initiatoren, die eine Halbwertszeit bei 80 °C von mehr als 100 Stunden aufweisen, wie Di-tert.-Butylperoxid, Cumolhydroperoxid, Dicumylperoxid, tert.-Butylperbenzoat, silylierte Pinakole, die z. B. unter dem Handelsnamen ADDID 600 der Firma Wacker kommerziell erhältlich sind oder hydroxylgruppenhaltige Amin-N-Oxide, wie 2,2,6,6-Tetramethylpiperidin-N-oxyl, 4-Hydroxy-2,2,6,6-Tetramethylpiperidin-N-oxyl, etc..

Weitere Beispiele geeigneter Initiatoren sind in "Polymer Handbook", 2. Aufl., Wiley & Sons, New York beschrieben.

Als Verdicker kommen neben radikalisch (co)polymerisierten (Co)Polymerisaten, übliche organische und anorganische Verdicker wie Hydroxymethylcellulose oder Bentonit in Betracht.

Als Chelatbildner können z.B. Ethylendiaminessigsäure und deren Salze sowie β-Diketone verwendet werden.

Geeignete Füllstoffe umfassen Silikate, z. B. durch Hydrolyse von Siliciumtetrachlorid erhältliche Silikate wie Aerosil® der Fa. Degussa, Kieselerde, Talkum, Aluminiumsilikate, Magnesiumsilikate, Calciumcarbonate etc.

Wenn derartige Füllstoffe oder sonstige Feststoffpartikel den Beschichtungsmassen zugefügt werden, so ist darauf zu achten, daß diese Teilchengrößen aufweisen, die unterhalb der auszubildenden Mikrostukturen liegen, bevorzugt so deutlich unterhalb, daß diese Partikel die Ausbildung der Mikrostukturen nicht beeinflussen.

Des weiteren können die Beschichtungsmassen ein Lösungsmittel enthalten, beispielsweise Butylacetat, Essigester, Methoxypropylacetat, Toluol, Xylol, fluorierte Aromaten, aliphatische und aromatische Kohlenwasserstoffgemische.

Bevorzugt werden die Beschichtungsmassen jedoch frei von Lösungsmittel aufgetragen.

Die Beschichtung der Substrate mit den Beschichtungsmassen erfolgt nach üblichen, dem Fachmann bekannten Verfahren, wobei man eine Beschichtungsmasse auf das zu beschichtende Substrat in der gewünschten Stärke aufbringt und gegebenenfalls trocknet. Dieser Vorgang kann gewünschten falls ein- oder mehrfach wiederholt werden. Das Aufbringen auf das Substrat kann in bekannter Weise, z. B. durch Spritzen, Spachteln, Rakeln, Bürsten, Rollen, Walzen, Gießen, Laminieren, Hinterspritzen oder Coextrudieren erfolgen. Die Beschichtungsstärke liegt in der Regel in einem Bereich von etwa 3 bis 1000 g/m² und vorzugsweise 10 bis 200 g/m².

Denkbar ist es, die Beschichtungsmasse auf Glas, beispielsweise Quarzglas aufzutragen.

Die Substratschicht besteht vorzugsweise aus einem thermoplastischen Polymer, insbesondere Polymethylmethacrylate, Polybutylmethacrylate, Polyethylenterephthalate, Polybutylenterephthalate, Polyvinylidenflouride, Polyvinylchloride, Polyester, Polyolefine, Acrylnitrilethylenpropylendienstyrolcopolymere (A-EPDM), Polyetherimide, Polyetherketone, Polyphenylensulfide, Polyphenylenether oder deren Mischungen.

Weiterhin genannt seien Polyethylen, Polypropylen, Polystyrol, Polybutadien, Polyester, Polyamide, Polyether, Polycarbonat, Polyvinylacetal, Polyacrylnitril, Polyacetal, Polyvinylalkohol, Polyvinylacetat, Phenolharze, Harnstoffharze, Melaminharze, Alkydharze, Epoxidharze oder Polyurethane, deren Block- oder Pfropfcopolymere und Blends davon.

Bevorzugt genannt seien ABS, AES, AMMA, ASA, EP, EPS, EVA, EVAL, HDPE, LDPE, MABS, MBS, MF, PA, PA6, PA66, PAN, PB, PBT, PBTP, PC, PE, PEC, PEEK, PEI, PEK, PEP, PES, PET, PETP, PF, PI, PIB, PMMA, POM, PP, PPS, PS, PSU, PUR, PVAC, PVAL, PVC, PVDC, PVP, SAN, SB, SMS, UF, UP-Kunststoffe (Kurzzeichen gemäß DIN 7728) und aliphatische Polyketone.

Besonders bevorzugte Substrate sind Polyolefine, wie z.B. PP(Polypropylen), das wahlweise isotaktisch, syndiotaktisch oder ataktisch und wahlweise nicht-orientiert oder durch uni- oder bisaxiales Recken orientiert sein kann, SAN (Styrol-Acrylnitril-Copolymere), PC (Polycarbonate), PMMA (Polymethylmethacrylate), PBT (Poly(butylenterephthalat)e), PA (Polyamide), ASA (Acrylnitril-Styrol-Acrylester-Copolymere) und ABS (Acrylnitril-Butadien-Styrol-Copolymere), sowie deren physikalische Mischungen (Blends). Besonders bevorzugt sind PP, SAN, ABS, ASA sowie Blends von ABS oder ASA mit PA oder PBT oder PC.

Ganz besonders bevorzugt ist PET, PP, PE und Polymethylmethacrylat (PMMA) oder schlagzähmodifiziertes PMMA.

Die Dicke des Substrates beträgt vorzugsweise 50 µm bis zu 5 mm. Besonders bevorzugt ist eine Schichtdicke von 100 bis 1000 µm, insbesondere 100 bis 500 µm.

Im nächsten Schritt wird eine Feinstruktur durch eine Matrize geformt, welche das Negativbild einer Feinstruktur aufweist. Es versteht sich von selbst, daß die Matrize dem erfindungsgemäß zu erzielenden Aspektverhältnis zumindest entsprechen muß, d.h. kein kleineres als das geforderte Aspektverhältnis aufweisen darf. Dabei kann die Matrize gegen die auf das Substrat aufgetragene Beschichtungsmasse gedrückt werden. Dies kann schrittweise, beispielsweise durch Stempeln oder Prägen, aber auch kontinuierlich, beispielsweise durch Rollen und Walzen, geschehen. Gegebenenfalls kann dieser Vorgang durch Anlegen eines Unterdrucks oder eines Überdruckes bzw. einer Andruckrolle auf der Rückseite des Substrats unterstützt werden, damit auch feine Strukturen der Matrize abgebildet werden.

In einer weiteren Ausführungsform enthält das Substrat die Matrize, welche das Negativ einer Mikrostruktur aufweist. In diesem Fall handelt es sich bei dem Substrat bevorzugt um eine Struktur aus Elastomeren, wie Polydimethylsiloxan, oder gehärteten Photolacken. Durch das Auftragen der Beschichtungsmasse auf die Matrize füllt die Beschichtungsmasse die Matrize der Mikrostruktur aus. Dies kann beispielsweise durch Unterdruck unterstützt werden.

Nach dem Auftragen auf die Matrize kann auf die Beschichtungsmasse ein weiteres Substrat aufgebracht werden. Die strukturierte Beschichtungsmasse wird dann zusammen mit diesem Substrat von der Matrize abgetrennt. Dieses Substrat entspricht dem vorstehend beschriebenen Substrat für die erste Ausführungsform. Auf diese Weise wird auf diesem Substrat eine feinstrukturierte Oberfläche erhalten.

Nach dem Auftragen der Beschichtungsmasse wird diese gegebenenfalls getrocknet und mit Elektronenstrahlen oder Belichtung unter sauerstoffhaltiger Atmosphäre oder bevorzugt unter Inertgas gehärtet, gegebenenfalls bei Temperaturen bis zur Höhe der Trocknungstemperatur.

Die Trocknung und/oder Härtung kann vor und/oder nach dem Abtrennen der feinstrukturierten Oberfläche von der Matrize durchgeführt werden.

In einer weiteren Ausführungsform wird die Trocknung und/oder Härtung vor dem Abtrennen durchgeführt. Es können sich aber auch noch weitere Trocknungs- bzw. Härtungsschritte nach dem Abtrennen von der Matrize anschließen.

Dies ist begrenzt durch die Thermostabilität des Substrats.

Die Strahlungshärtung erfolgt mit energiereichem Licht, z.B. (N)IR-, VIS-, UV-Licht oder Elektronenstrahlen. Die Strahlungshärtung kann bei höheren Temperaturen erfolgen.

Weiterhin wird ein Verfahren zum Beschichten von Substraten offenbart, bei dem man die erfindungsgemäße Beschichtungsmasse oder solche enthaltende Formulierungen, gegebenenfalls mit thermisch härtbaren Harzen versetzt, auf das Substrat aufbringt, trocknet, und nach Formung der Feinstruktur anschließend mit Elektronenstrahlen oder UV Belichtung unter sauerstoffhaltiger Atmosphäre oder bevorzugt unter Inertgas härtet, gegebenenfalls bei Temperaturen bis zur Höhe der Trocknungstemperatur.

Als Strahlungsquellen für die Strahlungshärtung geeignet sind z.B. Quecksilber-Niederdruckstrahler, -Mitteldruckstrahler, Hochdruckstrahler sowie Leuchtstoffröhren, Impulsstrahler, Metallhalogenidstrahler, LED, Elektronenblitzeinrichtungen, wodurch eine Strahlungshärtung ohne Photoinitiator möglich ist, oder Excimerstrahler. Die Strahlungshärtung erfolgt durch Einwirkung energiereicher Strahlung, also UV-Strahlung oder Tageslicht, vorzugsweise Licht im Wellenlängenbereich von λ=200 bis 700 nm, besonders bevorzugt von λ=200 bis 500 nm und ganz besonders bevorzugt λ=250 bis 400 nm, oder durch Bestrahlung mit energiereichen Elektronen (Elektronenstrahlung; 150 bis 300 keV). Als Strahlungsquellen dienen beispielsweise Hochdruckquecksilberdampflampen, Laser, gepulste Lampen (Blitzlicht), Halogenlampen oder Excimerstrahler. Die üblicherweise zur Vernetzung ausreichende Strahlungsdosis bei UV-Härtung liegt im Bereich von 80 bis 3000 mJ/cm².

Selbstverständlich sind auch mehrere Strahlungsquellen für die Härtung einsetzbar, z.B. zwei bis vier.

Diese können auch in jeweils unterschiedlichen Wellenlängenbereichen strahlen.

Die Bestrahlung kann gegebenenfalls auch unter Ausschluss von Sauerstoff, z. B. unter Inertgas-Atmosphäre, durchgeführt werden. Als Inertgase eignen sich vorzugsweise Stickstoff, Edelgase, Kohlendioxid, oder Verbrennungsgase. Des Weiteren kann die Bestrahlung erfolgen, indem die Beschichtungsmasse mit transparenten Medien abgedeckt wird. Transparente Medien sind z. B. Kunststofffolien, Glas oder Flüssigkeiten, z. B. Wasser. Besonders bevorzugt ist eine Bestrahlung in der Weise, wie sie in der DE 199 57 900 A1 beschrieben ist.

In einer bevorzugten Ausführungsform erfolgt die Härtung in Schritt c) durch Bestrahlung durch das Substrat hindurch.

Dabei ist es erforderlich, dass die Durchlässigkeit des Substrats für die eingesetzte Strahlung abgestimmt ist auf den eingesetzten Photoinitiator.

So ist beispielsweise PET durchlässig für Strahlung mit einer Wellenlänge unterhalb 300 nm. Als Photoinitiatoren, die bei dieser Strahlung Radikale erzeugen, kommen beispielsweise 2,4,6-Trimethylbenzoyldiphenylphosphinoxid, Ethyl-2,4,6-trimethylbenzoylphenylphosphinat und Bis-(2,4,6-trimethylbenzoyl)-phenylphosphinoxid in Betracht.

Falls das Substrat die Matrize enthält und ein weiteres Substrat aufgebracht wird, kann die Bestrahlung auch durch dieses zweite Substrat hindurch durchgeführt werden.

Die beschriebenen Polymere zeichnen sich durch eine besonders hohe Strukturtreue aus. Nur wenn diese gegeben ist, ist es möglich die Matrize genau abzuformen.

Strukturtreue bedeutet, dass die erhaltene Strukturierung der Oberfläche durch das Polymer in hoher Auflösung wiedergegeben wird. Dies betrifft insbesondere die Schärfe der Kanten und eventuelle Strukturierung von Flächen. Es kann allerdings zu einer leichten Streckung der Struktur senkrecht zur Oberfläche des Substrats kommen. So kann die Struktur durch das Abziehen der Matrize etwas in diese Richtung gestreckt werden (beispielsweise um 20 bis 50 %). Dabei weisen die Strukturen ein Seitenverhältnis von Breite zu Höhe von 1:10 bis 10:1 bevorzugt zwischen 3:1 und 1:3 auf.

Ebenfalls bevorzugte Seitenverhältnisse (Aspektverhältnisse) wurden bereits für das Verfahren zur Herstellung von feinstrukturierten beschichteten Oberflächen beschrieben. Diese liegen mindestens bei 0,5, bevorzugt mindestens 0,7, besonders bevorzugt mindestens 0,9, ganz besonders bevorzugt mindestens 1, insbesondere mindestens 1,3 und speziell mindestens 1,5.

Die obere Grenze für das Aspektverhältnis liegt davon unabhängig bevorzugt bei 100, 50, 20, 15, 10 oder 5.

Im letzten Schritt d) wird die gehärtete Beschichtung von der Matrize abgetrennt. Falls das Substrat die Matrize enthielt kann es von Vorteil sein, dass vor dem Abtrennen auf die gehärtete Beschichtung ein Substrat aufgebracht wird, gegebenenfalls unter Verwendung einer Haftvermittlerschicht.

Die Matrize kann aus unterschiedlichen Materialien bestehen. Dies können weiche Materialien sein, wie beispielsweise Polydimethylsiloxan (PDMS). Es können aber auch harte Materialien sein, wie beispielsweise Metalle, bevorzugt Nickel.

In einer weiteren Ausführungsform ist die Matrize eine Matrize einer hierarchischen Feinstruktur, bevorzugt einer hierarchischen Mikrostruktur. Dies sind Strukturen, welche Elemente mit verschiedenen Größenordnungen enthalten, z.B. eine Strukturierung in der Größenordnung von mehreren Mikrometern, beispielsweise 2 bis 20 µm, welche von einer Strukturierung im Bereich von unter einem Mikrometer, beispielsweise 200 nm bis 1 µm, überlagert wird (Hierarchie). Meistens ist die kleinere Struktur in der größeren Struktur enthalten. So weist die Beschichtung beispielsweise Vertiefungen oder Erhöhungen in der Größenordnung von mehreren Mikrometern auf, z.B. als Zylinder, oder Kegelstumpf, der gegebenenfalls eine konkave Mantelfläche aufweisen kann, welche auf ihren Stirnflächen wiederum Vertiefungen oder Erhöhungen aufweisen, welche naturgemäß deutlich kleiner sind. Charakterisiert werden solche Strukturen meistens über den Unterschied der Größenordnung in Bezug auf mindestens eine ihrer Dimensionen, bevorzugt in mindestens einer Richtung parallel zur Oberfläche des Substrats. In der Regel lässt sich die Größenordnung einer periodischen Strukturierung durch Periode dieser Struktur, d.h. der kürzeste Abstand bis sich die Struktur wiederholt, festlegen. Die Größenordnung der Struktur ergibt sich aus der kürzesten Periode. Bevorzugte hierarchische Strukturen weisen einen Unterschied der Größenordnungen der einzelnen Hierarchiestufen um einen Faktor von 2 bis 1000 auf, bevorzugt von 2 bis 100, besonders bevorzugt zwischen 2 und 20.

Des Weiteren kann das Verfahren die Herstellung einer Matrize zur Herstellung von Feinstrukturen auf Oberflächen umfassen. Mit Vorteil handelt es sich bei den Feinstrukturen um Mikrostrukturen.

Zuerst wird ein Photolack auf mindestens ein Matrizensubstrat aufgetragen. Verwendbare Matrizensubstrate sind vorzugsweise Edelmetalle, oxidische Gläser, mono- oder multikristalline Matrizensubstrate, Halbleiter, Metalle mit oder ohne passivierter Oberfläche, Kunststoffe oder allgemein Substrate mit hoher Resistenz gegen die nachfolgenden Prozeduren. Insbesondere handelt es sich hierbei um Pt, Au, GaAs, In_{Y}GaAs, Al_{X}GaAs, Si, Glas, Graphit, Diamant, Glimmer, SrTiO₃ sowie deren dotierte Modifikationen. Die verwendbaren Matrizensubstrate können sowohl planare, ebene Matrizensubstrate als auch solche mit planaren, gekrümmten (konvex oder konkav) Oberflächen sein.

Ein glattes Matrizensubstrat kann z.B. durch Spin-Coating mit einem Photolack beschichtet werden. Die Dicke des Films kann dabei zwischen 10 nm und 1000 µm betragen. Bevorzugt sind Dicken von 1 µm bis 500 µm, besonders bevorzugt zwischen 5 µm und 50 µm. Die Dicke der Schicht bestimmt dabei die maximale Höhe der späteren Struktur der Matrize. Bei besonders feinen Strukturen kann die Dicke der Schicht auch zwischen 10 nm und 1 µm betragen.

Zusätzlich kann auf das Matrizensubstrat ein haftvermittelndes oder antireflektives Material aufgetragen werden, z. B. Wide 15 B (Brewer Science).

Ein Photolack ist ein Material, welches seine Löslichkeit in einem Lösungsmittel in Abhängigkeit der eingestrahlten Dosis an Strahlung ändert (Photolack / Photoresist). Als Photolacke können die im Stand der Technik bekannten, im Handel erhältlichen Photolacke eingesetzt werden. Dabei kann sich die Löslichkeit der belichteten Bereiche erhöhen (positive Photolacke) oder erniedrigen (negativer Photolack). Dabei kann dies auch die Löslichkeit des Photolacks nach Trocknungs- und/oder Backschritten betreffen.

Dies kann beispielsweise ein auf DNQ (Diazonaphtochinon) basierender Photolack (z.B. AZ9260 von AZ Electronic Material) sein. Es kann aber auch ein auf Epoxiden basierender Photolack wie SU-8 (Microchem. Corp.) sein.

Gegebenenfalls kann noch ein Trocknungsschritt zur Erhöhung der Viskosität des aufgetragenen Photolacks durchgeführt werden. Dies kann durch einfaches Lagern bei Raumtemperatur, beispielsweise bei Luftfeuchten über 40 % relative Luftfeuchte, oder durch Backprozesse, vorzugsweise auf einer Heizplatte erfolgen.

In dem nächsten Schritt wird der Photolack mit sichtbarem Licht, UV-Strahlung, Röntgenstrahlung oder Elektronenstrahlung selektiv belichtet.

Die Belichtung kann auf herkömmliche Weise durch Masken oder bevorzugt durch Interferenz erfolgen (Interferenzlithographie). Dabei wird durch Interferenz von mehreren kohärenten Strahlungsquellen die gewünschte Intensitätserteilung in der zu belichteten Zusammensetzung erzeugt. Dies kann durch die Interferenz von mindestens zwei vorzugsweise zwei bis vier elektromagnetischen Wellen geschehen, deren Wellenlänge im Sensitivitätsbereich des verwendeten Materials liegt. Die Belichtung kann auch mehrfach durchgeführt werden. Entscheidend ist, dass nach der Belichtung die gewünschte flächige Dosisverteilung erreicht wurde. So kann die Belichtung auch mehrfach bei unterschiedlicher Substratposition und/oder Ausrichtung erfolgen. Durch Interferenz von mehreren Lichtquellen können insbesondere regelmäßige Muster erzeugt werden. So ist es beispielsweise möglich durch Interferenz von drei Lichtquellen ein hexagonales Intensitätsmuster zu erzeugen.

Durch Interferenzlithographie ist es möglich Flächen von über 1 m² in einem Schritt zu belichten.

In einer weiteren Ausführungsform wird in den Photolack die Struktur durch Aufdrücken einer Vorlage, z.B. eines Stempels, geprägt (Mikroreplikation). Die Vorlage kann ihrerseits durch Abguss einer mit dem Verfahren der Anmeldung hergestellten Matrize erhalten worden sein.

Gegebenenfalls kann auf die Schicht eine weitere Schicht eines Photolacks aufgetragen werden, welche wiederum durch selektives Belichten oder Prägen erneut mit einer Struktur versehen wird.

Das Verfahren eignet sich besonders zur Herstellung von hierarchischen Strukturen. Dazu wird bei jeder Wiederholung eine Struktur einer anderen Größenordnung erzeugt.

Mit Vorteil wird bei jeder Wiederholung eine Struktur mit zunehmender Größenordnung erzeugt. Dies führt dazu, dass Matrizen für Strukturen erhalten werden, welche aufeinander aufgesetzte Strukturen von abnehmender Größenordnung beinhalten, d.h. beispielsweise zylinderförmige Sockel auf deren Stirnflächen wiederum zylinderförmige Vorsprünge mit einer deutlich kleineren Größenordnung angeordnet sind.

Die erhaltenen Schichten werden anschließend entwickelt, d.h. es wird entweder der belichtete Teil aus dem Film herausgelöst (positiver Photolack) oder der unbelichtete Photolack wird aus dem Film herausgelöst (negativer Photolack). Die eingeschriebenen Muster und Strukturen stellen Vertiefungen in dem Photolack dar. Hierbei können die Strukturen periodisch oder aperiodisch sein. Die Strukturen können laterale Strukturdimensionen im Bereich zwischen 30 nm und 50 µm und eine Strukturhöhe von bis zu 100 µm, beispielsweise zwischen 50 nm und 100 µm, aufweisen.

Die Entwicklung erfolgt in Abhängigkeit von dem verwendeten Photolack, wie z. B. Kalilauge. Dabei kann die Stärke des Entwickelns. auch die Profilform und/oder Tiefe der fertigen Struktur durch die Konzentration der Entwicklerlösung und die Entwicklungszeit eingestellt werden.

Durch genaues Einstellen der Trocknungsschritte vor dem Belichten und der Entwicklungsparameter kann bei DNQ/Novolac Resisten erreicht werden dass sich auf der Struktur ein verbreitertes Plateau ausbildet. Dieses im Kontext von Photoresist genannte T-Topping wirkt sich besonders vorteilhaft auf die Adhäsionseigenschaften aus.

Mit Vorteil werden alle aufgetragenen Schichten gemeinsam entwickelt, bevorzugt werden alle durch Belichtung strukturierten Schichten gleichzeitig entwickelt. Damit werden mit einem Entwicklungsschritt die hierarchisch strukturierten Vertiefungen erhalten.

Es können auch noch weitere Schritte, wie zusätzliche Trocknungsschritte und Beschichtungsschritte enthalten sein.

Das Verfahren eignet sich insbesondere um hierarchische Strukturen mit einer Sockelstruktur herzustellen. Dazu wird in den ersten Schritten durch Interferenzlithographie und/oder Mikroreplikation das Negativ einer Fein- oder Mikrostruktur hergestellt. In der durch Abformung der Matrize hergestellten strukturierten Oberfläche bildet dieser Bereich die Kontaktstruktur der strukturierten Oberfläche, d.h. der Bereich der strukturierten Oberfläche, welcher die Adhäsion durch Kontaktierung beeinflusst.

Das Verfahren ermöglicht nun in einem letzten Schritt auf einfache Weise die Kontaktstruktur auf eine Sockelstruktur aufzusetzen. Dadurch kann die Adhäsionsfähigkeit der Oberfläche verbessert werden.

Zur Erzeugung einer Sockelstruktur kann es zunächst nötig sein, die Schichten der Matrize für die Kontaktstruktur zu trocknen oder zu härten.

Danach wird eine weitere Schicht Photolack aufgebracht, in welche die Sockelstruktur belichtet werden soll. Die Dicke der aufgebrachten Schicht bestimmt dabei die spätere Höhe der Sockel. Mit Vorteil ist sie mehr als 2mal so dick wie die Schichten der Kontaktstruktur, mit Vorteil mehr als 5mal so dick (gemessen beim Auftragen des Photolacks).

Im nächsten Schritt wird der Photolack mittels Interferenzlithographie belichtet. Mit Vorteil wird dabei ein hexagonales Intensitätsmuster verwendet.

Dabei wird die Größenordnung der Sockelstruktur so gewählt, dass sie mindestens 1.5mal, bevorzugt mehr als 2mal größer ist, als die größte Größenordnung der Kontaktstruktur. Dies bedeutet beispielsweise im Falle von zylindrischen Strukturen als Kontaktstruktur und Sockelstruktur, dass der Durchmesser der Sockelstruktur mindestens 5mal größer ist, als der größte Durchmesser einer Struktur der Kontaktstruktur.

Nach dem Belichten werden die Schichten gehärtet und/oder temperaturbehandelt.

Mit Vorteil eignet sich das Verfahren zur Herstellung von Strukturen mit einem Seitenverhältnis (Höhe zu Durchmesser) zwischen 1:10 bis 10:1 bevorzugt zwischen 3:1 und 1:3, sowie denen für die feinstrukturierte Oberfläche beschriebenen Seitenverhältnissen. Diese Seitenverhältnisse gelten für die jeweilige Hierarchiestufe.

Im letzten Schritt werden alle Schichten gemeinsam entwickelt. Dabei bildet sich die Matrize. Die Matrize wird bevorzugt in dem bereits beschriebenen Verfahren zur Herstellung von strukturierten Oberflächen verwendet.

Die erhaltene Matrize kann auch in einem Elastomer, z.B. Silikon, Polydimethylsiloxan (PDMS), Sylgard® 184, elastisches Polyurethan, PolyOptic® 1470 von PolyConForm, oder Nickel abgeformt werden.

Bei dem vorstehend beschriebenen Prozess kann auch ausschließlich mit Interferenzbelichtungen gearbeitet werden.

Mit Vorteil wird ein negativer Photolack verwendet.

Das Verfahren kann auch mit einer Kombination von Interferenzlithographie und Mikroreplikation durchgeführt werden. So kann beispielsweise die Herstellung des Negativs der Kontaktstruktur durch Prägen erfolgen.

Dazu kann beispielsweise ein Matrizensubstrat mit einem Haftvermittler beschichtet werden. Danach wird das Matrizensubstrat mit einem positiven Photolack beschichtet (z.B. auf DNQ/Novolac Basis). Nach Trocknung wird diese Schicht belichtet und die erhaltene Struktur entwickelt. Die erhaltene Struktur wird mit einem Elastomer abgeformt. Um das korrekte Positiv der Struktur zu erhalten kann es erforderlich sein, das erhaltene Elastomer erneut mit einem weiteren Elastomer abzuformen.

Diese abgeformte Struktur kann als Stempel zur Formung der Matrize für das Negativ der Kontaktstruktur verwendet werden.

Danach werden wie bereits beschrieben auf die geprägte Struktur weitere Strukturen aufgebracht, bevorzugt wird die Sockelstruktur erzeugt.

Die Verwendung eines Prägeschrittes zur Herstellung der Kontaktstruktur hat den Vorteil, dass ein solcher aus einem Elastomer hergestellter Stempel für viele Prägungen verwendbar ist. Dadurch kann das Herstellungsverfahren der Matrizen deutlich beschleunigt werden.

Das beschriebene Verfahren hat den Vorteil, dass es nur wenige Schritte bedarf und die Schichten nacheinander einfach aufgetragen und strukturiert werden. Danach können alle Schichten gemeinsam entwickelt werden.

Das Verfahren ermöglicht auch eine sehr einfache Herstellung der Matrizen für hierarchische Strukturen. Dies wird insbesondere dadurch erreicht, dass es aufgrund der gemeinsamen Entwicklung am Ende des Verfahrens nicht zwingend notwendig ist, das Negativ der Kontaktstruktur auf die Sockelstruktur auszurichten.

Als negativer Photolack kann ein epoxidischer Photolack wie SU-8 verwendet werden.

Mit Vorteil werden die Matrizen vor der Verwendung inertisiert. Dies kann durch eine Beschichtung mit Substanzen geschehen, welche auf der Oberfläche inertisierende Gruppen aufbringen. Dies kann durch ionische oder polare Bindungen (beispielsweise Wasserstoffbrücken, Karbonsäuregruppen, Amine, Alkylamine, Amide, Imine, Imide, Ketone, Thiole, Cyanide, Ether), Dipol-Dipol-Wechselwirkungen (beispielsweise aromatische Gruppen) oder kovalente Bindungen (beispielsweise Ester, Ether, Si-O-Bindungen).

Die inertisierenden Gruppen sind Gruppen, welche eine geringe Wechselwirkung mit anderen Oberflächen aufweist. Dies sind beispielsweise unsubstituierte oder mehrheitlich substituierte Kohlenwasserstoffgruppen. Diese Gruppen können auch ungesättigte oder aromatische Kohlenwasserstoffgruppen enthalten.

Beispiele für unsubstituerte Gruppen sind beispielsweise verzweigte oder unverzweigte Kohlenwasserstoffe mit mehr als 5 Kohlenstoffatomen, bevorzugt zwischen 5 und 30 Kohlenstoffatomen. Es kann sich auch um aromatische Gruppen handeln, d.h. Gruppen, welche ein oder mehrere aromatische Systeme aufweisen. Mit Vorteil weisen intertisierende Gruppen Fluoratome auf, mit Vorteil sind mehr als 50 % der Positionen für Wasserstoffatome durch Fluoratome substituiert sind, bevorzugt mehr als 60 %, besonders bevorzugt mehr als 70 %. Bevorzugt handelt es sich um perfluorierte Gruppen, welche allerdings 0 bis 4 Kohlenstoffatome aufweisen könne, welche nicht fluoriert sind, z.B. 1H,1H,2H,2H-Perfluorogruppen. Die Verbindungen können perfluorierte Karbonsäuren sein. Bevorzugt sind Silane, welche entsprechende Gruppen aufweisen und zusätzlich noch mindestens eine hydrolysierbare Gruppe, welche eine kovalente Bindung mit der Matrize ausbilden kann. Beispiele für solche Silane sind CF₃CH₂CH₂SiCl₂ (CH₃), CF₃CH₂CH₂SiCl (CH₃)₂, CF₃CH₂CH₂Si(CH₃)(OCH₃)₂, CF₃CH₂CH₂SiX₃, C₂F₅CH₂CH₂SiX₃, C₄F₉CH₂CH₂SiX₃, n-C₆F₁₃CH₂CH₂SiX₃, n-C₈F₁₇CH₂CH₂SiX₃, n-C₉F₂₁CH₂CH₂SiX₃ (X = OCH₃, OC₂H₅ oder Cl) ; i-C₃F₁₀-CH₂CH₂CH₂-SiCl₂(CH₃), n-C₆F₁₃-CH₂CH₂-SiCl (OCH₂CH₃)₂, n-C₆F₁₃-CH₂CH₂-SiCl₂(CH₃) und n-C₆F₁₃-CH₂CH₂-SiCl(CH₃)₂. Besonders bevorzugt sind CF₃CH₂CH₂SiX₃, C₂F₅CH₂CH₂SiX₃, C₄F₉CH₂CH₂SiX₃, n-C₆F₁₃CH₂CH₂SiX₃, n-C₈F₁₇CH₂CH₂SiX₃, n-C₉F₂₁CH₂CH₂SiX₃ (X = OCH₃, OC₂H₅ oder Cl).

Die Erfindung betrifft außerdem eine strukturierte Oberfläche eines Festkörpers erhältlich mit dem erfindungsgemäßen Verfahren. Dies kann eine Oberfläche sein, die Vorsprünge in regelmäßiger Anordnung mit Abständen im Bereich von 5 µm bis 50 µm aufweist. Die Vorsprünge können beliebig geformt sein. So kann es sich um eine eindimensionale Anordnung handeln. Dies bedeutet, dass die Vorsprünge in eine Richtung entlang der Oberfläche eine deutlich verlängerte Ausdehnung aufweisen, als in den anderen Richtungen. Dies ist beispielsweise der Fall, wenn die Oberfläche mit Rillen strukturiert ist. Die Vorsprünge der Oberfläche weisen auf ihrer Oberfläche wiederum Vorsprünge in regelmäßiger Anordnung mit Abständen im Bereich von 0,1 µm bis 3 µm auf.

Mit Vorteil weisen die Vorsprünge in jede Richtung eine Begrenzung auf.

In einer weiteren Ausführungsform handelt es sich bei den Vorsprüngen um zylindrische Formen, Kegel, stumpfe Kegel, Kreisscheiben oder Kombinationen davon.

Solche Formen können beispielsweise auch Kegel sein, auf deren Spitze sich eine Kreisscheibe befindet, welche bevorzugt parallel zur Oberfläche ausgerichtet ist. Man erhält auf diese Weise eine pilzförmige Struktur. Mit Vorteil weist die Struktur bezogen auf die maximalen Ausdehnungen eines Vorsprungs ein Seitenverhältnis von Höhe zu Durchmesser zwischen 1:10 bis 10:1 bevorzugt zwischen 3:1 und 1:3 oder 2:1 und 2:1 auf. Solche Strukturen werden auch als T-Toppings bezeichnet.

Die Größenordnungen, d.h. Höhe und Breite, der Vorsprünge liegen dabei im Bereich von 1 µm bis 50 µm, besonders bevorzugt im Bereich von 2 bis 20 µm.

Festkörper mit solch einer strukturierten Oberfläche können in allen Bereichen verwendet werden, wo eine Adhäsion zwischen Oberflächen kontrolliert werden soll. Solche Oberflächen können als Haftflächen bei allen Bereichen der Technik vorgesehen sein, bei denen Verbindungen zwischen verschiedenen Objekten hergestellt werden sollen. Sie können Saug-, Klett- und Magnethalterungen ersetzen.

Diese Oberflächen sind einfach herzustellen und daher auch großflächig auf Oberflächen aufbringbar, beispielsweise auch durch Bekleben dieser Oberfläche mit einer entsprechend strukturierten Folie.

Bereiche zur Verwendung solcher strukturierten Festkörper sind zum Beispiel in der Transporttechnik, Bautechnik, Medizintechnik, Textiltechnik, Sportartikeltechnik, Haushaltsartikeltechnik.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente. Im Einzelnen zeigt:
- Fig. 1: REM-Aufnahme (Rasterelektronenmikroskop) einer hergestellten Struktur S1;
- Fig. 2: REM-Aufnahme eines Querschnitts der Struktur S2;
- Fig. 3: REM-Aufnahme eines Querschnitts der Struktur S3;
- Fig. 4a: REM-Aufnahme einer hierarchischen Struktur S4;
- Fig. 4b: REM-Aufnahme der Matrize für die Struktur S4;
- Fig. 5: Adhäsionsmessungen an Proben mit unterschiedlicher Strukturgeometrie;
- 5a: Schematische Darstellung der Messvorrichtung für die Adhäsion (a); typische Messung (b);
- Fig. 6: Vorlastabhängigkeit der Haftkraft für unterschiedliche Strukturen;
- Fig. 7: REM-Aufnahmen der hergestellten Struktur S5;
- Fig. 8: REM-Aufnahmen der hergestellten Struktur S5; Die Höhe des Vorsprungs beträgt 3.80 µm, der Durchmesser 3.83 µm;
- Fig. 9: REM-Aufnahmen von Strukturen hergestellt mit verschiedenen Polymermischungen zur Untersuchung der Abformgenauigkeit für Struktur S7;
- Fig. 10: REM-Aufnahmen von Strukturen hergestellt mit verschiedenen Polymermischungen zur Untersuchung der Abformgenauigkeit für Struktur S8;
- Fig. 11: REM-Aufnahmen von Strukturen hergestellt mit verschiedenen Polymermischungen zur Untersuchung der Abformgenauigkeit für Struktur S9;
- Fig. 12: Messung der Basisadhäsion unterschiedlicher Polymere/Polymermischungen;
- Fig. 13: Adhäsionsmessungen unterschiedlicher Polymermischungen mit unterschiedlichen Strukturen zur Ermittlung der Strukturtreue (Struktur S7: 1; Struktur S8: 2; Struktur S9: 3; Flaches Substrat: 4; Teflon: 5);
- Fig. 14: Schematische Darstellung der Herstellung einer Matrize durch mehrfache Interferenzlithographie;
- Fig. 15: Schematische Darstellung der Herstellung einer Matrize durch Kombination von Mikroreplikation und Interferenzlithographie;
- Fig. 16: Schematische Darstellung eines 2-StrahlInterferenzaufbaus;
- Fig. 17: Schematische Darstellung eines 3-StrahlInterferenzaufbaus;
- Fig. 18: Beispiel für eine Linsenanordnung für einen 3-StrahlInterferenzaufbau.

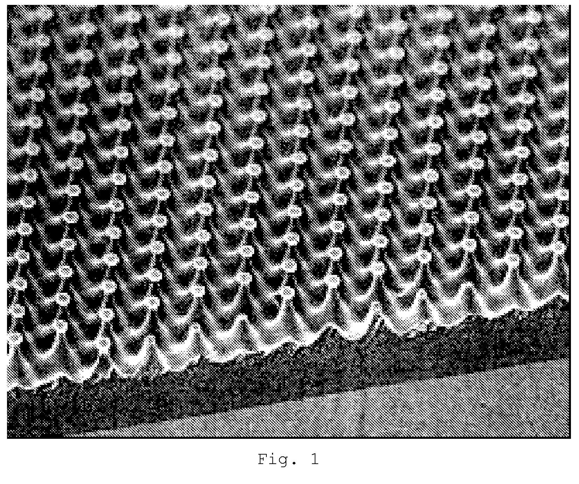

Figur 1 zeigt eine mit der Struktur S1 strukturierte Oberfläche, welche mit einer hexagonalen Anordnung von Vorsprüngen strukturiert ist. Die Vorsprünge weisen dabei einen abnehmenden Durchmesser ähnlich eines Kegels auf, wobei sich dieser Kegel im oberen Bereich nicht spitz zuläuft, sondern zu einer zur Oberfläche parallelen Stirnfläche verbreitert ähnlich einem Pilz (T-Topping). Allerdings ist der Durchmesser der Stirnfläche kleiner als die Basis des Kegels. Sie kann aber auch größer sein. Das Material der Struktur ist Polydimethylsiloxan Sylgard® 184 (Dow Corning). Die Strukturen haben eine Höhe von ca. 10 µm, einen Spitzendurchmesser von etwa 2,2 µm und ein Abstand von den Strukturmittelpunkten von etwa 7,5 µm. Daraus ergibt sich für diese Struktur eine aktive Kontaktfläche von etwa 8 % (Packungsdichte).

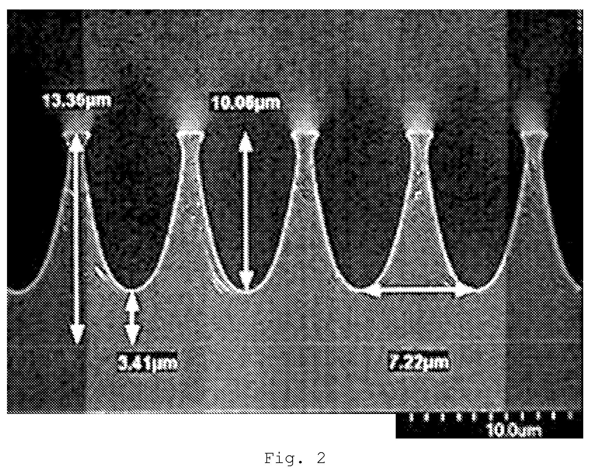

Figur 2 zeigt einen Querschnitt einer mit der Struktur S2 strukturierten Oberfläche. Dabei ähnelt der Querschnitt dem Querschnitt eines Vorsprungs der Struktur S1. Allerdings weist die Struktur keine kegelförmigen Vorsprünge auf, sondern die im Querschnitt gezeigten Strukturen erstrecken sich senkrecht zur Ebene der Figur 2 über die gesamte Oberfläche. Die Oberfläche weist eine Linienstruktur auf. Die Linienstrukturen weisen eine Höhe von etwa 10 µm, eine Spitzenbreite von 1,8 µm und einen Linienstrukturabstand von etwa 7.2 µm auf. Daraus resultiert eine Packungsdichte von etwa 25 %. Die Strukturen wurden aus Polydimethylsiloxan Sylgard® 184 (Dow Corning) hergestellt. Die Strukturen wurden aus Polydimethylsiloxan Sylgard 184® (Dow Corning) hergestellt.

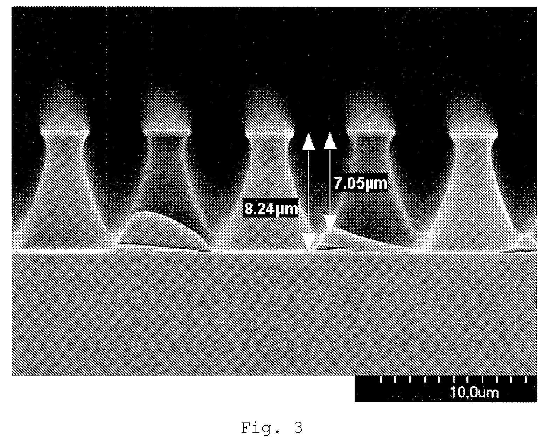

Figur 3 zeigt eine mit der Struktur S3 strukturierte Oberfläche. Es handelt sich wieder um eine pilzähnliche Struktur mit kegelförmigen Sockeln.

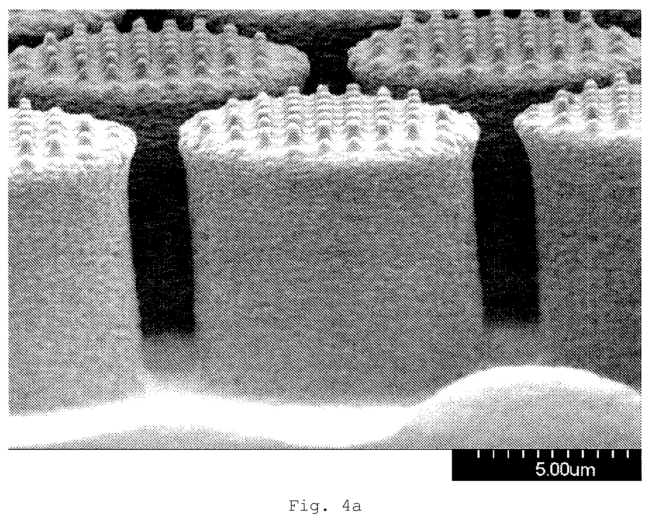

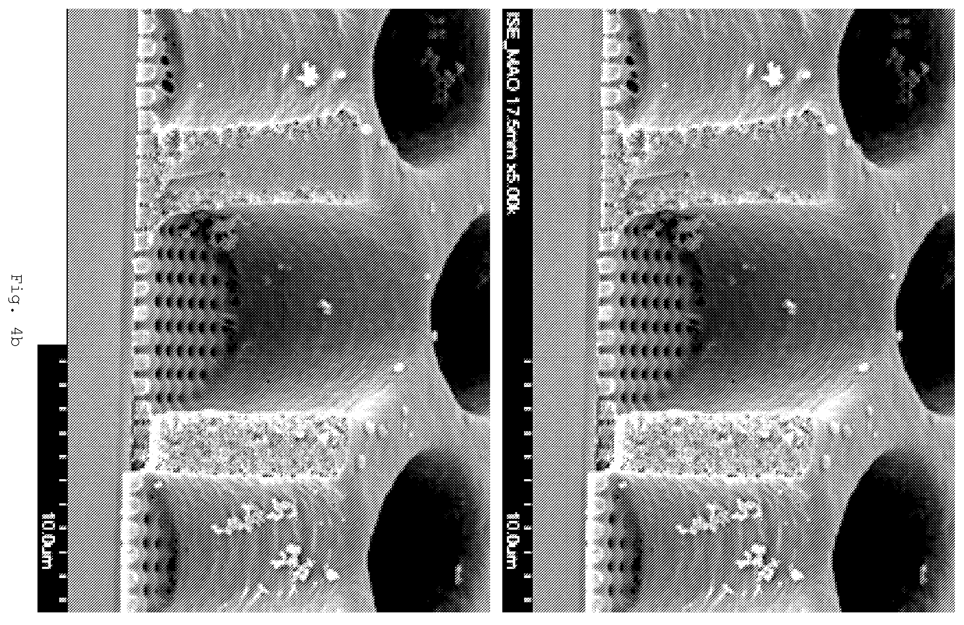

Figur 4a zeigt eine mit der Struktur S4 strukturierte Oberfläche. Diese zeichnet sich insbesondere durch die 10 µm im Durchmesser messenden im Wesentlichen zylindrischen Sockel aus, welche auf ihrer Stirnseite eine weitere Struktur aufweisen. Während die Sockel eine Größenordnung von ca. 12 µm aufweisen, liegt die Größenordnung der Struktur der Stirnseite bei ca. 1 µm. Die Struktur wurde aus PDMS (Elastosil® 604) hergestellt. Das Seitenverhältnis von Höhe zu Breite der Vorsprünge liegt ungefähr bei 1:1. Die Figur 4b zeigt die Matrize für die Struktur S4.

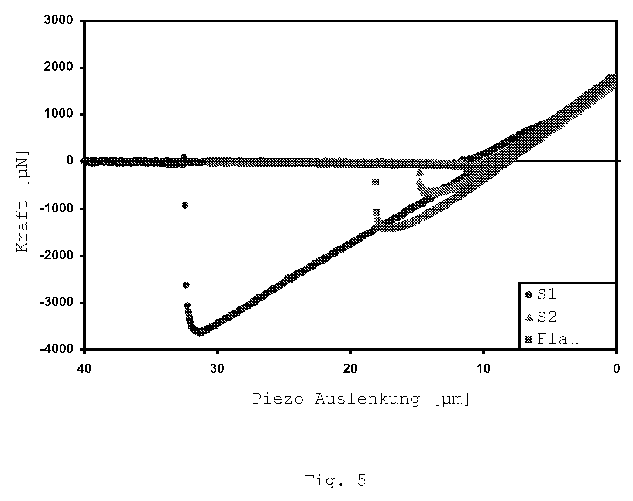

Figur 5 zeigt Adhäsionsmessung an Proben mit den Strukturen S1 und S2 (jeweils in PDMS) gegen die flache (unstrukturierte) Oberfläche. Es zeigt sich, dass die Linienstruktur im Vergleich zur unstrukturierten Oberfläche sogar eine reduzierte Adhäsion aufweist. Dagegen zeigt die Struktur S1 eine im Vergleich unstrukturierten Probe eine Steigerung der Adhäsion um den Faktor 3. Gerechnet auf die Kontaktfläche ergibt sich für die Adhäsion pro Fläche dieser Probe ein Wert von etwa 150 kPa.

Figur 5a zeigt die Vorrichtung zur Messung der Adhäsion (Figur 5a a)), sowie ein typisches Kraft/Auslenkungsdiagramm für eine Messung (Figur 5a b)). Eine solche Vorrichtung besitzt ein Laser-Interferometer (Miniatur-Interferometer SP120, SIOS GmbH, Germany; Genauigkeit +/- 50 nm) 50, welches die Auslenkung einer Glasfeder (Federkonstante 276.9 ± 1.4 N/m) mit Messsubstrat 52. Das Substrat wird dabei auf einem Piezoelement (Hexapod, PI Physik Instrumente, Deutschland) 54 platziert, welches auf einem 6-Achsentisch 56 montiert ist. Zur Messung wird das zu vermessende Substrat mit dem Messsubstrat und der Glasfeder kontaktiert und die Auslenkung der Glasfeder mit dem Interferometer gemessen. Aus der Auslenkung kann durch die Federkonstante die Kraft gemessen werden. Als Messsubstrat können unterschiedlich geformte Körper verwendet werden. Es können Spitzen oder Kugeln aus unterschiedlichen Materialien sein.

Figur 5a (b) zeigt ein typisches Messdiagramm. Im Verlauf der Messung wird das Substrat gegen das Messsubstrat gedrückt 60. Dabei kommt es zur Auslenkung der Glasfeder. Das Substrat kann bis zu einer bestimmten Vorlast 62 gegen das Messsubstrat gedrückt werden. Danach wird das Substrat wieder in die entgegengesetzte Richtung bewegt 64. Wenn eine Adhäsion zwischen Substrat und Messsubstrat vorliegt, bleibt das Messsubstrat noch an der Probe haften und es kommt zu einer entgegengesetzen Auslenkung der Feder bis zum Ablösen der Probe (pull-off force, 66).

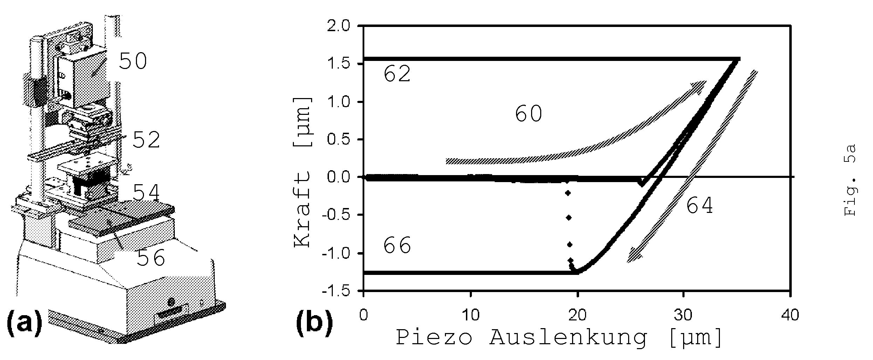

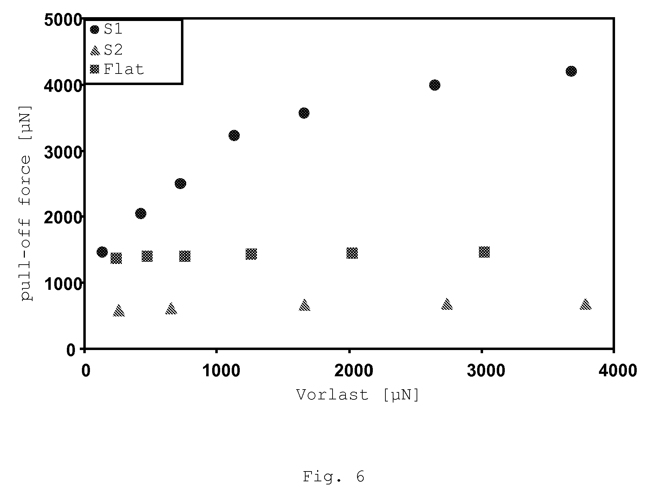

Figur 6 zeigt die Abhängigkeit der Adhäsion der Proben (bezeichnet als "pull-off force" oder auch Abziehkraft) aus Figur 5 von der Vorlast. Während die Linienstrukturen S2 und die unstrukturierte Kontrollprobe in erster Näherung keine Abhängigkeit von der Vorlast aufweisen, zeigt Struktur S1 eine deutliche Abhängigkeit. Für hohe Vorlasten ergibt sich eine deutliche Verbesserung der mit der Struktur S1 strukturierten Oberfläche gegenüber der unstrukturierten Oberfläche.

Aus den Messungen zeigt sich, dass die Strukturgeometrie von großer Bedeutung für die Adhäsion der Struktur ist. Um diese Strukturen auf einfache Weise herstellen zu können, müssen die Polymere in der Lage sein, solche Strukturen in hoher Schärfe abzuformen.

Als Polymere in den Beispielen wurden Gemische verschiedener Acrylate eingesetzt:

### Acrylsäure-2-phenoxyethylester (POEA)

### Dipropylenglykoldiacrylat (DPGDA)

Aminmodifiziertes Polyesteracrylat (PESA), erhältlich durch Umsetzung eines Polyesterols mit einem Molekulargewicht von etwa 600 g/mol, aufgebaut aus Dipropylenglykol und Adipinsäure (äquimolar), mit 1,2 Äquivalenten (Carbonsäuregruppen pro Hydroxygruppe) Acrylsäure, gefolgt von Umsetzung der unumgesetzten Acrylsäure mit 1 Äquivalent (Epoxygruppen pro Carbonsäuregruppe) Bisphenol-A-diglycidylether und Aktivierung der Acrylatgruppen mit 2 Gew% Ethylendiamin.

### Umsetzungsprodukt von 2 Äquivalenten Acrylsäure mit Butandioldiglycidether (BDGEA)

### Trimethylolpropan-formal monoacrylat (TMPFMA)

Umsetzungsprodukt eines Polyesterdiols aus Adipinsäure und Neopentylglykol mit Molekulargewicht ca. 500 g/mol mit 2 Äquivalenten Isophorondiisocyanat und 2 Äquivalenten Hydroxyethylacrylat (UA 1).

### Umsetzungsprodukt von Trimethylolpropan mit 3 Äquivalenten Ethylenoxid und 3 Äquivalenten Acrylsäure (ETMPTA)

Umsetzungsprodukt von Trimethylolpropan mit 3 Äquivalenten Ethylenoxid und 3 Äquivalenten Acrylsäure und Aktivierung der Acrylatgruppen mit 4 Gew% Diethanolamin (ETMPTA-A).

Umsetzung eine Caprolactondiols mit einem Molekulargewicht von ca. 400 g/mol mit Isophthalsäure zu einem Polyesterdiol mit einer OH Zahl von 36 mg KOH/g und Umsetzung des Polyesterdiols mit je 2 Äquivalenten Isophorondiisocyanat und Hydroxyethylacrylat (UA 2).

| Beispiel | POEA [Gew%] | DPGDA [Gew%] | PESA [Gew%] | Viskosität [mPas] | E-Modul [MPa] | Doppelbindungsdichte [mol/kg] |
|---|---|---|---|---|---|---|
| Mischung 1 | 50 | 12,5 | 37,5 | 79 | 9 | 6,0 |
| Mischung 2 | 70 | 8,5 | 21,5 | 30 | 4 | 5,1 |
| Mischung 3 | 10 | 22,5 | 67,5 | 593 | 17 | 4,8 |
| Mischung 4 | 90 | 2,5 | 7,5 | 13 | 1 | 5,2 |

| Beispiel | UA 1 [Gew%] | EDGA [Gew%] | POEA [Gew%] | UA 2 [Gew%] | Viskosität [mPas] | E-Modul [MPa] | Doppelbindungsdichte [mol/kg] |
|---|---|---|---|---|---|---|---|
| Mischung 5 | 50 | 50 | | | 39 | 4 | 3,4 |
| Mischung 6 | | | 65 | 35 | 91 | 3 | 3,6 |

| Beispiel | BDGEA [Gew% ] | TMPFMA [Gew%] | ETMPTA-A [Gew%] | ETMPTA [Gew%] | POEA [Gew%] | Viskosität [mPas] | E-Modul [MPa] | Doppelbindungsdichte [mol/kg] |
|---|---|---|---|---|---|---|---|---|
| Mischung 7 | 50 | 50 | | | | 39 | 4 | 5,5 |
| Mischung 8 | | | 10 | 10 | 80 | 91 | 3 | 5,4 |

Die Viskositäten der Beschichtungsmassen liegen im Bereich zwischen 10 mPas und 600 mPas. Der E-Modul der gehärteten Beschichtungsmassen liegt zwischen 1 und 20 MPa.

Mit Vorteil weist die Beschichtungsmasse einen Gehalt von
- 5 bis 80 Gew.-%, bevorzugt 10 bis 50 Gew.-% oder 15 bis 30 Gew.-% POEA;
- 5 bis 35 Gew.-%, bevorzugt 7 bis 30 Gew.-% oder 15 bis 25 Gew.-% DPGDA;
- 10 bis 80 Gew.-%, bevorzugt 15 bis 75 Gew-.% oder 50 bis 75 Gew.-% PESA;
mit der Maßgabe, dass sich die Werte, zuzüglich möglicher bereits beschriebener Additive auf 100 Gew.-% ergänzen.

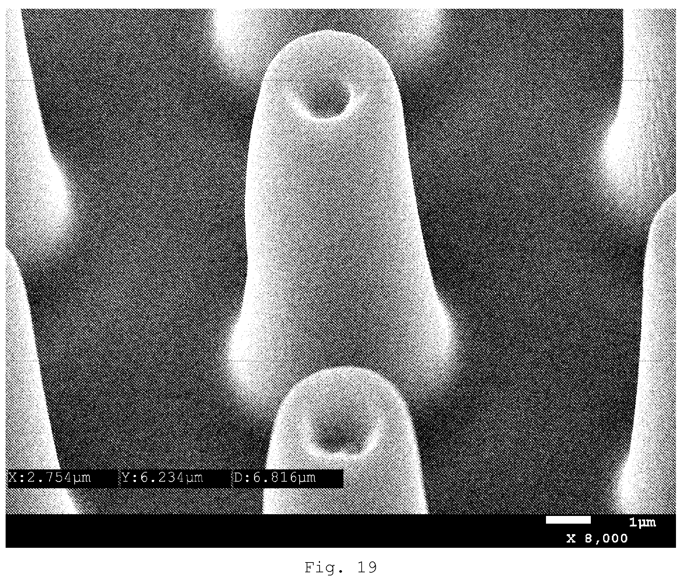

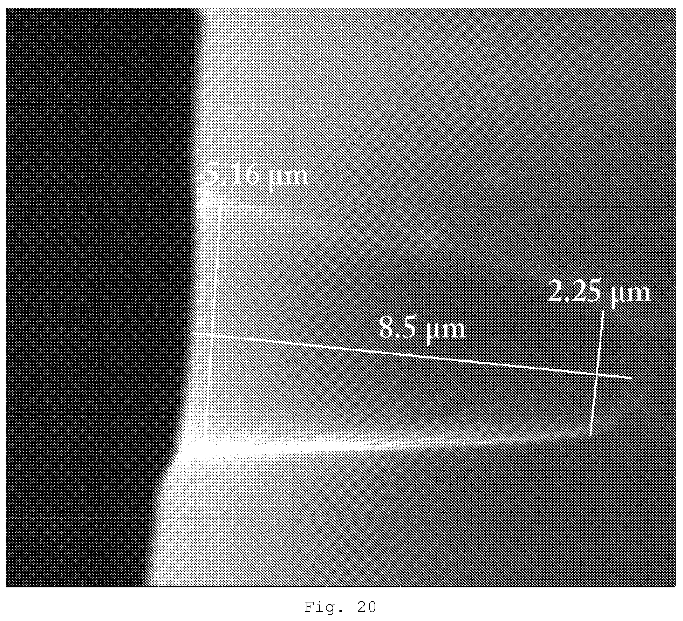

Figur 19 zeigt eine Struktur, welche durch Aufbringen einer Beschichtungsmasse aus Mischung 8 (Viskosität vor UV-Härtung: 91 mPas, E-Modul: 3 MPa, Doppelbindungsdichte: 5,4) auf eine Matrize, deren Ausschnitt im Querschnitt in Figur 20 dargestellt ist, erhalten wurde. Die UV-Belichtungszeit betrug 5 Minuten.

### Vergleichsbeispiel:

Eine Dispersion eines Polyacrylates, erhalten durch Polymerisation von 58 Gew% n-Butylacrylat, 40 Gew% Methylmethacrylat und 2 Gew% Acrylsäure (Glasübergangstemperatur des Polyacrylates: 0 °C), wurden mit 30 Gew% ETMPTA und 3,5 % Lucirin® TPO-L (Ethyl-2,4,6-Trimethylbenzoylphenylphosphinat, Photoinitiator der BASF SE, Ludwigshafen) versetzt und in einer Dicke von 20 µm auf einen Träger beschichtet. Die Viskosität dieser Mischung betrug 10 kPas.

Auf diese ungehärtete Beschichtung wurde eine Matrize aus PDMS mit 2.0 bar und einer Geschwindigkeit von 0,1 m/min angedrückt und anschließend über 5 Minuten in einem Abstand von 35 cm zur Härtung UV belichtet.

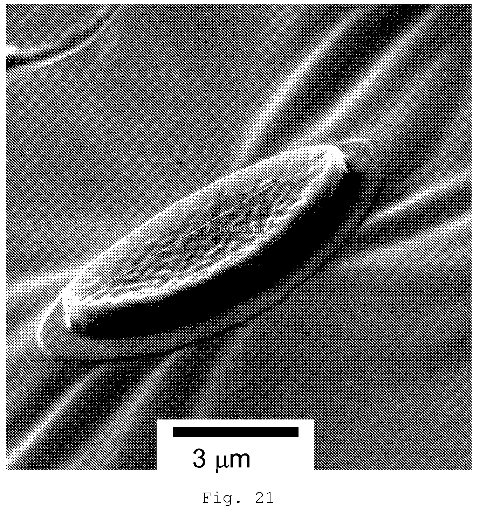

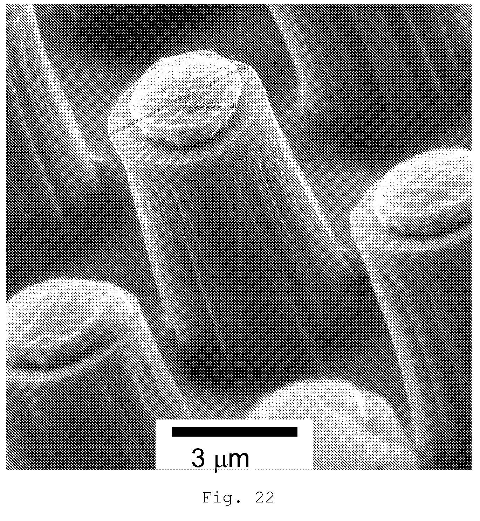

Figur 21 zeigt die mit dieser Beschichtungsmasse erhaltene Struktur, wohingegen Figur 22 die Struktur zeigt, die mit einer Beschichtungsmasse Mischung 1 mit einer Viskosität von 79 mPas, einem E-Modul von 9 MPa und einer Doppelbindungsdichte von 6,0 mol/kg erhalten wurde.

Man sieht, daß mit einer hochviskosen Beschichtungsmasse die Matrizenstruktur unzureichend abgebildet werden kann, wohingegen mit einer Beschichtungsmasse, die eine erfindungsgemäße Viskosität aufweist, die Form der Matrize gut wiedergegeben werden kann.

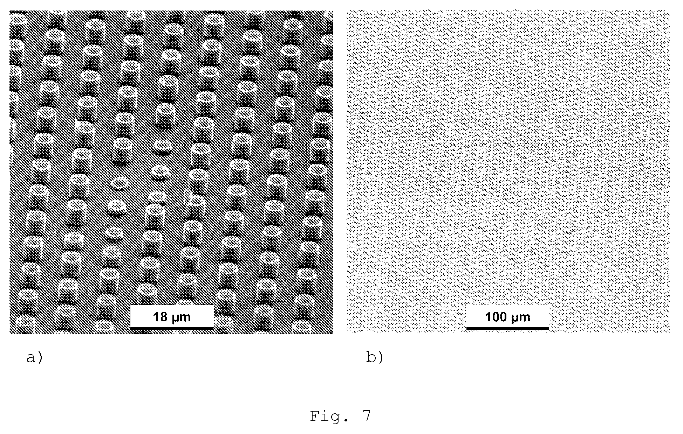

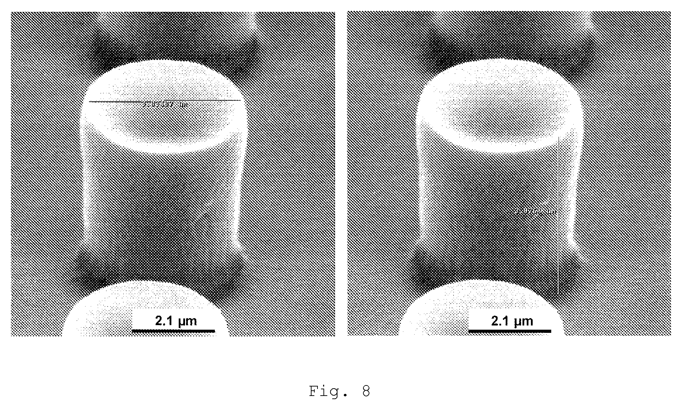

Figur 7 zeigt Struktur S5 welche durch Aufbringen der Polymermischung Mischung 3 auf eine Matrize aus Nickel, welche eine regelmäßige hexagonale Anordnung zylindrischer Strukturen aufwies, erhalten wurde. Die UV-Belichtungszeit betrug 5 Minuten. Figur 8 zeigt einen Ausschnitt aus der Figur 7.

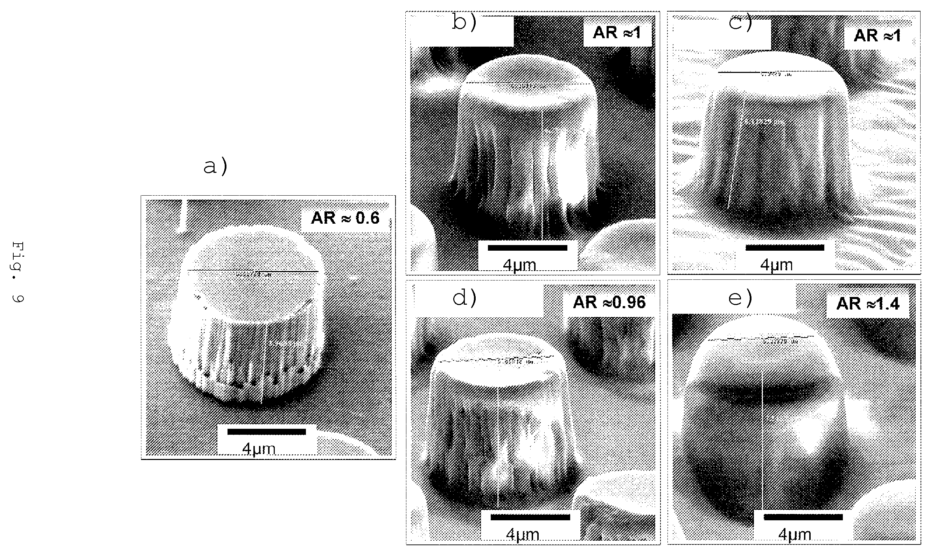

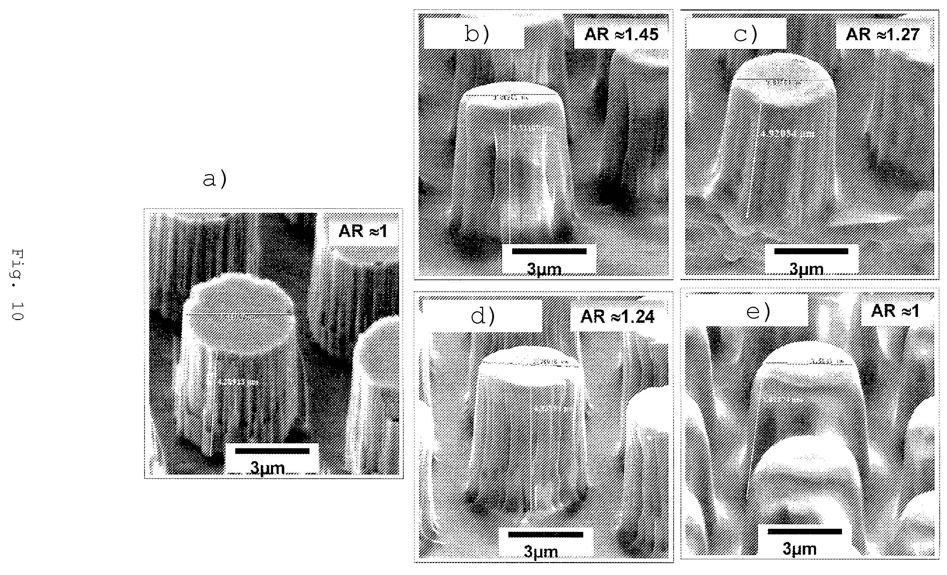

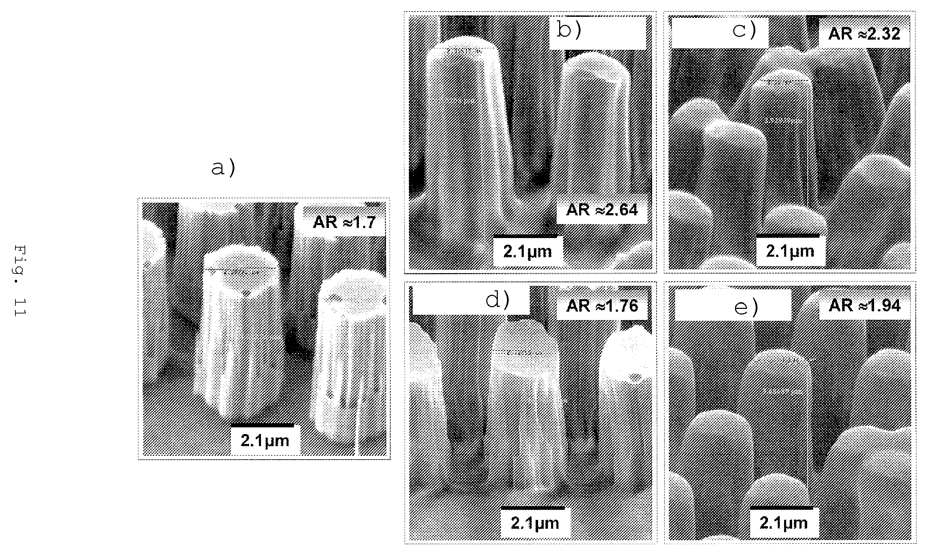

Die Figuren 9 bis 11 zeigen Untersuchungen zur Abformqualität unterschiedlicher Polymere/Polymermischungen. Dabei ist auch das Seitenverhältnis, d.h. das Verhältnis der Höhe der Struktur und dem Durchmesser (AR; *aspect ratio*) angegeben.

Die Strukturen wurden jeweils mit einer Matrize aus PDMS durch Aufbringen der strahlungshärtbaren Beschichtungsmasse hergestellt. Als Referenz ist als a) jeweils ein mit PDMS hergestellter Abdruck (bezeichnet als "*Original structure*") der entsprechenden Matrize.

Die erzeugten Strukturen sind zylindrische Strukturen mit gerader Stirnfläche und einem Verhältnis von Höhe zu Durchmesser an der Stirnfläche zwischen 0,6 und 1,7 gemessen am Referenzabdruck in PDMS (angegeben als AR). Dies könnte an einer Streckung der Strukturen beim Ablösen von der Matrize kommen.

Aus den Figuren ergibt sich, dass die Polymermischungen Mischung 4 die geringste Abformungsqualität zeigt. Die Polymermischungen Mischung 1 und Mischung 2 zeigen eine durchschnittliche Abformungsqualität. Die beste Abformungsqualität zeigt Mischung 3.

Durch den Herstellungsprozess scheint es zu einer leichten Verlängerung der Strukturen zu kommen. Das Seitenverhältnis kann sich um ca. 20 bis 70 % vergrößern. Allerdings ist zu erkennen, dass auch die Seitenriefen und Kanten der Struktur für die Mischungen 1, 2 und 3 gut aufgelöst werden.

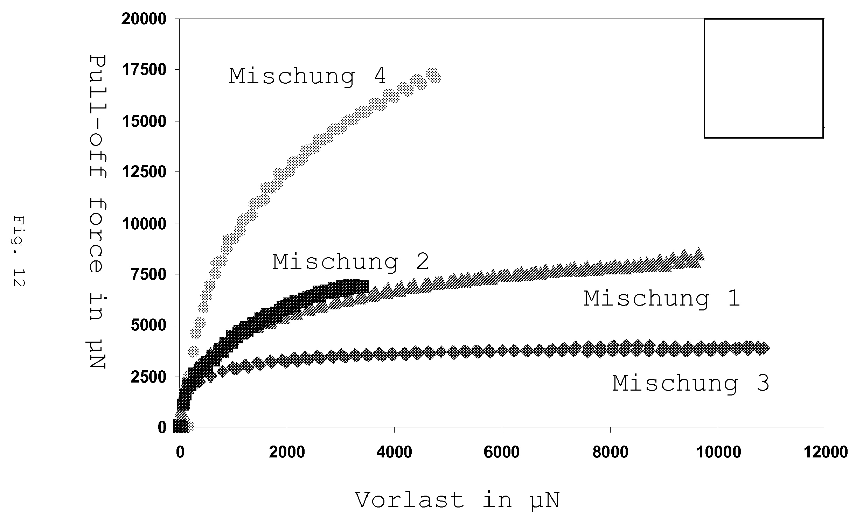

Figur 12 zeigt die Messung der Adhäsion unstrukturierter Oberflächen unterschiedlicher Polymere/Polymermischungen in Abhängigkeit von der Vorlast. Es zeigt sich, dass sich die Adhäsion bei zunehmender Vorlast wie folgt verteilt: Mischung 4 > Mischung 1 ∼ Mischung 2 > Mischung 3. Im Vergleich mit den Abformungseigenschaften zeigt sich, dass die Basisadhäsion mit zunehmender Abformungsqualität abnimmt.

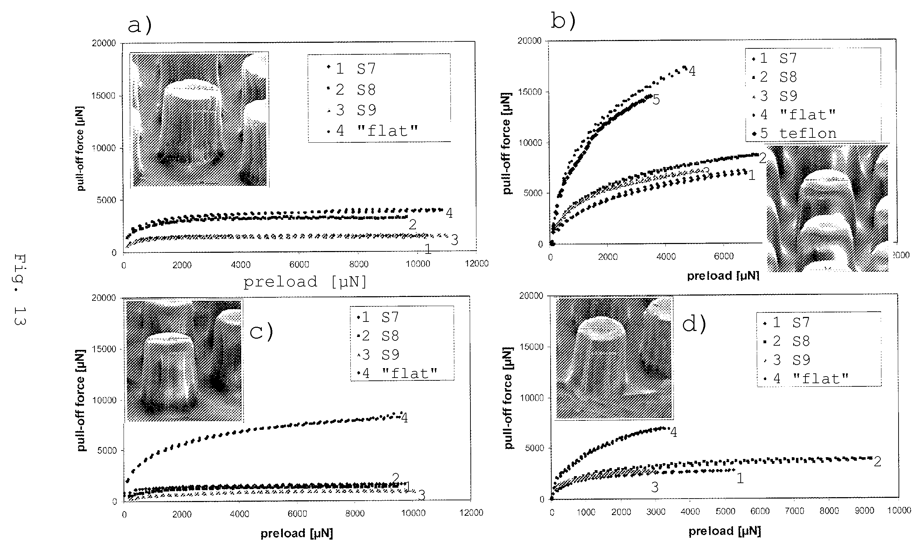

Figur 13 zeigt die Adhäsionsmessungen der verschiedenen Strukturen für verschiedene Polymere/Polymermischungen. Dabei ist jeweils die Vorlast (*preload*) in µN gegen die Kraft zum Abziehen (*pull*-*off force*) in µN aufgetragen. So zeigt a) Mischung 3, b) Mischung 4, c) Mischung 1 und d) Mischung 2. "flat" bedeutet eine unstrukturierte Oberfläche. Diese Ergebnisse entsprechen den Daten aus Figur 12. "teflon" bedeutet Messung gegen eine mit Teflon beschichtete Oberfläche. Eine Messung an einer unstrukturierten PDMS-Oberfläche ergab einen Wert von 1400 µN.

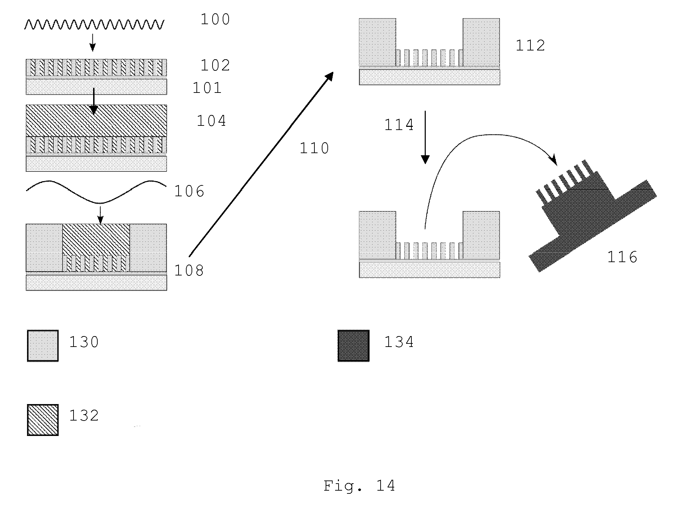

Figur 14 zeigt einen schematischen Ablauf der Herstellung einer Matrize zur Herstellung einer Feinstruktur auf einer Oberfläche 112. Zunächst wird gegebenenfalls eine Haftvermittlerschicht auf ein Matrizensubstrat 101 aufgetragen. Auf diese Schicht wird ein negativer Photolack 102 aufgetragen, z.B. SU-8. Dies kann durch Sprühen, Rakeln, Walzen oder Gießen und ggf. Schleudern geschehen. Die Schichtdicke kann zwischen 50 nm und 5 µm liegen, bevorzugt zwischen 200 nm und 2 µm. Mit Vorteil wird sie so gewählt, dass aus dieser Schicht erhaltene Kontaktstruktur eine Höhe zwischen 0,3 µm und 1 µm aufweist.

Die Schicht wird anschließend getrocknet. Dies kann durch Lagern bei Raumtemperatur oder Backprozesse, z.B. bei 60 °C bis 120 °C in einem Ofen oder auf einer Heizplatte, geschehen. Die Behandlung kann zwischen 30 Sekunden und bis zu zwei Stunden dauern.

Danach wird in diese Schicht das Negativ der Kontaktstruktur, bzw. einer Teilstruktur der Kontaktstruktur, belichtet. Dies erfolgt beispielsweise mit einem 2-Strahl-Interferenzaufbau. Dadurch kann eine wellenförmige Intensitätsverteilung erreicht werden 100. Um eine Anordnung mit in jeder Richtung regelmäßig angeordneten Vertiefungen zu erhalten kann auch mehrmals belichtet werden. Mit Vorteil wird zweimal belichtet, wobei die Probe zwischen den Belichtungen um 90° gedreht wird. Dadurch kann eine Anordnung von Vorsprüngen in einem Quadratraster erreicht werden. Die Periode dieser Belichtung liegt mit Vorteil unter 5 µm, bevorzugt unter 2 µm, aber über 0,1 µm. In Figur 14 zeigen die schraffierten Bereiche (Muster 132) unbelichteten Photolack und die Bereiche mit Muster 130 belichteten Photolack.

Im nächsten Schritt werden die Schichten temperaturbehandelt. Dies kann beispielsweise in einem Ofen oder auf einer Heizplatte geschehen, z. B. bei 90 °C bis 130 °C. Die Behandlung kann zwischen 30 Sekunden und bis zu zwei Stunden dauern.

Gegebenenfalls können die letzten Schritte wiederholt werden, um ein weiteres Negativ einer Kontaktstruktur aufzubringen.

Die erhaltene Struktur wird noch nicht entwickelt, sondern es wird eine weitere Schicht aus negativem Photolack 104 aufgetragen. Mit Vorteil ist es der gleiche Photolack, wie für das Negativ der Kontaktstruktur. In diese Schicht soll später die Sockelstruktur belichtet werden. Diese Schicht wird in einer Dicke von über 2 µm, bevorzugt über 3 µm, bis zu einer Dicke von 30 µm, bevorzugt bis zu 20 µm besonders bevorzugt bis zu 15 µm aufgetragen. Mit Vorteil wird sie so dick aufgetragen, dass die erhaltene Sockelstruktur eine Höhe zwischen 3 und 10 µm aufweist.

Die Schicht wird analog zu den bisher aufgetragenen Schichten getrocknet.

Danach wird in diese Schicht das Negativ der Sockelstruktur, bzw. einer Teilstruktur der Sockelstruktur, belichtet. Dies erfolgt beispielsweise mit einem 3-Strahl-Interferenzaufbau. Dadurch kann ein hexagonales Intensitätsmuster erzeugt werden. Es kann auch mehrfach belichtet werden und die Ausrichtung der Probe verändert werden. Die Periode dieser Belichtung 106 liegt mit Vorteil unter 20 µm, bevorzugt unter 15 µm, besonders bevorzugt unter 10 µm, sie kann aber auch unter 7 µm liegen. Mit Vorteil ist sie größer als 2 µm, bevorzugt größer als 3 µm. In der Regel ist sie 2- bis 10-mal so groß, wie die größte Periode zur Belichtung der Kontaktstruktur (bzw. des Negativs der Kontaktstruktur). Durch diese Belichtung, welche auch die noch nicht entwickelten unteren Schichten aus Photolack beeinflusst, entstehen in den Photolackschichten größere vollständig belichtete Bereiche. Man erhält auf diese Weise eine Sockelstruktur 108.

Im nächsten Schritt werden die Schichten temperaturbehandelt. Dies kann beispielsweise in einem Ofen oder auf einer Heizplatte geschehen, z. B. bei 90 °C bis 130 °C. Die Behandlung kann zwischen 30 Sekunden und bis zu zwei Stunden dauern.

Im nächsten Schritt 110 werden alle Schichten auf einmal entwickelt. Der Entwickler wird dabei in Abhängigkeit von dem verwendeten Photolack ausgewählt und ist dem Fachmann bekannt. Im Falle von SU-8 kann beispielsweise mr-dev 600 von micro resist technology GmbH verwendet werden. Dadurch wird in einem Schritt die Matrize 112 für eine Feinstruktur erhalten.

Danach kann die erhaltene Matrize in einem Elastomer 116, wie z.B. PDMS abgeformt werden (Schritt 114). Dieser Elastomer kann auch zur Herstellung weiterer Matrizen durch Prägen oder Abformung verwendet werden. Sie eignet sich aber auch insbesondere für das vorher beschriebene Verfahren zur Strukturierung von Oberflächen. Falls der Photolack als Material nicht geeignet ist, kann auch die erhaltene Abformung 116 zur Herstellung einer Matrize für eine Feinstruktur verwendet werden.

Die in Figur 4b gezeigte Matrize wurde mit dem vorstehend beschriebenen Verfahren hergestellt wurde. Dazu wurde zunächst die Struktur mit der kleineren Periode in eine Photolackschicht (SU 8) belichtet. Dazu wurde die Probe zweimal in einem 2-Strahl-Interferenzaufbau belichtet, wobei die Probe dazwischen um 90 °C gedreht wurde. In der Figur ist das Kreuzgitter der resultierenden Vorsprünge deutlich zu erkennen. Die Periode der Belichtung lag bei 1 µm. Danach wurde die Sockelstruktur in eine zweite aufgebrachte Photolackschicht belichtet. Dabei wurde ein 3-Strahl-Interferenzaufbau verwendet. Die entstehende Sockelstruktur weist daher eine hexagonale Anordnung auf. Die Periode der Belichtung lag bei 10 µm. Der Unterschied zwischen den beiden Anordnungen ist in Figur 4b deutlich zu erkennen. Nach den Belichtungen konnte die Form in nur einem Entwicklungsschritt erhalten werden. Figur 4a zeigt eine Abformung der Matrize in PDMS (ElastosilRT604).

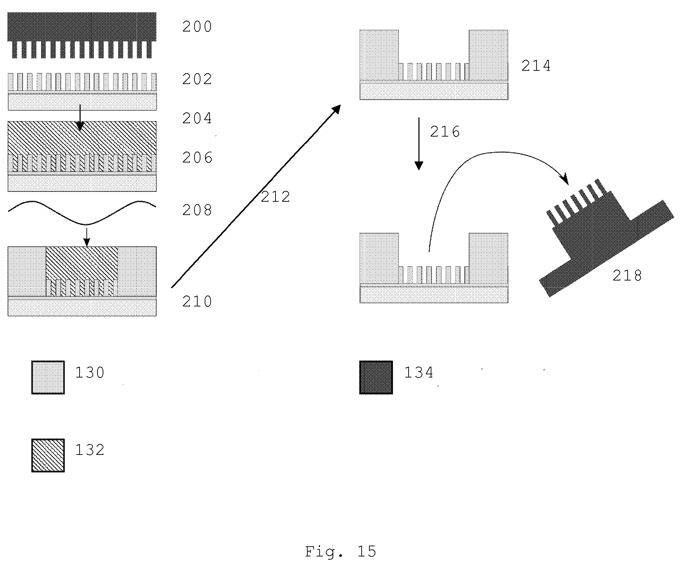

Fig. 15 zeigt eine andere Variante des vorstehend beschriebenen Verfahrens. Im Gegensatz zu einer Belichtung des Negativs der Kontaktstruktur, wird das Negativ der Kontaktstruktur in den aufgetragenen Photolack 202 mit Hilfe eines Stempels 200 geprägt und der geprägte Photolack anschließend gehärtet. Danach wird wie bereits beschrieben das Negativ der Sockelstruktur aufgebracht. So wird eine weitere Schicht Photolack für die Sockelstruktur 204 aufgebracht. Dabei füllt dieser Photolack 206 auch die bereits geprägte Struktur 202. Danach wird mit einer größeren Periode 208, um die Sockelstruktur 210 im Photolack auszubilden. Danach werden wie bereits beschrieben, alle Photolackschichten auf einmal entwickelt (Schritt 212). Man erhält die Matrize 214 der Feinstruktur. Diese kann wie bereits beschrieben durch ein Elastomer 218 abgeformt werden (Schritt 216).

Die Vorlage zum Prägen der negativen Kontaktstruktur kann auf folgende Weise erhalten werden. Zunächst wird ein Substrat, ähnlich den Substraten für die Matrize, mit einem Photolack beschichtet, bevorzugt einem positiven Photolack. Es kann nötig sein, vorher auf dem Substrat einen Haftvermittler aufzubringen.

Danach wird die Beschichtung temperaturbehandelt.

Im nächsten Schritt wird, wie bereits beschrieben, die Kontaktstruktur belichtet. Dies kann beispielsweise durch einen 2-Strahl-Interferenzaufbau geschehen, wobei zweifach belichtet wird und die Probe zwischen den Belichtungen um 90° gedreht wird.

Danach wird die Struktur entwickelt. Dies kann beispielsweise mit Kalilauge geschehen. Durch die Verwendung eines positiven Photolacks, bildet sich beim Entwickeln das Negativ der Struktur, welche bei Verwendung eines negativen Photolacks erhalten wird.

Die erhaltene Struktur wird in einem ersten Elastomer abgeformt, z.B. Silikon, beispielsweise Sylgard® 184 von Dow Corning. Es können auch andere Materialien, wie z.B. Nickel verwendet werden.

Um von der abgeformten Struktur zu der Vorlage zum Prägen des Negativs der Kontaktstruktur zu gelangen, muss die im letzten Schritt erhaltene Struktur ein weiteres Mal abgeformt werden.

Dafür kann erneut ein Elastomer, z.B. elastisches Polyurethan, beispielsweise PolyOptic® 1470 von PolyConForm verwendet werden. Dabei dürfen sich die beiden Elastomere bei der Polymerisation nicht miteinander reagieren und müssen auch wieder voneinander lösbar sein.

Die im letzten Schritt erhaltene abgeformte Struktur ist die Vorlage zum Prägen des Negativs der Kontaktstruktur.

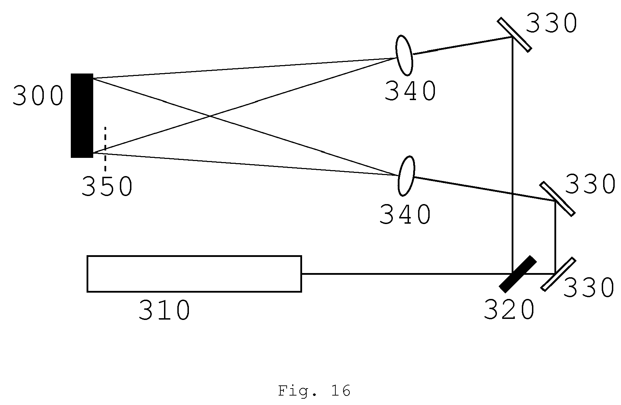

Figur 16 zeigt eine schematische Darstellung für einen 2-Strahl-Interferenzaufbau. Dabei werden zwei Strahlen auf einem mit Photolack beschichteten Matrizensubstrat 300 überlagert. Dazu wird ein Laser 310 mit Hilfe eines Strahlteilers 320 in zwei Strahlen bevorzugt mit gleicher Intensität aufgeteilt und über mehrere Spiegel 330 geleitet. Mit Hilfe von zwei Linsen 340 werden beide Strahlen aufgefächert und auf die Oberfläche des Substrats geleitet. Dabei kommt es im Überschneidungsbereich der beiden Strahlen 350 zur Interferenz der beiden Strahlen. Auf diese Weise kann auf der Oberfläche des Matrizensubstrats ein entsprechendes Interferenzmuster erhalten werden. Bei der Verwendung von zwei Strahlen kommt es zur Ausbildung von Linien, wie beispielsweise in Figur 2 gezeigt. Um abgegrenzte Vorsprünge zu erhalten, kann man die Probe mehrmals unter Verdrehung des Matrizensubstrats belichten. Wenn die Probe beispielsweise um 90 °C gedreht und dann erneut belichtet wird, kann ein kreuzförmiges Muster erhalten werden. Der Abstand zwischen Matrizensubstrat und Linsen bestimmt dabei neben der Wellenlänge die Größenordnung der belichteten Struktur.

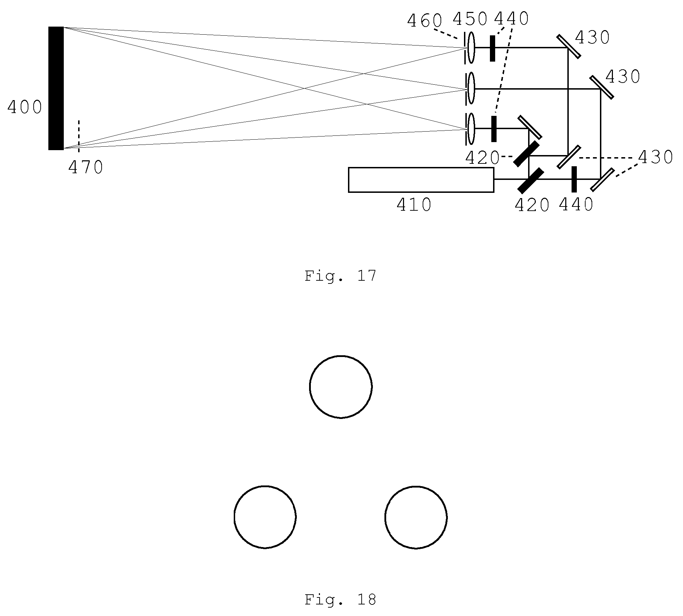

Figur 17 zeigt eine schematische Darstellung für einen 3-Strahl-Interferenzaufbau. Dabei werden insgesamt drei Strahlen auf einem mit Photolack beschichteten Matrizensubstrat 400 überlagert. Dazu wird ein Laserstrahl (z.B. Argon-Laser 363 nm) durch eine Kombination von 2 Strahlteilern 420 in insgesamt drei Strahlen gleicher Intensität aufgeteilt. Dabei teil der erste Strahlteiler im Intensitätsverhältnis 2:1 und der zweite den stärkeren Strahl des ersten Strahlteilers im Verhältnis von 1:1. Die Strahlen werden durch mehrere Spiegel 430 und λ/2-Platten (440, um Polarisationseffekte auszugleichen) auf drei Linsen 450 geleitet. Die Linsen fächern die drei Strahlen auf. Dabei können vor den Linsen noch Blenden 460 angeordnet sein. Durch die Überlagerung der drei Strahlen kommt es im Bereich 470 zur Interferenz. Auf dem Matrizensubstrat wird eine entsprechende Intensitätsverteilung belichtet. Die drei Linsen müssen sich dabei nicht in einer Ebene befinden. So kann eine Linse außerhalb der Verbindungslinie zwischen den beiden anderen Linsen angeordnet sein. So können die Linsen 450 beispielsweise wie in Figur 18 gezeigt in Form eines gleichseitigen Dreiecks angeordnet sein. Der Abstand der Linsen zum Matrizensubstrat erlaubt dabei eine einfach Einstellung der Größenordnung der Struktur.

### Messung der Adhäsion:

Zur Bestimmung der Adhäsion wurde mit einer Geschwindigkeit von 2µm/s eine Saphir-Kugel mit 2,5 mm Durchmesser gegen die Proben gedrückt. Als Eingangsparameter dient das "Piezo displacement". Er gibt die Verschiebung der Probe während der Messung an. Als Ausgangssignal erhält man die Auslenkung einer Messfeder, an welcher die Saphir-Kugel befestigt ist. Durch Kalibrierung lassen sich so die während der Messung auftretenden Kräfte bestimmen ("force"). In Figur 5 entsprechen positive Kräfte einer aufgebrachten Last auf die Probe, während negative Kräfte die Adhäsion beschreiben. Für Messungen der Adhäsion in Abhängigkeit von der Vorlast wurde die Kugel bis zur entsprechenden Vorlast (entspricht Auslenkung der Messfeder*Federkonstante) gegen die Probe gedrückt. Aus der Auslenkung der Messfeder beim Zurückziehen der Kugel kann die Adhäsionskraft (*pull-off force*) erhalten werden.

### Messung des Elastizitätsmoduls:

Der Intendationsmodulus der gehärteten Mischungen wurde mit einem TI950 Nanoindenter Instrument (Hysitron Inc., Minneapolis, MN, USA) gemessen. Eine Berkovich-Spitze wurde verwendet. Die Vorlast der Probe war 500 nN. Die Spitze wurde vor jeder Messung für 10 Minuten mit der angegebenen Vorlast für 10 Minuten in Kontakt mit der Probe gebracht um das System zu stabilisieren und thermischen Drift zu minimieren. Die Indentierungen wurden unter Auslenkungskontrolle ("displacement control") mit einer dreigeteilten Lastkurve durchgeführt: Zuerst eine erste linearer Last mit 200 nm/s bis zu einer Eindringtiefe von 2000 nm (Eindrückzeit 10s), gefolgt von einer Haltezeit von 30 s bei maximaler Last und danach einer Reduktion der Last mit 200 nm/s (Rückzugszeit 10 s). Die Fläche der Perkovich Spitze wurde durch Messung an einem Quartz-Standard (Quartz fused) mit einer Eindringtiefe von 30 bis 140 nm abgeschätzt. Der berechnete Spitzendurchmesser der Berkovich-Spitze lag zwischen 50 und 60 nm. Je Probe wurden 20 Tests durchgeführt. Die Oliver-Pharr-Methode wurde zur Berechnung des Elastizitätsmoduls der gehärteten Proben verwendet.

### Beispiel 1:

### Herstellung der Matrizen aus Polydimethylsiloxan (PDMS) ("Original structure")

Es wurde eine Zusammensetzung aus PDMS Sylgard 184 Basis (Sylgard 184 base) und PDMS Sylgard 184 Härter (Sylgard 184 cure agent) im Verhältnis von 10:1 hergestellt (beide von Dow Corning, Midland, MI). Die Mischung wurde für eine Stunde unter Vakuum entgast um Blasenbildung vorzubeugen. Die Mischung wurde auf eine strukturierte Silizium-Oberfläche aufgetragen (Strukturen auf dem Wafer wurden durch Photolithographie und "reactive ion etching-Elmar" hergestellt) und für 14 Stunden bei 95 °C gehärtet.

### Beispiel 2:

Die Oberfläche der PDMS-Matrize aus Beispiel 1 wurde mit einer selbstorganisierenden Monolage ("self-assembled monolayer" SAM) von Trichloro(1H,1H,2H,2H-perfluorooctyl)silan behandelt um eine gute Ablösbarkeit der Matrize von der hergestellten strukturierten Oberfläche zu gewährleisten.

### Beispiel 3:

Die strukturierte Nickeloberfläche wurde von Temicon Company erworben. Sie hat Mikrostrukturen mit einem Durchmesser von 4 µm und einer Länge von 15 µm.

### Beispiel 4:

Die Oberfläche der Matrize aus Beispiel **3** wurde mit Plasma aktiviert und danach mit Trichloro(1H,1H,2H,2H-perfluorooctyl) silan modifiziert, um ein einfaches Ablösen der Matrize zu gewährleisten.

### Beispiel 5:

### Herstellung der Strukturen durch Formen

Weiches Formen wurde mit der PDMS Matrize aus Beispiel 2 durchgeführt. Auf die Matrize wurde ein Rahmen aus PET-Folie mit einer Dicke von 75 µm aufgebracht. Die Dicke dieser PET-Folie ist dabei proportional die Dicke des ungeprägten Teils der späteren Polyacrylatschicht. Die UV-härtbaren Polyacrylatmischungen (Mischung 1, 2, 3 und 4) wurden in den durch den Rahmen begrenzten Bereich der Matrize gegossen. Danach wurde eine PET-Folie gegen die Mischungen gedrückt. Diese PET-Folie dient später als Substrat für die strukturierte Oberfläche. Die Polyacrylatmischungen wurden für 5 Minuten mit UV-Licht bestrahlt und danach von der Matrize abgelöst. Als Lichtquelle wurde eine kurzwellige 1000 W Hg (Xe) Lampe verwendet (Lot-Oriel instruments). Die Intensität der UV-Lampe war 28.4 mW bei einer Entfernung von Probe und Lampe von 4 cm. Bei einer spektralen Bestrahlungsdichte von 144,676 mW/cm² für 300 s wurde eine optische Energie von 43402,8 mJ/cm² auf die Oberfläche übertragen. Während der Bestrahlung waren die Matrize und die Polyacrylatschicht in Kontakt. Die hergestellten Strukturen sind in den Figuren 9 bis 11 dargestellt. Im Falle von a) wurden Abgüsse aus PDMS hergestellt.

### Beispiel 6:

### Herstellung von Feinstrukturen durch Formen mit harter Matrize

Das Verfahren wurde mit der Nickelmatrize aus Beispiel **3** durchgeführt. Auf die Matrize wurde ein Rahmen au seiner PET-Folie mit einer Dicke von 75 µm als Abstandshalter aufgebracht. Die Dicke der Folie ist proportional mit der Dicke der späteren nicht geprägten Teil der Polyacrylatschicht. Eine UV-härtbare Polyacrylatmischung (Mischung 2) wurde in den von dem Rahmen umgebenen Bereich der Matrix gegossen. Danach wurde eine PET-Folie gegen die flüssige Masse gepresst. Diese Folie dient später auch als unterstützendes Substrat der strukturierten Beschichtung. Nach 5 Minuten wurden die PET-Folie und die gehärtete Polyacrylatmischung von der Matrize abgelöst. Als Lichtquelle für die Belichtung wurde eine kurzwellige 1000 W Hg (Xe) Lampe (Lot-Oriel instruments) verwendet. Die Intensität der UV Lampe war 28,4 mW bei einer Entfernung von Probe und Lampe von 4 cm. Bei einer spektralen Belichtungsdichte von 144,676 mW/cm² für 300 s wurde eine optische Energie von 43402.8 mJ/cm² auf das Substrat übertragen. Die Polyacrylatschicht und die Matrize waren während der Belichtung in Kontakt.

### Beispiel 7:

Die Matrize für Struktur S1 wurde mit Hilfe von Interferenzlithographie im 3-Wellen Aufbau für hexagonale Strukturen hergestellt (hexagonale Anordnung). Dafür werden drei Strahlen zu einem Interferenzmuster überlagert. Dies erlaubt die Erzeugung von scharfen hexagonalen Strukturen. Dabei treffen die drei Strahlen ausgehend von drei Linsen in einem definierten Winkel auf die zu belichtende Oberfläche. Dieser Winkel definiert die Periode des entstehenden Musters. Die drei Linsen können dabei in Form eines gleichseitigen Dreiecks angeordnet sein, wodurch ein symmetrisches Muster entsteht. Der Abstand des Substrats von den Linsen und der Abstand dieser bestimmt den Winkel und damit die Periode der Intensitätsverteilung der Interferenz. So kann beispielsweise bei einem Abstand der Linsen entlang der Dreiecksseiten von 18,4 cm und einem Abstand vom Substrat von 3,5 m eine Zielperiode von 8 µm erhalten werden (Wellenlänge des Lasers 363,8 nm). Als Photolack wurde ein Photoresist AZ9260 der Firma AZ Electronic Materials verwendet. Zum Entwickeln wurde Kalilauge eingesetzt. Eine Abformung in PDMS zeigt Figur 1.

### Beispiel 8:

Die Matrize für Struktur S2 wurde analog zu Beispiel **7** hergestellt. Allerdings wurde, um Linien zu erhalten nur ein 2-Wellen-Aufbau mit einfacher Belichtung verwendet. Figur 2 zeigt eine Abformung in PDMS.

### Beispiel 9:

Die Herstellung der Matrizen für Struktur S3 wurde analog zu Beispiel **7**, allerdings mit Interferenzlithographie im 2-Wellen Aufbau mit doppelter Belichtung mit Drehung der Probe um 90° hergestellt. Dadurch wird eine Kreuzgitterstruktur der Vorsprünge erhalten.

### Beispiel 10:

Einer Matrize aus Nickel (ähnlich Beispiel 3; Lochdurchmesser 5 µm; Tiefe 15 µm) wurde auf einer Rolle einer Rolle-zu-Rolle-Druckmaschine angebracht. Mischung 3 wurde in einer Dicke von 400 µm auf einer PET-Folie aufgebracht und ohne Druck mit der Matrize in Kontakt gebracht. Die Mischung wurde während der Kontaktierung mit der Matrize für 5 Minuten belichtet. Es wurde eine 1000 W Lichtbogenlampe (Thermo-Oriel instruments) verwendet. Die Intensität der UV-Lampe war 20,3 mW bei einer Entfernung zwischen Probe und Lampe von 4 cm. Bei einer spektralen Bestrahlungsdichte von 103.41 mW/cm² für 300 s wurde eine optische Energie von 31023,94 mJ/cm² auf die Oberfläche übertragen. Es wurden die in Figur 7 und 8 gezeigten Strukturen erhalten. Zwar ist die Matrize sauber abgebildet, aber es kam zu einer nur unvollständigen Füllung der Matrize.

### Beispiel 11:

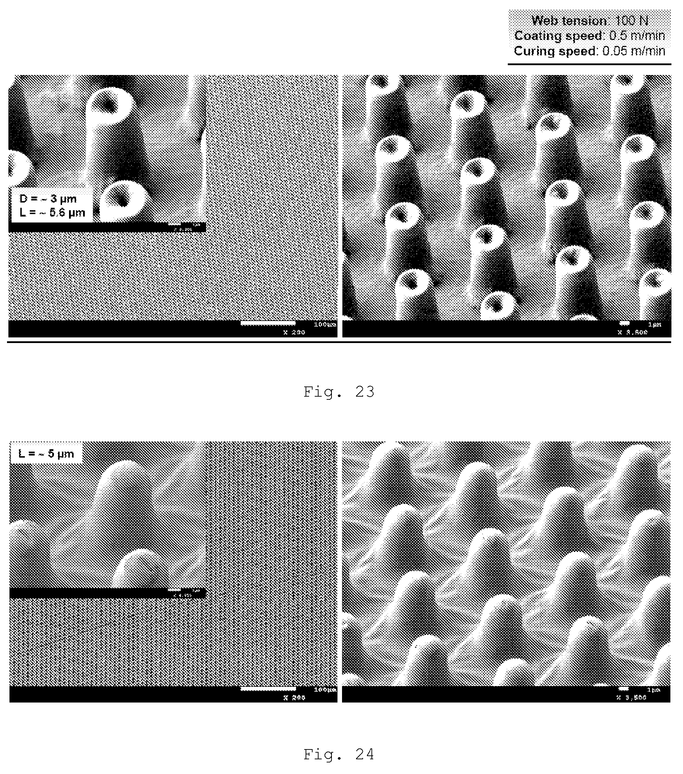

Es wurde die mögliche Scherbelastung eines Streifens einer strukturierten PET-Folie gemessen. Dazu wurden mit zwei Proben Mischung 5; Druckprozeß mit 5 min UV-Härtung (Viskosität vor UV-Härtung: 39 mPas, E-Modul: 4 MPa) und Mischung 6; Druckprozeß mit 5 min UV-Härtung (Viskosität vor UV-Härtung: 91 mPas, E-Modul: 3 MPa)Strukturen hergestellt. Die Figuren 23 (Mischung 5) und 24 (Mischung 6) zeigen die hergestellten Strukturen.

Ein Streifen dieser beiden strukturierten PET Folien von 1 * 3,5 cm hält einer Scherbelastung von 570 g (Glasplatte) stand. Die Struktur aus dem Material Mischung 5 konnte in einem ersten Test auch kurzzeitig 730 g standhalten.

Weitere anwendungstechnische Tests führten zu folgenden Ergebnissen:

Eine PET-Folie (Milinex 505, ca. 85µ) mit den Strukturen der Mischungen 5 bzw. 6 wurden bei einem Prüfklima von 23 °C und 50% relativer Luftfeuchtigkeit auf Stahlblech bzw. Glas auf eine Fläche von 25 × 25 mm angerollt, für 10 min belassen und die Scherfestigkeit mit einem Prüfkörper von 1 kg bestimmt. Gemessen wurde die Zeit in Stunden bis zum Lösen des Prüfkörpers. Ferner wurde die Art des Bruches der verklebten Fläche bestimmt (hier: Adhäsionsbruch, also vollständige Ablösung der verklebten Fläche vom Untergrund).

| | Scherfestigkeiten in Stunden | | | |
|---|---|---|---|---|
| | Stahl | | Glas | |
| Strukturierte Mischung 5 | 2,1 | A | 20,5 | A |
| Strukturierte Mischung 6 | 2,8 | A | 34,1 | A |

| | | | | |
|---|---|---|---|---|
| A = Adhäsionsbruch | | | | |

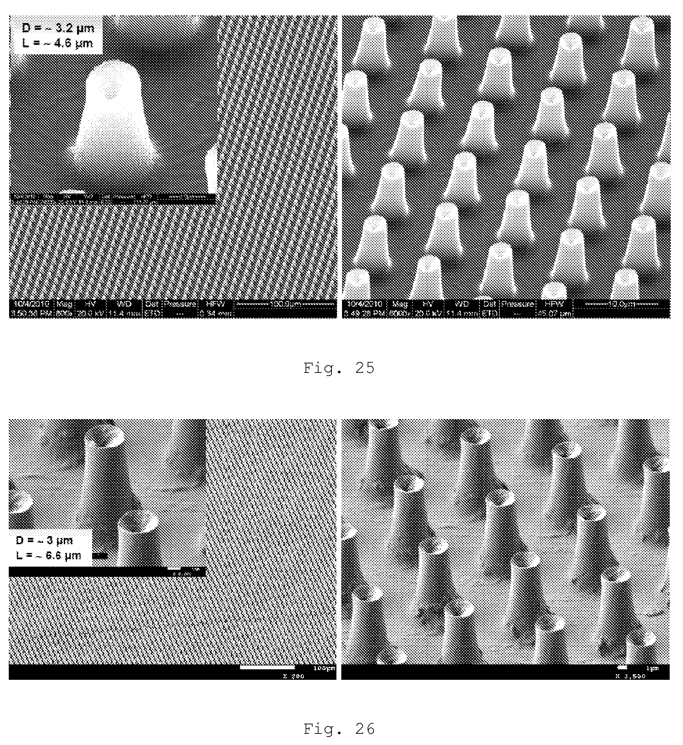

Auch mit den Mischungen 7 und 8 konnten Strukturen gedruckt werden. Die Figuren 25 (Mischung 7) und 26 (Mischung 7) zeigen die erhaltenen Strukturen.

### Bezugszeichen

- 50: Laser-Interferometer
- 52: Glasfeder und Messsubstrat
- 54: Piezoelement
- 56: 6-Achsentisch
- 60: Andrücken ("approach")
- 62: Vorlast ("preload")
- 64: Abziehen der Probe ("retreat")
- 66: Ablösekraft der Probe ("pull-off force")
- 100: Intensitätsverteilung der Belichtung
- 101: Matrizensubstrat
- 102: Schicht aus negativem Photolack
- 104: Schicht aus negativem Photolack
- 106: Intensitätsverteilung (Periode) der Belichtung
- 108: Sockelstruktur
- 110: Entwicklung aller Schichten
- 112: Matrize mit Feinstruktur
- 114: Abformen der Matrize
- 116: abgeformtes Elastomer
- 130: belichteter Photolack
- 132: unbelichteter Photolack
- 134: Elastomer
- 200: Stempel
- 202: geprägte Schicht aus Photolack
- 204: Photolack
- 206: geprägte Schicht aus Photolack
- 208: Intensitätsverteilung der Belichtung
- 210: Sockelstruktur
- 212: Entwicklung aller Schichten
- 214: Matrize mit Feinstruktur
- 216: Abformen der Matrize
- 218: abgeformtes Elastomer
- 300: Matrizensubstrat
- 310: Laser
- 320: Strahlteiler
- 330: Spiegel
- 340: Linse
- 350: Interferenzbereich
- 400: Matrizensubstrat
- 410: Laser
- 420: Strahlteiler
- 430: Spiegel
- 440: λ/2-Platte
- 450: Linse
- 460: Blende
- 470: Interferenzbereich

**Tabelle 1**

| Probe | Höhe (gemessen ab Basis) [µm] | Durchmesser (gemessen auf der Stirnfläche) [µm] | Seitenverhältnis (AR) |
|---|---|---|---|
| **Struktur S7 (****Fig. 9****)** | | | |
| a) "Original structure" | 3,97 | 6,61 | ∼0,60 |
| b) Mischung 1 | 6,29 | 6,35 | ∼1 |
| c) Mischung 2 | 6,12 | 5,84 | ∼1 |
| d) Mischung 3 | 5,65 | 5,87 | ∼0,96 |
| e) Mischung 4 | 7,55 | 5,39 | ∼1.4 |

| **Struktur S8 (****Fig. 10****)** | | | |
|---|---|---|---|
| a) "Original structure" | 4,29 | 4,41 | ∼1 |
| b) Mischung 1 | 5,53 | 3,80 | ∼1,45 |
| c) Mischung 2 | 4,92 | 3,88 | ∼1,27 |
| d) Mischung 3 | 4,94 | 3,98 | ∼1,24 |
| e) Mischung 4 | 3,92 | 3,58 | ∼1 |

| **Struktur S9 (****Fig. 11****)** | | | |
|---|---|---|---|
| a) "Original structure" | 4,07 | 2,40 | ∼1,7 |
| b) Mischung 1 | 5,5 | 2,09 | ∼2,64 |
| c) Mischung 2 | 3,93 | 1,68 | ∼2,32 |
| d) Mischung 3 | 3,82 | 2,19 | ∼1,76 |
| e) Mischung 4 | 3,67 | 1,89 | ∼1,94 |

### zitierte Literatur

EP 1 513 904 B1
DE 100 01 135 A1
DE 10 2007 021 249 A1
WO 01/49776 A2
WO 2009/053714 A1
DE 100 13 186 A1
DE 100 13 187 A1
EP 71 050 B1
EP 71 050 A1
US 4,421,602
EP 0 464 043 B1
US 5,225,088
EP 0 411 400 A2
DE 24 34 816 A1
US 4,066,494
WO 94/12560 A1
WO 94/14873 A1
WO 97/25367
EP 7 508 A2
EP 57 474 A2
DE 196 18 720 A1
EP 0 495 751 A1
EP 0 615 980 A2
DE 198 26 712 A1
DE 199 13 353 A1
WO 98/33761 A1
DE 199 57 900 A1
EP 0 092 269 A1
EP 0 464 043 B1
WO 97/25367 A1
"Advances in Polymer Science", Volume 14, Springer Berlin 1974 K. K. Dietliker, Chemistry and Technology of UV- and EB-Formulation for Coatings, Inks and Paints, Volume 3; Photoinitiators for Free Radical and Cationic Polymerization, P. K. T. Oldring (Eds), SITA Technology Ltd, London,
D. A. Wicks, Z. W. Wicks, Progress in Organic Coatings, 36, 148-172 (1999)
D. A. Wicks, Z. W. Wicks, Progress in Organic Coatings, 41, 1-83 (2001)
D. A. Wicks, Z. W. Wicks, Progress in Organic Coatings, 43, 131-140 (2001).
Polymer Handbook, 2. Aufl., Wiley & Sons, New York

## Patentansprüche

1. Verfahren zur Herstellung von feinstrukturierten beschichteten Oberflächen mit einem Aspektverhältnis von mindestens 0,5 zur Beeinflussung der Adhäsion umfassend die Schritte
a) Auftragen mindestens einer Beschichtungsmasse auf mindestens ein Substrat;
b) Formen einer Feinstruktur durch eine Matrize, die das Negativ einer Feinstruktur aufweist, wobei
b1) die Matrize gegen die Beschichtungsmasse auf dem Substrat gedrückt wird oder
b2) das Substrat aus Schritt a) die Matrize enthält;
c) Härten der so erhaltenen feinstrukturierten Beschichtungsmasse unter Erhalt einer gehärteten Beschichtung;
d) Abtrennen der feinstrukturierten Beschichtung von der Matrize, wobei die Schritte d) und c) auch in umgekehrter Reihenfolge durchgeführt werden können, und
wobei
- die Beschichtungsmasse in lösungsmittelfreiem Zustand vor dem Auftragen auf das Substrat eine Viskosität [Rotationsviskosimetrie nach DIN 53018-1 mit Platte/Kegel-Geometrie bei 25°C; Temperierung: Peltier; Messeinrichtung: HC 60/1 bei einem Schergefälle D von 10 - 1.000 1*s-1] unter 10 Pas und
- die gehärtete Beschichtung ein E-Modul [Indentation mit Berkovich Spitze, Vorlast zwischen 0,1 und 1 mN je nach Modul der zu bestimmenden Probe; Eindrückzeit: 10 s; Haltezeit 30 s und Rückzugzeit 10 s, Kalibrierung auf Polycarbonat] von mindestens 1 und bis zu 1000 MPa aufweist
- die strahlungshärtbare Beschichtungsmasse eine Doppelbindungsdichte von nicht mehr als 7 mol/kg aufweist.

2. Verfahren gemäß Anspruch 1, **dadurch gekennzeichnet, dass**
die Viskosität der Beschichtungsmassen in lösungsmittelfreien Zustand im Bereich zwischen 10 mPas und 600 mPas liegt.

3. Verfahren gemäß Anspruch 1 oder 2, **dadurch gekennzeichnet, dass**
es sich bei den strahlungshärtbaren Beschichtungsmassen um Acrylsäureester, Methacrylsäureester oder ungesättigte Polesterharze handelt.

4. Verfahren gemäß Anspruch 1 oder 2, **dadurch gekennzeichnet, dass**
es sich bei den strahlungshärtbaren Beschichtungsmassen um Polyester-, Polyether-, Carbonat-, Epoxy- oder Urethan(meth)acrylate handelt, die optional teilweise aminmodifiziert sein können.

5. Verfahren gemäß Anspruch 1 oder 2, **dadurch gekennzeichnet, dass**
die strahlungshärtbare Beschichtungsmasse enthält
- mindestens ein Polyester-, Polyether-, Carbonat-, Epoxy- oder Urethan(meth)acrylat oder ungesättigtes Polyesterharz,
- optional mindestens einen Reaktivverdünner,
- optional mindestens ein Photoinitiator,
- optional mindestens ein Lösungsmittel,
- optional mindestens einen Stabilisator,
- optional mindestens Additiv, ausgewählt aus der Gruppe bestehend aus Aktivatoren, Füllmittel, Pigmente, Farbstoffe, Verdicker, thixotrope Agentien, oberflächenaktive Agentien, Viskositätsmodifikatoren, Plastifizierer und Chelatbildner.

6. Verfahren gemäß einem der Ansprüche 2 bis 5, dadurch genkennzeichnet, dass
die strahlungshärtbare Beschichtungsmasse eine Doppelbindungsdichte von mindestens 0,1 mol/kg aufweist.

7. Verfahren gemäß einem der vorstehenden Ansprüche, **dadurch gekennzeichnet, dass**
das Substrat ausgewählt ist aus der Gruppe bestehend aus PET, PP, PE und PMMA.

8. Verfahren gemäß einem der vorstehenden Ansprüche, **dadurch gekennzeichnet, dass**
die Matrize eine Matrize einer hierarchischen Feinstruktur ist.

9. Strukturierte Oberfläche eines Festkörpers erhältlich nach einem Verfahren der Ansprüche 1 bis 8.

## Claims

1. Method for producing finely structured coated surfaces with an aspect ratio of at least 0.5 for influencing adhesion comprising the steps
a) applying at least one coating compound on at least one substrate;
b) forming a fine structure by means of a die, which has the negative of a fine structure, wherein
b1) the die is pressed against the coating compound on the substrate or
b2) the substrate from step a) contains the die;
c) curing the resultant finely structured coating compound, obtaining a cured coating;
d) separating the finely structured coating from the die, wherein steps d) and c) can also be carried out in the reverse order, and
wherein
- the coating compound, in the solvent-free state before application on the substrate, has a viscosity [rotary viscosimetry according to DIN 53018-1 with plate/cone geometry at 25°C; temperature control: Peltier; measuring device: HC 60/1 at a shear gradient D of 10-1000 l*s⁻¹] below 10 Pas and
- the cured coating has an elastic modulus [indentation with Berkovich tip, preload between 0.1 and 1 mN depending on the modulus of the test specimen; indentation time: 10 s; holding time 30 s and retraction time 10 s, calibration on polycarbonate] of at least 1 and up to 1000 MPa
- the radiation-curing coating compound has a double bond density of not more than 7 mol/kg.

2. Method according to Claim 1, **characterized in that** the viscosity of the coating compounds in the solvent-free state is in the range from 10 mPas to 600 mPas.

3. Method according to Claim 1 or 2, **characterized in that** the radiation-curing coating compounds are acrylic acid esters, methacrylic acid esters or unsaturated polyester resins.

4. Method according to Claim 1 or 2, **characterized in that** the radiation-curing coating compounds are polyester-, polyether-, carbonate-, epoxy- or urethane(meth)acrylates, which optionally can be partially amine-modified.

5. Method according to Claim 1 or 2, **characterized in that** the radiation-curing coating compound contains
- at least one polyester-, polyether-, carbonate-, epoxy-or urethane(meth)acrylate or unsaturated polyester resin,
- optionally at least one reactive thinner,
- optionally at least one photoinitiator,
- optionally at least one solvent,
- optionally at least one stabilizer,
- optionally at least additive, selected from the group consisting of activators, fillers, pigments, dyes, thickeners, thixotropic agents, surfactants, viscosity modifiers, plasticizers and chelating agents.

6. Method according to one of Claims 2 to 5, **characterized in that** the radiation-curing coating compound has a double bond density of at least 0.1 mol/kg.

7. Method according to one of the preceding claims, **characterized in that** the substrate is selected from the group consisting of PET, PP, PE and PMMA.

8. Method according to one of the preceding claims, **characterized in that** the die is a die with a hierarchic fine structure.

9. Structured surface of a solid body obtainable by a method of Claims 1 to 8.

## Revendications

1. Procédé de fabrication de surfaces revêtues finement structurées ayant un rapport de longueur d'au moins 0,5 pour influencer l'adhésion, comprenant les étapes suivantes :
a) l'application d'au moins un matériau de revêtement sur au moins un substrat ;
b) la formation d'une structure fine par une matrice qui présente le négatif d'une structure fine,
b1) la matrice étant pressée contre le matériau de revêtement sur le substrat ou
b2) le substrat de l'étape a) contenant la matrice ;
c) le durcissement du matériau de revêtement finement structuré ainsi obtenu pour obtenir un revêtement durci ;
d) la séparation du revêtement finement structuré de la matrice, les étapes d) et c) pouvant également être réalisée dans l'ordre inverse, et
- le matériau de revêtement présentant à l'état sans solvant avant l'application sur le substrat une viscosité [viscosimétrie rotative selon DIN 53018-1 avec une géométrie à plaque/cône à 25 °C ; régulation de la température : Peltier, dispositif de mesure : HC 60/1 à un gradient de cisaillement D de 10 à 1 000 1*s-1] inférieure à 10 Pas, et
- le revêtement durci présentant un module E [indentation avec des pointes Berkovich, charge comprise entre 0,1 et 1 mN selon le module de l'échantillon à déterminer ; temps d'indentation . 10 s ; temps de maintien 30 s et temps de retrait 10 s, étalonnage sur du polycarbonate] d'au moins 1 et de jusqu'à 1 000 MPa,
- le matériau de revêtement durcissable par rayonnement présentant une densité de doubles liaisons inférieure ou égale à 7 mol/kg.

2. Procédé selon la revendication 1, **caractérisé en ce que** la viscosité des matériaux de revêtement à l'état sans solvant se situe dans la plage comprise entre 10 mPas et 600 mPas.

3. Procédé selon la revendication 1 ou 2, **caractérisé en ce que** les matériaux de revêtement durcissables par rayonnement sont des esters de l'acide acrylique, des esters de l'acide méthacrylique ou des résines de polyester insaturées.

4. Procédé selon la revendication 1 ou 2, **caractérisé en ce que** les matériaux de revêtement durcissables par rayonnement sont des (méth)acrylate de polyester, de polyéther, de carbonate, d'époxy ou d'uréthane, qui peuvent éventuellement être partiellement modifiés par des amines.

5. Procédé selon la revendication 1 ou 2, **caractérisé en ce que** le matériau de revêtement durcissable par rayonnements continent :
- au moins un (méth)acrylate de polyester, de polyéther, de carbonate, d'époxy ou d'uréthane ou une résine de polyester insaturée,
- éventuellement au moins un diluant réactif,
- éventuellement au moins un photoinitiateur,
- éventuellement au moins un solvant,
- éventuellement au moins un stabilisateur,
- éventuellement au moins un additif, choisi dans le groupe constitué par les activateurs, les charges, les pigments, les colorants, les épaississants, les agents thixotropes, les agents tensioactifs, les modificateurs de viscosité, les plastifiants et les chélateurs.

6. Procédé selon l'une quelconque des revendications 2 à 5, **caractérisé en ce que** le matériau de revêtement durcissable par rayonnement présente une densité de doubles liaisons d'au moins 0,1 mol/kg.

7. Procédé selon l'une quelconque des revendications précédentes, **caractérisé en ce que** le substrat est choisi dans le groupe constitué par le PET, le PP, le PE et le PMMA.

8. Procédé selon l'une quelconque des revendications précédentes, **caractérisé en ce que** la matrice est une matrice d'une structure fine hiérarchique.

9. Surface structurée d'un corps solide pouvant être obtenue par un procédé selon les revendications 1 à 8.
